(19) Europäisches Patentamt
European Patent Office
Office européen des brevets

(11) Publication number: **0 355 955 A2**

# (12) EUROPEAN PATENT APPLICATION

(21) Application number: 89305884.2

(22) Date of filing: 12.06.89

(51) Int. Cl.4: **H01L 21/60 , H01L 23/49 , H01L 23/29**

The title of the invention has been amended (Guidelines for Examination in the EPO, A-III, 7.3).

(30) Priority: **29.07.88 JP 190163/88**
**16.11.88 JP 289237/88**
**25.07.88 JP 185993/88**
**07.04.89 JP 86841/89**

(43) Date of publication of application: **28.02.90 Bulletin 90/09**

(84) Designated Contracting States: **DE FR GB IT**

(71) Applicant: **HITACHI, LTD.**
**6, Kanda Surugadai 4-chome**
**Chiyoda-ku Tokyo 101(JP)**

Applicant: **HITACHI MICROCOMPUTER ENGINEERING LTD.**
**5-22-1, Josuihon-cho**
**Kodaira-shi Tokyo(JP)**

(72) Inventor: **Okikawa, Susumu**
**1-1-56 Suehiro-cho**
**Ohme-shi Tokyo(JP)**
Inventor: **Watanabe, Hiroshi**
**203 Heiwakoopo 1-13-19 Hon-cho**
**Higashimurayama-shi(JP)**
Inventor: **Tanimoto, Michio**
**3-26-18 Nishi-machi**
**Kokubunji-shi Tokyo(JP)**
Inventor: **Homma, Makoto**
**2-9-17 Hanekami Hamura-machi**
**Nishitama-gun Tokyo(JP)**
Inventor: **Kaneda, Tsuyoshi**
**1-24-16 Hounan**
**Suginami-ku Tokyo(JP)**
Inventor: **Koike, Shunji**
**55-11 Megurita-cho**
**Kodaira-shi Tokyo(JP)**
Inventor: **Nishita, Takafumi 202 Hitachimaikon**
**Tokorozawashataku, 4-2689**
**Higashisayamagaoka**
**Tokorozawa-shi Saitama(JP)**

(74) Representative: **Calderbank, Thomas Roger et al**
**MEWBURN ELLIS 2 Cursitor Street**
**London EC4A 1BQ(GB)**

## (54) Connection for semiconductor devices or integrated circuits by coated wires and method of manufacturing the same.

(57) A semiconductor integrated circuit device in which wire bonding is applied by using a bonding wire having heat resistant polyurethane coating, a semiconductor integrated circuit device applied with bonding by way of a coated wire and encapsulated with a resin composition of a low heat expansion coefficient, and a semiconductor integrated circuit device free from disconnection and damage to the coated wire by applying chamfering to a chip, etc.

EP 0 355 955 A2

Xerox Copy Centre

FIG. 1

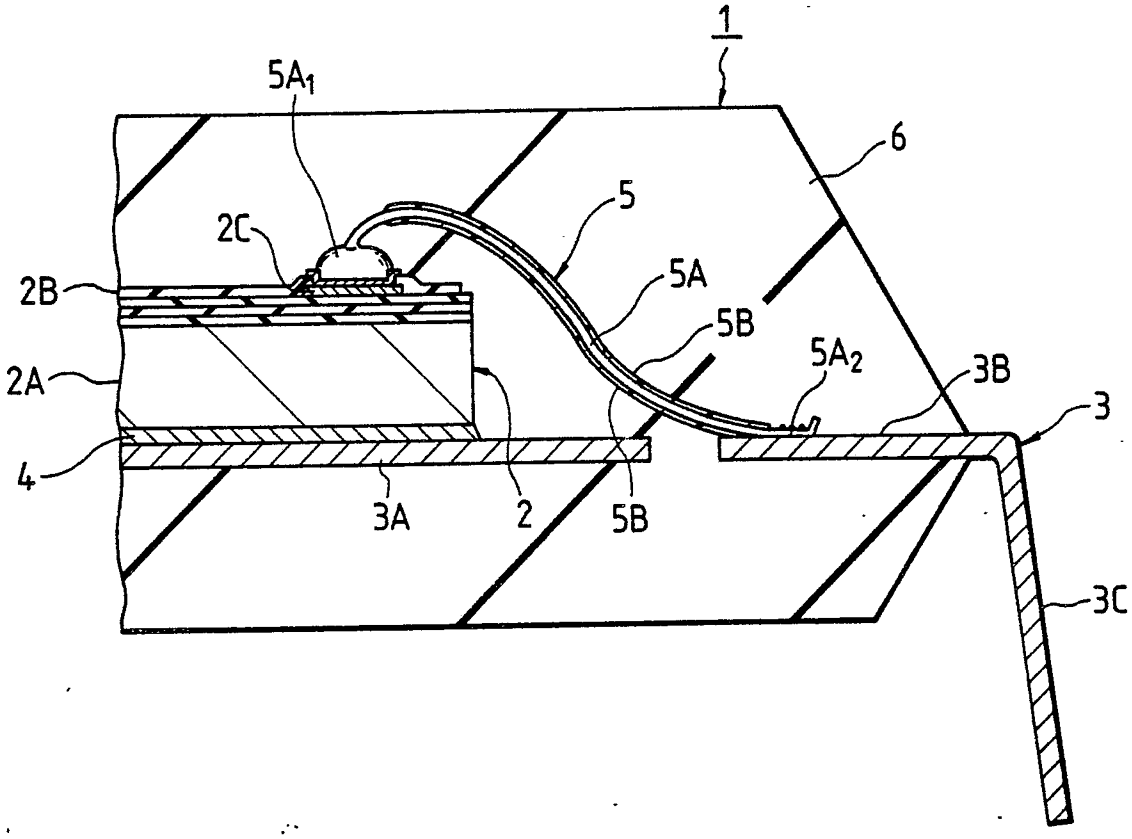

# SEMICONDUCTOR DEVICE OR SEMICONDUCTOR INTEGRATED CIRCUIT DEVICE AND METHOD OF MANUFACTURING THE SAME

The present invention concerns a technique for manufacturing a semiconductor device and, particularly, it relates to a technique which may be effective when applied to the manufacture of a semiconductor device, in which external terminals of a semiconductor chip and a lead are connected by way of coated wires each comprising a metal wire coated at the surface thereof with an insulative coating layer, as well as to a semiconductor device obtained thereby.

Further, the present invention relates to a technique which be effective when applied to the structure of a semiconductor device having a semiconductor chip of high integration degree and high performance and, particularly, it relates to an improvement of reliability of wiring by means of wire bonding.

Generally, wires made, for example, of gold (Au), aluminum (Al) or copper (Cu) are used for the electrical connection between external terminals (bonding pad) of a semiconductor chip and leads (inner lead) in a semiconductor device.

As the wire of this type, while a so-called not-coated wire comprising only a metal wire made of the material as described above has been used, it has been recently considered to use a coated wire comprising a metal wire coated at the surface thereof with an insulative layer with an aim of preventing inter-wire short-circuit failure.

Use of such coated wires are proposed, for example, in Japanese Patent Laid-Open Publications Sho 57-152137, 57-162438, 60-224237 and 61-194735 and in Japanese Utility Model Laid-Open Publication Sho 61-186239.

According to the above-mentioned known techniques, use of urethane resin or nylon resin (Japanese Patent Laid-Open Publication Sho 57-152137), polyimide resin, polyurethane resin or fluoro resin (Japanese Patent Laid-Open Publication Sho 57-162438), polyethylene resin, polyimide resin or urethane resin (Japanese Patent Laid-Open Publication Sho 60-224237), urethane resin, polyvinyl chloride resin or polyimide resin (Japanese Patent Laid-Open Publication Sho 61-194735) and enamel as the insulative varnish, formal, polyester resin or polyurethane resin (Japanese Utility Model Publication Sho 61-186239), as the material for the insulative coating layer for the coated wire, has been described respectively.

As an example of the techniques of this kind described so far, there can be mentioned "Micro Device (separate edition of NIkkei Electronics)", p 82- 92, published from Nikkei McGrow Hill Co., June 11, 1984.

In the above-mentioned literature, an epoxy sealant, that is, a resin composition (hereinafter simply referred to as "resin") in a resin molded semiconductor device has been described specifically.

That is, the packaging size for semiconductor devices has become smaller along with a demand for high density mounting and, in a case where a semiconductor chip of high integration degree is encapsulated within such a package of a reduced size, the thickness and the length for the package are inevitably reduced.

As a result, crack is liable to occur due to the difference in the heat expansion coefficient between the resin (resin composition) constituting the package and the lead. In addition, since the package is small in the size, moistures easily intrude from the outside through the lead extended outwardly although crack is not formed, which may cause a worry that the corrosion of the external terminal on the semiconductor chip is accelerated.

That is, while the heat expansion coefficient of general epoxy resins is as large as from $17 \times 10^{-6}$ to $70 \times 10^{-6}/^{\circ}C$, the heat expansion coefficient is as small as about $10 \times 10^{-6}$ for Fe-Ni alloy and about $6 \times 10^{-6}$ for 42 alloy, Kovar, etc. that constitute the lead.

Due to the difference in the heat expansion coefficient, interface peeling, that is, cracking occurs at a portion in contact with the lead after curing of the package, to lower the moisture proofness of the semiconductor device. In order to suppress the development of crack, a filler such as molten quartz powder with extremely low heat expansion coefficient has been blended.

The present inventor has found that the known techniques described above involve the following problems.

From a study of the materials for the insulative coating layers disclosed in the known techniques described above, the polyester resin is not suitable since it is poor in the bondability due to the excessively great rigidity of the film and liable to cause bonding failure.

Further, polyimide resin (nylon resin), fluoro resin, polyethylene resin, polyvinyl chloride resin and enamel, as well as polyester resin are not quite satisfactory by the following reasons. That is, since these materials are not decomposed but carbonized at a heating temperature during formation of a metal ball, there have been problems that carbonization products deposited to the coated wire are caught in the

capillary to hinder the supply of the wire upon wire bonding of a semiconductor chip to the external terminals, the carbonization products as electro-conductive material fall on the circuit forming surface of the semiconductor chip, thereby causing short-circuit failure, as well as the bondability is poor since the peeling property of the coating layer is poor upon wire bonding to the lead, the coating layer is carbonized by heating upon heating and removal of the carbonization products is difficult to hinder the bonding.

Further, although the polyurethane (or urethane resin) or formal has satisfactory properties from an overall point of view as compared with other materials described above, it has been found by the experiment of the present inventors that there is a problem of thermal degradation, particularly, due to the insufficient heat resistance. That is, during use after mounting the semiconductor device, the wire also undergoes considerably great thermal shock due to the heat generated from the semiconductor device. Accordingly, it has been confirmed by the temperature cycle test according to MIL-883B and the test of leaving at high temperature conducted by the present inventor, et al. that when usual polyurethane resin or formal is used as the coating layer, if the wire should cause the state of tab-touch, chip-touch to the silicon region and, further, state of touch between wires, polyurethane or formal undergoes thermal degradation, finally leading to the tab short-circuit, chip short-circuit and inter-wire short-circuit due to the destruction of the layers even in the case of using the coated wire.

In this regard, no consideration has been taken in any of the known techniques described above for the problem of thermal degradation in the coating layers of polyurethane resin and, accordingly, there is a problem that the short-circuit failure as described above is caused, only by the use of the polyurethane resin as the material for the coating layer of the wire, since the material can not withstand the conditions in use for the semiconductor device and test conditions of MIL-883B.

It has further been found that while the heat expansion coefficient of the entire resin is decreased in proportion with the blending amount of the filler, since the viscosity of the resin is increased in a reverse proportion therewith, flow of wire (deformation) is caused in the resin molding step.

That is, along with the flow of the wire, contact between the wires, contact between the wire and the tab of the semiconductor chip is caused to remarkably reduce the reliability as the semiconductor device by electric short- circuit.

In view of the above, in the above-mentioned prior art, it is obliged to limit the content of the filler in the resin to less than 60 % by weight, and it is actually difficult to make the heat expansion coefficient of the resin approximately equal with that of the lead.

Further, in a case where the package is formed in a state where the wire is kept in contact with the tab or the semiconductor chip, wire disconnection is caused due to the deformation along with the heat expansion of the package to worsen the electric reliability of the semiconductor device.

Furthermore, in a resin encapsulated semiconductor device such as DIP (Dual In-line Package), external terminals (bonding pad) of a semiconductor chip and inner leads of a lead are connected by way of wires. In the resin encapsulated semiconductor device, the semiconductor chip, inner leads and the wires are resin encapsulated (resin molding). An epoxy resin is used, for example, as the resin.

In the resin encapsulated semiconductor device under development by the present inventor, coated wire is used as the wire as described in Japanese Patent Application Sho 62-200561 (laid open number Hei 01-42831) filed previously by the present applicant. The coated wire is formed by coating the surface of the metal wire with an insulator. The metal wire in the coated wire is formed with gold (Au), copper (Cu), aluminum (Al), etc. The insulator is made of resin material such as a polyurethane resin or polyimide resin. The coated wire is bonded by means of a ball wedge bonding method or wedge & wedge bonding method.

The resin encapsulated semiconductor device using the coated wire has an advantageous feature capable of improving the electric reliability by preventing short-circuit failure due to contact between adjacent wires, short-circuit failure due to contact between the wire and the end of the semiconductor chip and short-circuit failure due to contact between the wire and the tab end. The short-circuit failure is liable to be caused by the flow of the resin injected, particularly, in the resin encapsulation step.

The present inventor has found the following problems in the course of the inspection for the electric characteristics of the resin encapsulated semiconductor device using the coated wire as described above.

The coated wire is free from short-circuit failure with respect to other coated wire in adjacent therewith or between the coated wire and the semiconductor chip or the tab end respectively. On the other hand, in the resin encapsulated semiconductor device under development by the present inventor, the size of the tab is made somewhat larger so that semiconductor chips of different size (different function) can be mounted on an identical package. Accordingly, contact between the coated wire and the corner of the tab of the lead is permitted in the resin encapsulated semiconductor device. However, in a case of using a resin layer such as of a polyurethane resin as the insulator for the coated wire, adhesion is strong both between the metal wire and the insulator and between the insulator and the resin (epoxy resin) as the material for

encapsulation. That is, shrinking stresses caused to the encapsulation material in the temperature cycle after the resin encapsulation is exerted on the entire area of the metal wire in the coated wire, in which the stresses are localized, particularly, to the coated wire at a portion in contact with each of the corners described above. Accordingly, there has been a problem that the insulator on the coated wire is destroyed to cause short-circuit between the metal wire and the tab or the coated wire is disconnected, to worsen the electric reliability of the resin encapsulated semiconductor device. Particularly, since the lead frame of the resin encapsulated semiconductor device is formed by punching and burrs are formed to the respective end faces of the tab and the lead, the foregoing problem becomes conspicuous if the burrs are brought into contact with the coated wire. The problem also occurs in the same manner if the coated wire is brought into contact with the corners of the semiconductor chip.

The present inventor has further found the following problems before the development of the resin encapsulated semiconductor device described above.

In a resin encapsulated semiconductor device, pin-arrangement (position or arrangement for signal pins or power source pins) may be different depending on the kind of boards on which the device is mounted and the type of the external devices. In such a case, resin encapsulated semiconductor devices of an identical function with other pin arrangement have to be developed. That is, it requires an additional development for the arrangement of the external terminals of the semiconductor chip and the arrangement for the leads of the package. Particularly, since the cost for the development of a semiconductor chip is about 10 times as high as that of the package, there has been a problem that a great development cost is necessary in order to develop a new resin encapsulation semiconductor device with the reason that only the pin arrangement is different.

Various aspects of the present invention are as defined in the appended claims.

Various aspects of the present invention are explained below.

In a manufacturing method for a semiconductor device and a semiconductor device obtained thereby in accordance with the present invention, the insulative coating layer for the coated wire comprises a heat resistant polyurethane prepared by reacting a polyol ingredient and an isocyanate and containing constituent units derived from terephthalic acid in the molecule skelton. The coated wire is connected at one end thereof to an external terminal of a semiconductor chip and at the other end thereof to a lead.

The coated wire is connected to the external terminal of the semiconductor while with removing the coating layer at one end upon forming a metal ball or without forming such a metal ball.

The other end of the coated wire is brought into contact with a lead and the coating layer at the portion of contact is destroyed, or the coating layer at the other end is previously removed, thereby connecting the metal wire at the other end of the coated wire with the lead.

Upon connecting the other end of the coated wire with the lead, only the wire bonding portion of the lead can be heated.

A pigment can be added by a predetermined amount to the coating layer for the coated wire.

In another way of expressing the present invention, for both manufacturing a semiconductor device and the semiconductor device obtained thereby the insulative coating layer for the coated wire can be formed with such material as having the degradation rate of less than 20 % in relation with the reduction of the destruction frequency of the coating layer at 150°C - 175°C, after 100 hours and showing no carbonization upon forming a metal ball or removal of the coating layer.

According to the means described above, since the coating layer made of a heat resistant polyurethane can prevent the layer destruction caused by thermal degradation, it is possible to prevent electric short-circuit failure such as tab short-circuit or chip short-circuit of the coated wire, or short-circuit between each of the wires.

Further, since urethane bondings in the heat resistant polyurethane used as the insulative coating layer for the wire are decomposed at the bonding temperature upon usual wire bonding or with supersonic vibration energy, it is possible to attain reliable bonding by the combined use of hot-press bonding by usual heating and supersonic vibrations or by the application of the supersonic vibration energy. In this case, if local heating to the bonded portion is used together, more reliable wire bonding is possible.

Furthermore, when such material as having degradation rate of less than 20 % in relation with the reduction of destruction frequency of the coating layer at 150°C - 175°C, after 100 hours and not carbonizable upon forming a metal ball or removing the coating layer is used as the insulative coating layer for the coated wire, since the thermal degradation of the coating layer can be prevented, electric short-circuit failure caused by the destruction of the layer can be prevented.

Further, referring simply to the outline of typical embodiments among those disclosed in the present application, a number of features become possible and/or advantageous.

The first feature concerns a structure of a resin encapsulated semiconductor device in which an

intermediate layer made of an insulative resin is disposed between a metal wire and a resin, and the heat expansion coefficient of the resin is controlled to less than 10 x $10^{-6}/^{\circ}C$.

The second feature concerns a structure of a resin encapsulated semiconductor device in which external terminals on a semiconductor chip and a lead are wired by means of metal wires each having an intermediate layer made of an insulative resin formed at the periphery thereof and, further, the periphery of them is molded with a resin, wherein the total diameter of the metal layer and the intermediate layer is set to less than 30 µm and the heat expansion coefficient of the resin is controlled to less than 10 x $10^{-6}/^{\circ}C$.

The third feature concerns a structure of a resin encapsulated semiconductor device in which each of metal wires for connecting external terminals formed on a semiconductor chip and a lead comprises a first intermediate layer made of an insulative resin formed at the periphery thereof and a second intermediate layer made of a resin of satisfactory releasability formed to the outer circumference thereof.

The fourth feature concerns connection between external leads on a semiconductor chip and a lead by way of metal wires, which comprises press-bonding one end of the metal wire protruded from a top end of a bonding tool applied with supersonic vibrations to the external terminal, moving the bonding tool while maintaining the supersonic vibrations, deliverying the metal wire from the top end thereof and bonding the other end of the metal wire to the lead and, thereafter, applying molding over the region of the wiring with the metal wire by using a resin, the heat expansion coefficient of which is controlled to less than 10 x $10^{-6}/^{\circ}C$.

The fifth feature concerns a method of forming an intermediate layer by depositing an insulative resin comprising a polyurethane prepared by reacting a polyol ingredient and an isocyanate and containing constituent units derived from terephthalic acid in the molecule skelton at the periphery of the metal wire, connecting external terminal of a semiconductor chip and a lead by means of the metal wire and, thereafter, applying molding over the region of the wiring with a resin, the heat expansion coefficient of which is controlled to less than 10 x $10^{-6}/^{\circ}C$.

The sixth features concerns a method of preparing a wire by forming an intermediate layer made of an insulative resin at the periphery of a metal wire, connecting a semiconductor chip mounted on a lead frame and a lead by using the wire, placing the lead frame within a mold in which a plurality of cavities are formed, and injecting a molten resin from at least two resin supply sources to a plurality of cavities in the mold under a high pressure, thereby forming a package.

The seventh feature concerns an intermediate forming apparatus for forming first and second intermediate layers at the periphery of a metal wire, comprising a first storage reservoir and a second storage reservoir disposed continuously and a pulley rotatable within a vertical plane in each of the storage reservoirs, in which the lowermost portion of the pulley is immersed in a stored solution and the stored solution of a predetermined amount picked-up by the pulley to the uppermost portion thereof is brought into contact with the metal wire, thereby forming first and second intermediate layers at the periphery of the metal wire.

According to the first means as described above, development of crack caused by the difference of the heat expansion coefficient between the resin and the lead, etc. can be prevented effectively by controlling the heat expansion coefficient of the resin to less than 10 x $10^{-6}\,^{\circ}C$. Further, although the viscosity of the resin is increased in such a state that the heat expansion coefficient is restricted, electric short-circuit caused by the flow of wire in the resin molding step can effectively be prevented since the intermediate layer comprising the insulative resin is disposed at the periphery of the metal wire.

According to the second means, since the total diameter of the metal wire and the intermediate layer is restricted to less than 30 µm, less wire flow is caused due to the resin injection pressure in the resin molding step and, if the wire flow should occur, electric short-circuit can be prevented effectively since the intermediate layer formed with the insulative resin is disposed at the periphery of the metal wire.

According to the third means, since the first intermediate layer comprising the insulative resin and the second intermediate layer of satisfactory releasability therearound are disposed, the metal wire can move finely by the releasing effect of the second intermediate layer even if the wire is brought into contact with the semi conductor chip, and, accordingly, no compulsory stresses is applied to the metal wire itself and disconnection can be prevented effectively.

According to the fourth means, since the supersonic vibrations are continuously applied to the bonding tool upon delivering the metal wire from the bonding tool, deformation such as bending caused by the adsorption of the metal wire, etc. can be prevented.

According to the fifth means, since the structure of the intermediate layer is not carbonized by the heating when the metal ball is formed upon wire bonding, contamination to the semiconductor chip during wire bonding can effectively be prevented. Further, since the heat expansion coefficient is restricted, development of crack caused by the difference of the heat expansion coefficient can be prevented.

According to the sixth means, since the molten resin is injected from two or more of resin supply sources to a plurality of cavities, even a molten resin having relatively high viscosity can be injected efficiently into the cavities and the efficient resin molding step can be attained to the lead frame to which connection is applied by means of the wire having the intermediate layer.

According to the seventh means, the first and the second intermediate layers can be formed continuously and easily by disposing the first and the second storage reservoirs continuously.

Furthermore, preferred features among those disclosed in the present application are explained below.

(1) In a semiconductor device in which external terminals of a semiconductor chip mounted on a tab and a lead are connected by means of coated wires and the coated wire and the connection portion of the coated wire are covered with a resin, the shape of the corners for the semiconductor chip, the corners for the tab or the corners for the lead where the coated wire is extended, is moderated.

(2) The coated wire is extended such that it is not into contact with the corners for the semiconductor chip, the corners for the tab or the corners for the lead.

(3) A method of forming a semiconductor device using a coated wire, comprising steps of mounting a semiconductor chip at a chip mounting position of a first package, and connecting external terminals of the semiconductor chip and a lead by means of a coated wires thereby forming a first semiconductor device, while mounting an identical semiconductor chip with the semiconductor chip of the first semiconductor device at a chip mounting position of a second package different from the first package for the first semiconductor device and connecting external terminals of the semiconductor chip and a·lead by means of coated wires, thereby forming a second semiconductor device.

(4) A method of forming a semiconductor device using a coated wire, comprising steps of mounting a first semiconductor chip at a chip mounting position of a lead, connecting external terminals of the first semiconductor chip and the lead by means of coated wires and, thereafter, applying resin encapsulation thereby forming a first semiconductor device, while mounting a second semiconductor chip of a kind different from the first semiconductor chip of the first semiconductor device at a chip mounting position of an identical lead with that of the first semiconductor device, connecting external terminals of the second semiconductor chip and the lead by means of coated wires and, thereafter, applying resin encapsulation, thereby forming a second semiconductor device.

According to the means (1) above, since concentration of stresses due to the shrinkage of the resin to a portion of the coated wire in contact with the corners for the semiconductor chip, the corners for the tab or the corners for the lead is reduced, short-circuit between the semiconductor chip or the tab and the metal wire of the coated wire due to the destruction of the insulator, or disconnection of the coated wire can be prevented. As a result, electric reliability of the semiconductor device can be improved.

According to the means (2) above, since stresses due to the shrinkage of the resin are not concentrated to the coated wire, it is possible to prevent short-circuit between the semiconductor chip or the tab and the metal wire of the coated wire or disconnection of the coated wire. As a result, electric reliability of the semiconductor device can be improved.

According to the means (3) above, since the external terminals of the semiconductor chip and the lead can be connected by means of the coated wire while intersecting other lead, or the external terminals of the semiconductor chip and the lead can be connected while crossing the coated wires to each other, a plurality kinds of semiconductor devices can be formed by using identical type of semiconductor chip (standardization of the semiconductor chip) and using different kinds of packages. As a result, since the development cost for the package is less expensive as compared with the developing cost for the semiconductor chip, a plurality kinds of semiconductor devices can be formed at a reduced development cost.

According to the means (4) above, since the external terminals of the semiconductor chip and the lead can be connected by means of the coated wire while intersecting other lead, or the external terminals of the semiconductor chip and the lead can be connected while intersecting the coated wires to each other, a plurality kinds of semiconductor devices can be formed by using identical kind of lead (lead frame) (standardization of lead frame) and using different types of semiconductor chips. As a result, since there is no requirement for developing leads on every development of semiconductor chips (for instance, on every semiconductor chips having identical functions but different with respect to the position of the external terminals), a plurality kinds of semiconductor devices can be formed at a reduced development cost.

**In the drawings:**

Fig. 1 is a cross sectional view for one-half portion of a resin encapsulated semiconductor device as

Example 1-I according to the present invention;

Fig. 2 is a schematic enlarged cross sectional view for a wire bonding portion;

Fig. 3 is a schematic constitutional view for a wire bonding apparatus usable in the present invention;

Fig. 4 is a perspective view for a portion thereof;

Fig. 5 is a cross sectional view for a portion illustrating a specific constitution for a portion of the wire bonding apparatus;

Fig. 6 is a plan view taken along the direction of arrow VI in Fig. 5;

Fig. 7 is a cross sectional view taken along lines VII-VII in Fig. 6;

Fig. 8 is a schematic constitutional view illustrating the principle of forming a metal ball;

Fig. 9 is an exploded perspective view for a portion of a spool in the wire bonding apparatus;

Fig. 10 is an enlarged perspective view for a portion of the spool;

Fig. 11 is a schematic plan view for the local heating portion for the wire bonding;

Fig. 12 is a plan view illustrating one embodiment of wire bonding;

Fig. 13 is an enlarged cross sectional view for a portion illustrating the chip touch state therein;

Fig. 14 is an enlarged cross sectional view for a portion illustrating the chip short-circuit state;

Fig. 15 is an enlarged cross sectional view for a portion illustrating the tab-touch state of the coated wire;

Fig. 16 is an enlarged cross sectional view for a portion illustrating the tab short-circuit state;

Fig. 17 is a graph showing the short circuit rate between the semiconductor chip and the coated wire relative to the temperature cycle in the present invention;

Fig. 18 is a graph showing the short-circuit rate between the tab and the coated wire relative to the temperature cycle in the present invention;

Fig. 19 is a schematic view showing experimental conditions used for the evaluation of a coating layer of the coated wire used in the present invention;

Figs. 20 and 21 are graphs showing, respectively, the results of comparison experiments for the abrasion resistance of the coating layer in the present invention;

Fig. 22 is a graph showing the results of experiment for the relationship between the temperature and the degradation rate in the present invention;

Fig. 23 is a graph showing the results of experiment between the imidization rate of the coating layer (abscissa) and the degradation velocity, i.e., degradation rate (left ordinate) and the peeling strength of the second bonding of the coated wire (right ordinate);

Fig. 24 is a graph showing the results of experiment for the amplitude of the temperature cycle and the life of the temperature cycle of the coated wire;

Fig. 25 is a graph showing the effect of the addition of a pigment to the coating layer of the coated wire on the degradation velocity (degradation rate);

Figs. 26 through 30 are, respectively, cross sectional views for a portion of the wire bonding illustrating Examples 1-II to VI in the wire bonding system utilizable in the present invention;

Fig. 31 is a cross sectional view for a portion of the wire bonding illustrating the composite coating layer structure in Example 1-VII according to the present invention;

Fig. 32 is a cross sectional view illustrating the constitution of a semiconductor device as Example 2 according to the present invention;

Fig. 33 is a plan view for a portion illustrating the planar configuration of a lead frame used in the example described above;

Fig. 34 is a cross sectional view for a portion illustrating the inner structure of the semiconductor chip in the example above;

Fig. 35 is a perspective view illustrating the wire used in the example above;

Fig. 36 is an explanatory view showing the characteristics of the wire;

Fig. 37 is a schematic explanatory view illustrating an intermediate layer forming apparatus used for the coating of the intermediate layer to the wire of the example described above;

Figs. 38(a) and (b) are, respectively, explanatory views illustrating the constitution of the wire bonding apparatus used in the example above;

Fig. 39 is an explanatory view illustrating the constitution of a resin molding apparatus used for forming a package in the example above;

Fig. 40 is a plan view illustrating the mold surface in the resin molding apparatus;

Fig. 41 is an explanatory view illustrating a relationship between the heat expansion coefficient and the blending amount of the filler;

Fig. 42 is an explanatory illustrating a relationship between the resin viscosity in the molten state and the blending amount of the filler;

Fig. 43 is an explanatory view showing a relationship between the wire short-circuit rate and the blending amount of the filler, in comparison with the prior art;

Fig. 44 is an explanatory view illustrating the change of the water penetration state in PCT (Pressure Cooker Test) in comparison with the prior art;

Fig. 45 is a cross sectional view for a portion illustrating the constitution of DIP type resin encapsulated semiconductor device as Example 3-I according to the present invention;

Fig. 46 is a plan view partially in cross section of a resin encapsulated semiconductor device;

Figs. 47 through 50 are, respectively, enlarged cross sectional views for the portion of the resin encapsulated semiconductor device;

Fig. 51 is a graph illustrating the short-circuit rate between the tab of the resin encapsulated semiconductor device and the wire;

Fig. 52 is a graph showing a disconnection rate of the wire in the resin encapsulated semiconductor device;

Figs. 53 and 54 are, respectively, enlarged cross sectional views showing the method of forming the lead of the resin encapsulated semiconductor device on every forming steps;

Figs. 55 and 56 are, respectively, schematic plan views showing the method of forming the resin encapsulated semiconductor device as Example 3-II according to the present invention on every forming step;

Fig. 57 is a cross sectional view for a portion of a wafer illustrating a bevel dicing in Example 4 according to the present invention;

Fig. 58 is an explanatory view for the entire constitution thereof;

Fig. 59 is a cross sectional view illustrating an wafer appended by way of an adhesive sheet to a circular frame used for dicing;

Fig. 60 is a top plane view of a wafer illustrating the state of scribe lines for wafer pelletization;

Fig. 61 is a schematic view partially in cross section illustrating the details of the bonding process in Example 5 according to the present invention;

Fig. 62 is a cross sectional view of a face mounted device in Example 6 according to the present invention.

The following description for the present invention are divided into Examples 1 - 6 for the sake of convenience, but they do not belong to different inventions but may be substituted with each other and some of the examples are a modified process or modified structure for a portion of other examples.

(1) Example 1

Heat resistant polyurethane used as the coating layer for the coated wire in the present invention is to be described more specifically. The heat resistant polyurethane is prepared by reacting a polyol ingredient and an isocyanate and contains constituent units derived from terephthalic acid in the molecule skelton. The heat resistant polyurethane is obtained by using a polymer ingredient comprising terephthalic acid polyol containing active hydrogen as the main ingredient and an isocyanate. In this text "as the main ingredient" also includes a case where the entire portion consists only of the main ingredient.

The terephthalic acid polyol containing the active hydrogen can be prepared by using terephthalic acid and a polyhydric alcohol and by way of a customary esterifying reaction while setting the reaction temperature from 70 to 250°C within a range of OH/COOH = 1.2 to 30. Generally, those having an average molecular weight of from 30 to 10,000, containing about from 100 to 500 hydroxyl groups and having hydroxyl groups on both of the terminal ends of the molecular chain are used.

As the starting material for constituting the terephthalic polyol, there can be mentioned aliphatic glycols such as ethylene glycol, diethylene glycol, propylene glycol, dipropylene glycol, hexane glycol, butane glycol, glycerine, trimethylol propane, hexanetriol and pentaerythritol. Further, polyhydric alcohol such as 1,4-dimethylol benzene may also be used. Use of ethylene glycol, propylene glycol or glycerine is particularly preferred.

Although terephthalic acid used as the dicarboxylic acid, amide acid or imide acid may also be used together if necessary.

The imide acid has the structural formula as shown below:

Structural formula of imide acid

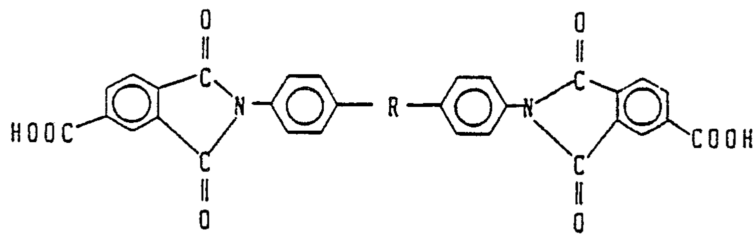

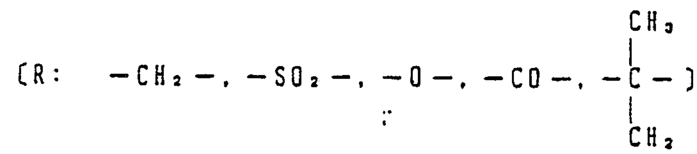

Dibasic acid such as isophthalic acid, ortho-phthalic acid, succinic acid, adipic acid or sebasic acid, or polybasic acid such as 1,2,3,4-butane tetracarboxylic acid, cyclopentane tetracarboxylic acid, ethylene tetracarboxylic acid, pyromellitic acid and trimellitic acid may also be used together, with such an extent as not reducing the heat resistance.

As the isocyanate to be reacted with the terephthalic acid polyol, there can be mentioned those obtained by blocking the isocyanate groups of polyvalent isocyanates having at least two isocyanate groups in one molecule such as toluylene diisocyanate and xylylene diisocyanate with a compound having active hydrogen, for example, phenols, caprolactam or methyl ethyl ketone oxime. Such an isocyanate is stabilized. There can also be mentioned prepared by reacting the above-mentioned polyvalent isocyanate compound with a polyhydric alcohol such as trimethylol propane, hexanetriol or butanediol and blocking with a compound having active hydrogen.

As examples of the isocyanate compound, there can be mentioned Millionate MS-50, Coronate 2501, 2503, 2505, Coronate AP-St, Desmodule CT-St, etc. manufactured by Nippon Polyurethane Co. Then, as the polyvalent isocyanate, those having a molecular weight of from about 300 to 10000 are preferably used.

In the present invention, a semiconductor device is manufactured by using a coated wire which is prepared by forming a paint composition using the starting materials as described above, coating the composition to a metal wire as the wire main body into a coating layer of a film thickness from 0.5 to several micronmeters, thereby insulating the metal wire as the wire main body.

The paint composition described above used in the present invention can be prepared by adding, based on one equivalent of hydroxyl groups in the polyol ingredient, from 0.4 to 4.0 equivalent, preferably, from 0.9 to 2.0 equivalent of isocyanate groups of a stabilized isocyanate and a predetermined amount of a cure promoting catalyst and, further, an appropriate amount of an organic solvent (phenols, glycol ethers, naphtha, etc.) and conditioning the solid content usually to 10 - 30 % by weight. In this case, additives such as appearance improver or dyes may be blended each in an appropriate amount as required.

In the present invention, from 0.4 to 4.0 equivalents of the isocyanate groups of the stabilized isocyanate is added based on one equivalent of the hydroxy groups in the polyol ingredient, because the crazing property of the resultant insulated wire is reduced if the amount is less than 0.4 equivalent, whereas the abrasion resistance of the coating layer is deteriorated if the amount exceeds 4.0 equivalent. The amount of the cure promoting catalyst added upon preparing the paint composition is, preferably, from 0.1 to 10 parts by weight based on 100 parts by weight of polyol ingredient. If it is less than 0.1 parts by weight, the cure promoting effect is reduced and the coating film-forming performance tends to be worsened. On the contrary, if it exceeds 10 parts by weight, the heat degradation property of the resultant heat resistant urethane bonding wire is reduced.

As the cure promoting catalyst, there can be mentioned metal carboxylic acid, amino acid and phenols. Specifically, there can be used zinc salt, iron salt, copper salt, manganese salt, cobalt salt and tin salt of naphthenic acid, octenic acid, versatic acid, etc, 1,8-diazabicyclo(5,4,0)undecene-7,2,4,6-tris-(dimethylaminomethyl)phenol.

The bonding wire having insulative coating used in the present invention can be obtained by coating the paint composition as described above to the surface of the metal wire as the wire main body and then baked in a customary baking and coating device.

The conditions for coating and baking, although different depending on the blending amount of the polyol ingredient, stabilized isocyanate, polymerization initiator and cure promoting catalyst, are usually

from 200 to 300° C for about 4 to 100 sec. In summary, baking are conducted at such temperature and times sufficient to substantially complete the curing reaction of the coating composition.

The thus obtained bonding wire having insulative coating has an insulative coating layer comprising heat resistant polyurethane formed at the outer circumference of the metal wire as the wire main body made of gold, copper or aluminum.

In this case, the insulative coating layer described above may be used in combination with other insulative coating layer as a composite coating layer structure.

The composite coating layer can be obtained by forming the insulative coating layer according to the present invention as described above and, subsequently, forming a second insulative coating layer on the above-mentioned insulative coating layer. In this case, the thickness of the second insulative coating layer is suitably set to less than twice, preferably, to less than 0.5 times as the thickness of the insulative coating layer according to the present invention. Then, as the material for forming the second insulative coating layer, there can be mentioned polyamide resin, special polyester resin, special epoxy resin, etc.

The constitution and the function of the present invention are to be explained referring to examples in which the present invention is applied to the semiconductor manufacturing technique to be used for a resin encapsulated semiconductor device.

Throughout the accompanying drawings used for explaining the examples, those having identical functions carry the same reference numerals and duplicate explanations therefor are omitted.

Fig. 1 is a cross sectional view for a portion of a resin encapsulated semiconductor device of Example 1-I according to the present invention;

Fig. 2 is an enlarged schematic cross sectional view for a wire bonding portion;

Fig. 3 is a schematic structural view for a wire bonding apparatus that can be used in the present invention;

Fig. 4 is a perspective view for a portion thereof;

Fig. 5 is a cross sectional view, partially in cross section, of a specific constitution for a portion of the wire bonding apparatus;

Fig. 6 is a plan view along the direction of arrow VI in Fig. 5;

Fig. 7 is a cross sectional view taken along line VII - VII in Fig.6;

Fig. 8 is a schematic constitutional view illustrating the principle of forming a metal ball;

Fig. 9 is an enlarged exploded perspective view of a spool in the wire bonding apparatus;

Fig. 10 is an enlarged perspective view for a portion of the spool;

Fig. 11 is a schematic plan view of a local heating portion for the wire bonding;

Fig. 12 is a plan view illustrating one embodiment of the wire bonding;

Fig. 13 is a cross sectional view for a portion illustrating the chip-touch state of a coated wire;

Fig. 14 is an enlarged cross sectional view for a portion illustrating the state of chip short-circuit thereof;

Fig. 15 is a cross sectional view for a portion illustrating the tab-touch state of the coated wire;

Fig. 16 is an enlarged cross section view for a portion illustrating the tab short-circuit state;

Fig. 17 is a graph showing the short-circuit rate between the semiconductor chip and the coated wire relative to the temperature cycle in the present invention; and

Fig. 18 is a graph also illustrating the short-circuit rate between the tab and the coated wire relative to the temperature cycle in the present invention.

The semiconductor device in this example is one example of a resin encapsulated semiconductor device, in which a semiconductor chip 2 can be constituted, for example, as a semiconductor integrated circuit device, e.g., memory, gate array, microprocessor, MOS logic, etc.

The semiconductor chip 2 comprises a substrate 2A, for example, made of silicon (Si), a passivation film 2 at the uppermost portion thereof and an external terminal (bonding pad) 2C exposed through the opening in the passivation film 2B. The semiconductor chip 2 is bonded by way of bonding material 4, for example, made of silver (Ag) to a tab 3A of a lead 3.

On the other hand, the external terminal 2C of the semiconductor ship 2 is electrically connected by way of a conductor wire with an inner lead 3B of a lead 3, in which a coated wire 5 is used for the conductor wire in this example. The coated wire 5 has such a structure in which an insulative coating layer 5B is coated at the surface of a metal wire 5A.

'The material for the metal wire 5A of the coated wire 5 can be made, for example, of gold (Au), copper (Cu) or aluminum (Al). The coating layer 5B of the coated wire 5, as described above and specifically explained later, comprises a heat resistant polyurethane prepared by reacting a polyol ingredient and an isocyanate and containing constituent units derived from terephthalic acid in the molecule skelton.

The coated wire 5 in this example is electroconductively connected on the first bonding side thereof,

that is, on the connection side between the external terminal 2C of the semiconductor chip 2 and one end of the coated wire 5 by means of ball bonding through the formation of a metal ball $5A_1$, while electroconductively connected on the second bonding side, that is, on the connection side between the inner lead 3B of the lead 3 and the other end of the coated wire 5 by means of a so-called thermosonic bonding utilizing hot-press bonding and supersonic vibrations as a second bonding portion $5A_2$ with no previous removal of the coating layer 5B.

The semiconductor chip 2, the tab 3A and the inner lead 3B of the lead 3 and the coated wire 5 applied with pellet bonding and wire bonding are encapsulated with resin material 6 such as an epoxy resin, and only the outer lead 3C of the lead 3 is protruded to the outside of the resin material 6.

Then, the constitution and the operation of the wire bonding apparatus for the bonding of the coated wire 5 in this example are explained mainly referring to Figs. 3 through 11.

The wire bonding apparatus is constituted as a so-called ball bonding apparatus such that the coated wire 5 wound around a spool 11 is supplied to a bonding section 12 as shown in Fig. 3.

That is, the coated wire 5 is supplied from the spool 11 to the bonding section 12 by way of a tensioner 13, a wire guide member 14, a wire clamper 15 and a bonding tool (capillary) 16.

A resin encapsulated semiconductor device 1 before resin encapsulation constituted as shown in Figs. 3 and 4 is disposed to the bonding section 12. Then, the resin encapsulated semiconductor device 1 before resin encapsulation is supported, as shown in Fig. 3, on a semiconductor device support bed 17 of the bonding apparatus (mounting table for the semiconductor device).

The metal ball $5A_1$ formed from the metal wire 5A exposed by removing the coating layer 5B on one side of the coated wire 5 is connected to the external terminal 2C of the semiconductor chip 2. The metal ball $5A_1$ has a diameter, for example, about 2 - 3 times greater than the diameter for the metal wire 5A. The metal wire 5A on the other side of the coated wire 5 exposed by destructing the coating layer 5B on the other end of the coated wire 5 at the connection portion is connected with the inner lead 3B of the lead 3. That is, the other end of the coated wire 5 is so constituted that only the coating layer 5B for the connection portion with the lead 3 is substantially removed and other portion of the coating layer 5B is left as it is. Destruction for the coating layer 5B at the other end of the coated wire 5 can be conducted, as described later, by means of supersonic vibrations, appropriate pressurization and heating (energy) given from the bonding tool 16.

In this way, in the resin encapsulated semiconductor type device 1 using the coated wire 5, the metal ball $5A_1$ formed from the metal wire 5A at one end of the coated wire 5 is connected to the external terminal 2C of the semiconductor chip 2, and the metal wire 5A at the other end of the coated wire 5 exposed by destructing the coating layer 5B at the connection portion is connected with the inner lead 3B of the lead 3. In this case, since the size of the metal ball $5A_1$ is large, it is possible to increase the area of contact between the external terminal 2C of the semiconductor chip 2 and the metal wire 5A of the coated wire 5, thereby improving the bondability between both of them. In addition, since the other end of the coated wire 5 except for the portion to be connected with the inner lead portion 3B of the lead 3 is covered with the coating layer 5B, it is possible to reduce the short-circuit between the other end of the coated wire 5 and the other end of other coated wire 5 in adjacent therewith. Accordingly, a distance between leads 3 can be reduced to provide a multi-terminal arrangement (so-called, multi-pin arrangement) for the resin encapsulated semiconductor device 1.

The top ends of the bonding tool 16 and the coated wire 5 in the supplying direction (portion for forming the metal ball $5A_1$) are so constituted that they are covered by a covering member 18A upon forming the metal ball $5A_1$ as shown in Figs 3 and 4. The covering member 18A is constituted so as to move rotationally in the direction of arrow A shown in Fig. 4. That is, the covering member 18A is constituted so as to insert the bonding tool 16 through a tool insertion port 18B and cover the tool by the rotational operation in the direction of arrow A upon forming the metal ball $5A_1$.

The covering member 18A is constituted as shown in Fig. 5 (partial cross sectional view illustrating a specific constitution, which corresponds to the cross section along line V - V in Fig. 6), Fig. 6 (plan view along the direction of arrow VI in Fig. 5) and Fig. 7 (cross sectional view taken along line VII - VII in Fig. 6). As stated later, the covering member 18A is so constituted that the coating layer 5B does not scatter to the bonding section 12 by the blowing off of the coating layer 5B that is melted upwardly upon forming the metal ball $5A_1$. Further, the covering member 18A is so constituted that an anti-oxidation sealing gas atmosphere (shielding gas atmosphere) can easily be maintained in a case where the metal wire 5A of the coated wire 5 is made of easily oxdizable material such as Cu or Al. The covering member 18A is made, for example, of stainless steel. Further, the covering member 18A may be made of transparent glass material so that operators can observe the state of forming the metal ball $5A_1$ of the coated wire 5, etc.

At the bottom of the covering member 18A, an electric torch (arc electrode) 18D is disposed as shown

in Figs 3, 4 and 5. As shown in Fig. 8 (schematic constitutional view for explaining the principle of forming the metal ball), the electric torch 18D is disposed closer to the metal wire 5A at the top end of the coated wire 5 on the supplying side so as to generate an arc Ac between both of them thereby forming the metal ball $5A_1$. The electric torch 18D is made, for example, of tungsten (W) capable of withstanding high temperature.

The electric torch 18D is connected by way of a suction tube 18E to a suction device 19 made of electroconductive material to an arc generation device 20. The suction tube 18E is made, for example, of stainless steels, to which the electric torch 18D is secured by way of a bonding metal layer such as of Ag - Cu soldering material. The suction tube 18E is secured by way of a clamping member 18F to the covering member 18A. That is, the electric torch 18D, the suction pipe 18E and the covering member 18A are formed integrally.

The electric torch 18D is arranged movably in the direction of arrow A shown in Fig. 4, so that it can approach the top end of the coated wire 5 on the supplying side during formation of the metal ball $5A_1$, while apart from the supplying path of the coated wire 5 during bonding step. The moving device for moving the electric torch 18D mainly comprises a supporting member 18G for supporting the torch 18D by way of the suction tube 18E and an insulation member 18H, a crank shaft 18I for rotating the support member 18G in the direction of arrow A and a driving source 18D for rotating the crank shaft 18I. The crank shaft 18I is rotated by the movement of a shaft 18J of a driving source 18K connected to the crank portion in the direction of arrow B. The driving source 18K comprises, for example, an electromagnetic solenoid. The crank shaft 18I is rotatably supported to the bonding apparatus main body not illustrated. The movement of the electric torch 18D and that of the covering member 18A are substantially identical since both of them are constituted integrally.

As shown in Fig. 4, the arc generation device 20 mainly comprises a capacitor $C_1$, an accumulating capacitor $C_2$, an arc generating thyristor D actuated upon triggering and a resistor R. A DC voltage DC is constituted so as to supply a voltage at negative polarity, for example, of about -1,000 to -3,000 (V). The DC power source DC is connected to the electric torch 18D by way of the thyristor D, the resistor R, etc. The reference potential GND is, for example, a grounded potential (=0 (V)). V is a volt meter and A is an ampere meter.

As described specifically later, the metal wire 5A of the coated wire 5 is grounded at the top end thereof wound around the spool 11 to the reference potential GND. As a result, in the case of forming the metal ball $5A_1$ at the top end of the coated wire 5 using the electric torch 18D, it is possible to set the electric torch 18D to a negative potential (-), while the metal wire 5A at the top end of the coated wire 5 in the supplying direction to a positive potential(+) as shown in Figs 3, 4 and 8.

In the bonding apparatus adapted to generate the arc Ac between the metal wire 5A at the top end of the coated wire 5 and the arc electrode 18D, thereby form the metal ball $5A_1$ at the top end of the covering wire 5 in this way, since the position for generating the arc Ac between the metal wire 5A of the coated wire 5 and the electric torch 18D can be stabillized by connecting the metal wire 5A of the coated wire 5 to the positive potential (+), while connecting the electric torch 18D to the negative potential (-), as compared with the case of connecting them at the opposite polarity, upward creeping of the arc Ac toward the rear end of the metal wire 5 of the coated wire 5 can be reduced. The reduction in the upward creeping of the arc Ac enables to reduce the upward melting of the coating layer 5B of the coated wire 5, thereby preventing the formation of a spherical insulative coating layer.

In the present invention, the metal wire 5A of the coated wire 5 may be connected to a voltage higher or lower than the reference potential GND so that the metal wire 5A of the coated wire 5 has a positive potential relative to the electric torch 18D.

The spool 11 around which the coated wire 5 is wound is constituted as shown in Figs. 4 and 9 (exploded perspective view for a portion). The spool 11 is formed, for example, by applying alumite processing to the surface of cylindrical aluminum metal. The alumite processing is applied for improving the mechanical strength or preventing the occurrence of flaws. Since the spool 11 is applied with the alumite processing as described above, it has an insulative property.

The spool 11 is attached to a spool holder 21 and attached by way of a rotational shaft 21A of the spool holder 21 to the bonding apparatus main body 10.

The spool holder 21 is made, for example, of stainless steel so that it has electroconductivity at least to a portion thereof.

As shown in Figs. 9 and 11 (enlarged perspective view for a portion), a connection terminal 11A is disposed to the spool 11. The connection terminal 11A is disposed in a stop-like form to the side (flanged portion) of the spool 11 in contact with the electroconductive portion of the spool holder 21.

As shown in Fig. 10, the connection terminal 11A comprises a conductor 11Ab disposed above an

insulator 11 Aa and a connecting metal portion 11Ac disposed above the conductor 11Ab. The insulator 11Aa is made, for example, of a polyimide resin so that it can surely isolate electrically the conductor 11Ab from the spool 11 and, in addition, has an appropriate resiliency capable of reliably abutting the connecting metal portion 11Ac against the spool holder 21. The conductor 11Ab is made, for example, of a Cu foil so that it can surely connect the connecting metal portion 11Ac for connecting the metal wire 5A of the coated wire 5 with the connecting metal portion 11Ac in contact with the spool holder 21. The connecting metal portion 11Ac is formed, for example, with electroconductive paste or soldering.

The connecting terminal 11A is constituted such that the metal wire 5A at the end of the coated wire 5 on the side opposite to that supplied to the bonding section 12, that is, the metal wire 5A at the beginning end of the coated wire 5 in winding is connected through a recess formed to the side (flanged portion) of the spool 11. The metal wire 5A is connected by means of the connecting metal portion 11Ac to the connection terminal 11A. The coating layer 5B on the surface of the metal wire 5A at the beginning end of the coated wire 5 is removed by heating or chemically. The connection terminal 11A, that is, the metal wire 5A of the coated wire 5 is connected to the reference ground GND by way of the spool holder 21, the rotational shaft 21A thereof and the bonding apparatus main body 10. The reference potential GND is the same as the reference potential GND for the arc generation device 20 described above.

By disposing the connection terminal 11A to the spool 11 for connecting to the reference potential GND and connecting the metal wire 5A at the beginning end of the coated wire 5 to the connection terminal in this way, since it is possible to connected the wire to the reference potential GND by way of the spool holder 21, the metal wire 5A of the coated wire 5 can surely be connected to the reference potential GND.

Further, by connecting the metal wire 5A of the coated wire 5 to the reference potential GND, since a sufficient potential difference can be secured between the electric torch 18D and the metal wire 5A of the coated wire 5 on the supplying side thereby making the generation of the arc Ac satisfactory upon forming the metal ball $5A_1$, it is possible to surely form the metal ball $5A_1$.

As shown in Figs 3 and 4, the bonding tool 16 is supported by way of a bonding arm 16A to a bonding head (digital bonding head) 22. Although not illustrated, a supersonic vibration device is incorporated in the bonding arm 16A so as to apply supersonic vibrations to the bonding tool 16. The bonding head 22 is supported by way of an X-Y table on a substrate 24. A moving device capable of vertically moving the bonding arm 16A (in the direction of arrow C) is disposed to the bonding head 22, so that the bonding tool 16 can approach and apart from the bonding section 12. The moving device mainly comprises a guide member 22A, an arm moving member 22B, a female threaded member 22C, a male threaded member 22D and a motor 22E. The guide member 22A is so constituted as to move the arm moving member 22B in the direction of arrow C. The motor 22E is constituted so as to rotate the male threaded member 22D, move the female threaded member 22C meshing with the male threaded member 22D by the rotation in the direction of arrow C and then move the arm moving member 22B in the direction of arrow C.

The bonding arm 16A supported by the arm moving member 22B rotates around a rotating shaft 22F. The rotation of the bonding arm 16A around the rotational shaft 22F as the center is controlled by a resilient member 22G. The rotation of the resilient member 22G is controlled such that the bonding section 12 can be prevented from undergoing unnecessary pressing when the bonding tool 16 abuts against the bonding section 12 thereby preventing damage or destruction caused to the bonding section 12.

The wire clamper 15 can put the coated wire 5 therebetween and control the supply of the coated wire 5. The wire clamper 15 is disposed by way of the clamper arm 15A to the bonding arm 16A.

The wire guide member 14 guides the coated wire 5 supplied from the spool 11 to the bonding section 12. The wire guide member 14 is disposed to the clamper arm 15A.

As shown in Figs.3 and 8, a fluid blowing nozzle 18C of a fluid blowing device 25 is disposed near the top end of the coated wire 5 in the supplying direction and near the supplying path of the coated wire 5 between the bonding tool 16 and the bonding section 12. The fluid blowing nozzle 18C is constituted so as to blow a fluid Gs from the fluid blowing device 25 to the portion of forming the metal ball $5A_1$ (metal wire 5A and the coating layer 5B) when it is formed from the metal wire 5A at the top end of the coated wire 5 in the supplying direction. The fluid Gs is blown out from the fluid blowing nozzle 18C, as shown in Fig. 8, so that the coating layer 5B melted upwardly by the heat generated from the arc Ac upon forming the metal ball $5A_1$ with the metal wire 5A at the top end of the coated wire 5.

It is, basically, necessary for the fluid blowing nozzle 18C that it blows the fluid Gs to the top end of the bonding tool 16, that is, to the top end of the coated wire 5 as described above and the nozzle is disposed to the covering member 18A in this example. As shown in Figs. 4 through 7 specifically for the structure, the fluid blowing nozzle 18C is so made as to blow the fluid Gs from the rear end to the top end of the coated wire 5 so as to reduce the upward melting of the coating layer 5B. It is preferred that the fluid blowing nozzle 18C is not attached to the bonding tool 16. If the fluid blowing nozzle 18 is attached to the

bonding tool 16, the weight of the bonding tool 16 is increased to make the load for the supersonic vibration greater thereby reducing the bondability in the connection portion.

As the fluid Gs, gas such as $N_2$, $H_2$, He, Ar, air, etc., is used, which is supplied from a fluid blowing device (fluid source 25) by way of a cooling device 25A, a flow meter 25B and a fluid conveying tube 25C to the fluid blowing nozzle 18C.

The cooling device 25A is so constituted to positively cool the fluid Gs to lower than the normal temperature. The cooling device 25A comprises, for example, an electronic cooling device utilizing Pz effect. As shown schematically in Fig. 8, the fluid conveying tube 25C is constituted so as to cover at least the portion between the cooling device 25A and the supply port of the fluid blowing nozzle 18C with a heat insulating material 25D. That is, the heat insulating material 25D is used not to change the temperature of the fluid Gs cooled by the cooling device 25A during transportation in the fluid conveying tube 25C (for improving the cooling efficiency).

Further, the suction tube 18E connected to the suction device 19 is disposed near the top end of the coated wire 5 in the supplying direction, that is, at a position opposed to the fluid blowing nozzle 18C around the upwardly melting portion of the coating layer 5B of the coated wire 5 as the center. As has been described above, while the suction tube 18E is used also as the conductor for connecting the electric torch 18D with the arc generation device 20, it is mainly constituted so as to suck the upwardly melted coating layer 5Ba of the coated wire 5 and blown out by the fluid blowing nozzle 18. The coating layer 5Ba sucked by the suction tube 18E is sucked to the sucking device 19.

In this example, a ceramic heater 26 for locally heating only the inner lead 3B of the lead 3 to a temperature higher than that for other portions is disposed in the form of a square frame-like configuration as shown in Figs. 2 and 11, in order to bond the other end of the coated wire 5 to the inner lead 3B of the lead 3 more reliably (second bonding). Reference 26A denotes a power supply line to the square frame-like local heating heater 26.

Then, the wire bonding method of this example is to be explained simply.

At first, as shown in Figs. 3, 4, 5 and 8, the bonding tool 16 and the top end of the coated wire 5 in the supplying direction protruded on the pressing side thereof are covered with the covering member 18A. The covering is conducted by the moving device operated by the driving source 18K by moving the coverage member 18A in the direction of arrow A. By the covering with the covering member 18A, the electric torch 18D and the fluid blowing nozzle 18C can be disposed respectively near the top end of the coated wire 5.

Then, as shown in Fig. 8, the arc Ac is generated between the metal wire 5A at the top end of the coated wire 5 in the supplying direction and the electric torch 18D to form the metal ball $5A_1$ from the metal wire 5A. The insulative coating layer 5B at the top end of the coated wire 5 in the supplying direction is melted upwardly by the heat of the arc Ac, by which the metal ball $5A_1$ is formed. That is, the coating layer 5B at the top end of the coated wire 5 in the supplying direction is removed to expose the metal wire 5A.

The metal ball $5A_1$ is formed in a period of time as short as possible. When the metal ball $5A_1$ is formed in a short period of time at a high energy (in the region of high current and voltage), the upwardly melting amount in the coating layer 5B of the coated wire 5 is reduced. The metal ball $5A_1$ can thus be formed in a short time at a high energy by stabilizing the generation of the arc Ac as described above, that is, by setting the electric torch D to the negative potential (-), while setting the metal wire 5A of the coated wire 5 to the positive potential (+).

Upon forming the metal ball $5A_1$, the fluid Gs is blown to the upwardly melting coating layer 5B of the coated wire 5 from the fluid blowing device 25 by the fluid blowing nozzle 18C, the position of which is set together with the covering member 18A, to blow out the coating layer 5B as shown in Fig. 8. The blown out coating layer 5Ba is sucked by way of the sucking tube 18E to the sucking device 19 and removed out of the system.

The fluid Gs from the fluid blowing nozzle 18C is cooled, for example, to about 0(°C) - 10(°C) by the cooling device 25A shown in Fig. 8. As the temperature of the fluid Gs from the fluid blowing nozzle 18C is lower, the upwardly melting amount of the coating layer 5B of the coated wire 5 is decreased. That is, since the fluid Gs cooled by the cooling device 25A can positively cool the metal wire 5A and the coating layer 5B of the coated wire the bonding tool 16, etc., only the coating layer 5B for the arc generation portion is melted while leaving the coating layer 5B in the other portion not melted as it is and, as a result, the upwardly melting amount of the coating layer 5B can be decreased.

Then, the covering member 18A, of the electric torch 18D and the fluid blowing nozzle 18C are moved respectively in the direction of arrow A (in the direction opposite to the above).

Then, the metal ball $5A_1$ formed at the top end of the coated wire 5 in the supplying direction is attracted nearer to the pressing surface of the bonding tool 16.

Then, the bonding tool 16 is brought closer to the bonding section 12 in this state and the metal ball

$5A_1$ formed at the top end of the coated wire 5 in the supplying direction is connected with the external terminal 2C of the semiconductor chip 2 by the bonding tool 16 indicated by the dotted line in Fig. 2 (first bonding). The metal ball $5A_1$ is connected by way of the supersonic vibrations and/or hot-press bonding of the bonding tool 16.

Then, as shown in Fig. 2, the metal wire 5A at the rear end of the coated wire 5 is connected with the inner lead 3B of the lead 3 by means of the bonding tool 16 (second bonding). The rear end of the coated wire 5 is connected by means of ultrasonic vibrations and/or hot-press bonding of the bonding tool 16. Thus, the rear end of the coated wire 5 and the inner lead 3B are firmly wedge-bonded in the second bonding portion $5A_2$.

In the connection for the rear end of the coated wire 5, although the coated wire 5 in the connection portion is previously covered with the coating layer 5B, the coating layer 5B is destructed only for the connection portion to expose the metal wire 5A by applying supersonic vibrations to the bonding tool 16. Although somewhat varying depending on the energy of the supersonic vibrations or hot-press bonding force of the bonding tool 16, the thickness of the coating layer 5B of the coated wire 5 is preferably, for example, about from 0.2 to 3 $\mu$m. If the thickness of the coating layer 5 of the coated wire 5 is excessively thin, the insulation withstand voltage as the insulative coating layer is low. On the other hand, if the thickness of the coating layer 5B of the coated wire 5 is excessively thick, it is difficult to destroy the coating layer 5B by the ultrasonic vibrations of the bonding tool 16. Then, if the thickness of the coating layer 5B exceeds a predetermined value, since the coating layer 5B is no more destructed, connection failure may be caused between the metal wire 5A of the coated wire 5 and the inner lead 3B of the lead 3.

Upon bonding the the other end of the coated wire 5 (second bonding) in this example, since only the inner lead 3B of the lead 3 is locally heated to a temperature higher than that for other portions by the heater 26, the heating and decomposition of the coating layer 5B can be promoted more, by which the bondability in the second bonding can be improved to obtain firm wire bonding.

Subsequently, by isolating the bonding tool 16 (coated wire 5 is disconnected in this case), the first bonding step for the coated wire 5 is completed as shown in Fig. 2.

As described above, in the bonding technique of forming the metal ball $5A_1$ at the top end of the coated wire 5, since the fluid blowing nozzle 18C (as a portion of the fluid blowing device 25) is disposed near the top end of the coated wire 5 for blowing the fluid Gs to the top end of the coated wire 5, the upwardly melting portion of the coating layer 5B of the coated wire 5 can be blown off and, accordingly, formation of the spherical portion of the insulative coating layer 5B to the coated wire 5 can be prevented. As a result, since it is possible to prevent the coated wire 5 from being caught to the bonding tool 16 by the spherical portion of the insulative coating layer 5B and the coated wire 5 can be attracted to the pressing surface of the bonding tool 16, the ball bonding can be conducted and the bonding failure can be prevented.

Further, in the bonding technique of forming the metal ball $5A_1$ at the top end of the coated wire 5, since the fluid blowing nozzle 18C (as a portion of the fluid blowing device 25) is disposed and the suction tube 18E (suction device 19) is disposed near the top end of the coated wire 15 for sucking the coating layer 5B of the coated wire 5 blown out by the blowing of the fluid Gs from the fluid blowing nozzle 18C, it is possible to blown out the upwardly melted coating layer 5B of the coated wire 5 to prevent the formation of the spherical portion of the coating layer 5B of the coated wire 5, and to prevent the bonding failure as described above. In addition, since the blown out coating layer 5Ba is not scattered to the bonding section 12, bonding failure due to the scattered coating layer 5Ba can be prevented. Bonding failure due to the scattered coating layer 5Ba means, for example, such a case that the coating layer 5Ba is scattered between the external terminal 2C of the semiconductor chip 2 or the inner lead 3B of the lead 3 and the metal wire 5A of the coated wire 5, to result in conduction failure between both of them.

Furthermore, in the bonding technique of forming the metal ball $5A_1$ at the top end of the coated wire 5, since the fluid blowing nozzle 18C (as a portion of the fluid blowing device 25) is disposed and the cooling device 25A for cooling the fluid Gs from the fluid blowing nozzle 18C is disposed near the top end of the coated wire 5, upward melting of the insulative coating layer 5B of the coated wire 5 can remarkably be decreased and the coating layer 5B, if it is melted upwardly, can be blown out, by which formation of the spherical coating layer 5B to the coated wire 5 can be prevented and bonding failure as described above can be prevented.

Furthermore, in the bonding technique of using the coated wire 5, the metal ball $5A_1$ is formed at the top end (in the supplying direction) of the coated wire 5, the metal ball $5A_1$ is connected to the external terminal 2C of the semiconductor chip 2, the rear end (in the supplying direction) of the coated wire 5 is brought into contact with the inner lead 3B of the lead 3, the coating layer 5B of the contact portion is destroyed and the metal wire 5A at the other end of the coated wire 5 is connected to the inner lead 3B of the lead 3. In this way, the coating layer 5B at the rear end of the coated wire 5 can be removed without

using a torch for removing the coating layer and accordingly, a torch for removing the coating layer and a moving device, a control device therefor, etc. can be saved. As a result, the structure of the bonding apparatus can be simplified.

Particularly, in the semiconductor device 1 in this example, since a heat resistant polyurethane prepared by reacting a polyol ingredient and an isocyanate and containing constituent units derived from terephthalic acid in the molecule skelton is used, tab short-circuit, chip short-circuit or inter-wire short-circuit due to destruction of the insulative layer caused by the heat decomposition of the coating layer 5B can surely be prevented.

That is, after bonding the coated wire 5 as described above, resin-molding is conducted using the resin material 6 to manufacture a resin-encapsulated semiconductor device 1. In this case, if the distance between the external terminal 2C of the semiconductor chip 2 and the bonding portion of the inner lead 3B of the lead 3 is great as shown in Fig. 13, this may possibly lead to a so-called chip touch in which the coated wire 5 and the silicon region of the semiconductor chip 2 are brought into contact as shown in Fig. 13, a so-called tab touch in which the coated wire 5 and the tab 3A are brought into contact as shown in Fig. 15 and a so-called interwire touch in which the coated wires 5 are brought into contact with each other. Such wire touch is liable to occur if the length of the wire is increased to greater than 2.5 mm, or if the size of the tab 3A is excessively greater than that of the semiconductor chip 2.

When such a wire touch should occur, the coating layer 5B of the coated wire 5 is destroyed by heat degradation due to the heat generated from the semiconductor chip 2, by which the metal wire 5A is brought into direct contact with the semiconductor chip 2, causing chip short-circuit between the wire and the semiconductor chip 2 as shown, for example, in Fig. 14, or a tab short-circuit failure between the wire and the tab 3A as shown in Fig. 16 and, further, inter-wire short-circuit between the wires to each other.

However, in the semiconductor device 1 in this example, since the coating layer 5B of the coated wire 5 is made of the specific heat resistant polyurethane, even if chip touch, tab touch or interwire touch should occur as described above, short-circuit failure can surely be prevented.

For confirming the effect of preventing the short-circuit failure according to the present invention, explanation is to be made for the result of the experiment conducted by the present inventors for the semiconductor device after resin encapsulation as Experimental Example 1. In the Experimental Example, "parts" means "parts by weight".

Experimental Example 1

At first, starting materials as shown later in Table 1 were blended at the ratio as shown in the table and charged in a 500 cc flask, to which a thermometer and a steam condensor were attached, and they were reacted to obtain three kinds of terephthalic acid polyols P-1, P-2 and P-3. The ratio between terephthalic acid and ethylene glycol, reaction time, etc. are also shown in Table 1. The end point for the synthesis reaction was determined based on the theoretical reaction water and an acidic value of not greater than 5. In this case, the reaction was conducted at a reduced pressure if required.

Three kind of terephthalic acid type polyols P-1, P-2 and P-3 obtained as described above and commercially available polyols were used, and the polyol ingredients and the isocyanate ingredients were blended at the ratios as shown in Table 2 described later, to prepare coating compositions. Each of the thus obtained coating compositions was diluted to 10% concentration by using a solvent, which was coated at least by twice to the outer circumferential surface of the wire main body, heated at 175°c for 21 min and applied with post-curing at 170°C for 2 hours, to prepare an insulative coating layer comprising a heat resistant polyurethane, which was fabricated into a wire. The blending ratio of the composition and the property of the coating film in this case are shown in Table 2 described later.

Then, the semiconductor chip applied with wire bonding as described above by using the heat resistant polyurethane coated wire obtained as described above was molded with resin material to manufacture a semiconductor device in the states of with touch as shown in Fig. 13 (chip touch) and Fig. 15 (tab touch). Then, a temperature cycle test was conducted according to MIL-883B to carry out an experiment for comparing the short-circuit rate relative to the semiconductor device using a wire coated with a commercially available polyurethane, and the improvement made in the present invention was evaluated.

The result of the comparative experiment was as shown in Figs. 17 and 18. That is, Fig. 17 shows the short-circuit rate between the semiconductor chip and the coated wire in the chip touch state as shown in Fig. 13. As apparent from the figure, a remarkable effect for preventing the short-circuit, that is, chip short-circuit was confirmed in the semiconductor device using the heat resistant polyurethane coated wire according to the present invention as compared with the semiconductor device using the wire coated with

the commercially available polyurethane.

Fig. 18 shows the short-circuit rate between the tab and the coated wire in the tab touch state shown in Fig. 15. Also in this case, a remarkable effect of preventing the short-circuit rate, that is, tab short-circuit was confirmed in the semiconductor device using the heat resistant polyurethane coated wire according to the present invention.

Next, the present inventors have made a comparative experiment for the wire in the state before resin encapsulation under the test conditions described later between the heat resistant polyurethane coated wire according to the present invention and the wire coated with a commercially available polyurethane to evaluate the abrasion resistance and the degradation rate of the coating layer. The results of the experiment and the results of other various experiments are to be explained as Experimental Examples 2-5 referring to Figs. 19 through 25.

Experimental Example 2

The experimental conditions were as shown by the model chart in Fig. 19. That is, a constant load (1 g) was suspended vertically from the lower end of a coated wire 5 coated at the outer surface thereof with the insulative coating layer (heat resistant polyurethane according to the prevent invention or commercially available polyurethane). A tab 3A of a lead frame is brought into contact at one edge thereof with the coated wire 5 at an angle of contact: $\alpha = 45^\circ$. Then, a pressing force is applied horizontally to the coated wire 5 at a load $W_1$ (0.65 g) from the side opposite to the contact portion of the tab edge and the tab 3A was vibrated vertically with 20 $\mu$m amplitude, to evaluate the abrasion, etc. of the coating layer 5B.

In this case, evaluation was made while defining the the number of frequency (cycle for the amplitude (vibration) Nf till the coating layer 5B is destroyed by abrasion as the abrasion resistance.

Further, the heat resistance of the coating layer 5B was evaluated by measuring Nf after leaving it at high temperature of 150°C to 200°C, for 0 to 1,000 hours).

As a result, it has been found that in the case of the polyurethane, thermal degradation can be suppressed remarkably and the temperature cycle life $T_\infty$ can also be improved remarkably by imidizing the material.

The results of the experiment are specifically explained.

At first, Fig. 20 and 21, respectively, show the heat degradation of the abrasion strength of the coating layer 5B at a temperatures of 150°C and 175°C (reduction of the frequency for destroying coating layer after 100 hours). As apparent from these figures, in the coating layer using the heat resistant polyurethane according to the present invention, it has been found that the reduction in the abrasion strength Nf was small even after the elapse of time left at high temperature and the degradation in the coating layer was extremely small. Particularly, it has been found that the degradation rate in the reduction of the frequency for destroying the coating layer 5B is less than 20 % after 100 hours, which means an extremely advantageous characteristic for the coated wire.

Experimental Example 3

Fig. 22 shows result of an experiment for a relationship between the temperature indicated on the abscissa and the degradation rate, that is, the degradation velocity (ΔNF/100 hours) $N_0 - N_{100}$ /100 hours) indicated on the ordinate. Also in this figure, it can be seen that the degradation velocity is extremely low in the case of the heat resistant polyurethane according to the present Invention as compared with the case of the commercially available polyurethane.

Experimental Example 4

Then, Fig. 23 shows the result of an experiment showing a relationship between the imidization rate for the coating layer (abscissa) and the degradation velocity, that is, the degradation rate (ordinate on the left) and the peeling strength in the second bonding for the coated wire (ordinate on the right).

The peeling strength for the second bonding is a result of an experiment conducted by the present inventors for the bonding made to the inner lead 3B without previously peeling the coating layer 5B as shown in Fig. 2 by using a heat resistant polyurethane coated wire with a diameter : $\varnothing = 25\ \mu$m.

As apparent from Fig. 23, the imidization rate of about 1/3 for the coating layer is preferred for both of

the degradation velocity (degradation rate) and the peeling strength.

Particularly, in the case of the heat resistant polyurethane coated wire according to the present invention, since the peeling strength in the second bonding portion is large, the bonding reliablity is high and an extremely advantageous effect can be obtained.

Experiment Example 5

Further, Fig. 24 shows the result of an experiment showing a relationship between the temperature cycle amplitude (-55 - 150 °C) and the temperature cycle test of the coated wire. As apparent from figure the life T∞ of the coated wire with the commercially available polyurethane is about 400, whereas it is greatly improved to more than 4000 in the case of the heat resistant polyurethane coated wire according to the present invention.

Experiment Example 6

Further, Fig. 25 is a graph showing the result of an experiment demonstrating the effect of adding a pigment to the coating layer of the coated wire on the degradation velocity (degradation rate).

According to the findings of the present inventors, when a metal ball is formed, for example, in a case of conducting the bonding by using the coated wire 5, since the thickness of the coating layer 5B is extremely thin, it is extremely difficult to confirm the upward melting or peeling thereof and it is almost impossible at least with naked eyes. In view of the above, the present inventors have found that if a pigment, for example, oil scarlet is added to the coating layer 5B, the upward melting or the peeling thereof can be observed visually (for example, by using an electron microscope), which is extremely useful.

However, since excess addition of the pigment increases the degradation velocity (degradation rate) of the coating layer, the present inventors have made various studies to determine the appropriate amount thereof and the results are shown in Fig. 25.

As apparent from the result of the experiment in Fig. 25, if the addition amount of the pigment is too much, the degradation velocity (degradation rate) of the coating layer is increased, whereas if the addition amount is insufficient, the foregoing merit by the addition of the pigment is lost. Then, in view of the two requirements conflicting with each other, the present inventors have made an earnest study and, as a result, found that the suitable addition amount of the pigment (oil scarlet in this example) is less than 2.0 % by weight and, particularly, from 0.5 to 2.0 % by weight. By adding the pigment within the above-mentioned range to the coating layer, it is possible to obtain a merit capable of visually confirming the upward melting or the peeling of the coating layer from the coated wire.

The present inventors have obtained the following findings from Experimental Example 1, Experimental Examples 2 - 6, as well as various other experiments, studies, confirmation, etc.

That is, the use of the heat resistant polyurethane of the above-mentioned composition according to the present invention as the coating layer of the coated wire is extremely useful for improving the thermal degradation or bondability of the layer and, further, for the improvement of the peeling strength of the bonding.

In addition to the above, as apparent, for example, from Experimental Example 2, it is extremely important to use, as the constituent material for the coating layer such material that can reduce the thermal degradation (degradation rate) of the coating layer, that is, the degradation rate in the reduction of the frequency for destroying the coating layer at 150 °C - 175 °C after 100 hours to less than 20 %, through the temperature cycle test and the abrasion test under the experimental conditions in Fig. 19 for the coating layer.

Furthermore, as the characteristics required for the coating layer, it is also extremely important that if the coated wire is actually used for the wire bonding operation, it does not give undesired effect on the bondability, etc. As a result of the earnest study by the present inventors in this regard, it has been found that constitution of the coating layer with material showing no carbonization upon forming the metal ball in the ball bonding or upon removing the coating layer under heating.

The reason is as described below. That is, the coating layer is melted upwardly just above the metal ball when the metal ball is formed or the coating layer is removed by heating, if the coating layer is carbonizable, it is not decomposed but carbonized at the heating temperature, for example, at a high temperature of 1,060 °C. As a result, since the carbonized coating layer is deposited to remain so as to cover the metal wire just above the metal ball, the deposited carbonized coating layer forms an obstacle

that hinders the supply of the coated wire through the capillary upon conducting the bonding by the bonding tool, making it difficult or impossible for the coated wire to pass through the capillary. On the other hand, if the deposited carbonized coating layer should drop by some or other reason to the surface of the semiconductor chip for forming integrated circuit, electroconductivity carbides would cause electric short-circuit failure for the integrated circuit. In addition, it has also been found that the coated wire deposited with the carbides also causes bonding failure, for example, upon second bonding to the inner lead.

Taking such facts collectively into consideration, it has been confirmed by the present inventors that two conditions are extremely important, that is, the degradation rate under the predetermined conditions as described above, i.e., the degradation rate in the reduction of the frequency for destroying the coating layer at 150° C - 175° C after 100 hours is less than 20 %, as well as the material shows no carbonizable when the metal ball is formed or the coating layer is removed by heating, and the material capable of satisfying the two conditions can provide extremely satisfactory results as the coated wire.

Then, as a result of the study made by the present inventors, although the heat resistant polyurethane of the composition as described above can of course satisfy the two conditions, the materials capable of satisfying the two conditions are not restricted only to the heat resistant polyurethane with the composition as described above, but heat resistant polyurethanes of other compositions and, further, those materials other than the heat resistant polyurethane can also be utilized as the preferred material for the coating layer.

Referring to this, among the polyurethanes, commercially available polyurethanes and formal can satisfy the requirement of showing no carbonizability but they can not be said suitable as the coating layer since their degradation ratio exceeds 20 %.

On the other hand, since polyimide, polyamide, nylon polyester, polyamideimide, polyesterimide, etc. show the carbonizability upon forming the metal ball or removal of the coating layer under heating, it has been found that they involve a drawback for use as the coating layer of the coated wire and can not be said optimum.

Then, the present invention is further described referring to various other examples of the wire bonding method utilizable for the present invention referring to Fig. 26 through 30.

In Example 1-II shown in Fig. 26, as one example of other wire bonding method included in the present invention, the same ball bonding method by the metal ball $5A_1$ as that in the previous Example 1 is employed on the side of the first bonding of the coated wire 5, but the coating layer 5B is previously removed prior to the second bonding as illustrated by the second bonding portion $5A_{22}$ and the second bonding is conducted by means of hot-press bonding and/or supersonic vibration method.

Then, in Example 1-III shown in Fig. 27, bonding is applied at the second bonding portion $5A_2$ without removing the coating layer 5B in the same manner as in Example 1-I. In addition, the first bonding is applied, not by the ball bonding method by using the metal ball, but by the hot-press and/or supersonic vibration method without previously removing the coating layer 5B, thereby forming the first bonding portion $5A_{11}$.

Accordingly, in this example, both of the first and the second bondings employ the identical bonding method.

Further, in Example 1-IV shown in Fig. 28, although the first bonding portion $5A_{11}$ is identical with that in Example 1-III, the bonding is applied for the second bonding portion $5A_{22}$ by previously removing the coating layer 5B in the same manner as that in Example 1-II.

In Example 1-V illustrated in Fig. 29, a bonding method of previously removing the coating layer 5B is used for the first bonding portion $5A_{12}$, while bonding is applied to the second bonding portion $5A_2$ without removing the coating layer 5B in the same manner as in Examples 1-I and 1-III.

In Example 1-VI illustrated in Fig. 30, bonding is applied to both of the first bonding portion $5A_{12}$ and the second bonding portion $5A_{22}$, in which the metal wire 5A is bonded by the non-ball forming method by previously removing the coating layer 5B.

Fig. 31 is a cross sectional view for a portion, illustrating the wire bonding portion in Example.1-VII according to the present invention.

In this example, the coating layer of the coated wire 5 has a composite coating layer structure. That is, the outer surface of the coated wire 5 is coated with the coating layer 5 made of the heat resistant polyurethane as described above and, the outer surface of the coating layer 5B is further coated with a second coating layer 5C comprising other insulative material.

As the material for the second coating layer 5C, polyamide resin, special polyester resin, special epoxy resin, etc. can be used as described above. The second coating layer can be applied by using nylon etc also with an aim of improving the sliding property of the coated wire in the capillary.

The thickness of the second coating layer 5C can be made to less than twice, preferably, less than 0.5

times of the thickness for the coating layer 5B.

Although the invention made by the present inventor has been specifically explained referring to the examples, the present invention is not restricted only to such examples but various modifications are of course possible within a range not departing the scope thereof.

For instance, materials for forming the coating layers 5B or 5C, for example, polyol ingredient, isocyanate, terephthalic acid, as well as the kind and the composition of the compounds and additives are not restricted only to those in the examples as described above.

Further, the material for the metal wire 5A of the coated wire and the bonding method therefor are not res tricted to those in the examples described above.

Further, the structure of the wire bonding apparatus used for practicing the present invention is not restricted to those in the examples described above.

Although the foregoing explanations have been made mainly for the cases where the invention made by the present inventor is applied to the resin encapsulated semiconductor devices as the application field thereof, the present invention is not restricted only to them but is generally applicable, for example, to various other semiconductor devices such as ceramic encapsulated semiconductor devices, as well as production techniques therefor.

The effects obtained by typical inventions among those disclosed in the foregoing examples are simply explained as below.

(1) In a method of manufacturing a semiconductor device, in which external terminals of a semiconductor chip and a lead are connected by way of coated wires each comprising a metal wire coated at the surface thereof with an insulative coating layer, since the coating layer for the coated wire comprises a heat resistant polyurethane prepared by reacting a polyol ingredient and an isocyanate and containing constituent units derived from terephthalic acid in the molecule skelton, and the coated wire is connected at one end thereof with the external terminal of the semiconductor chip while connected at the other end thereof with the lead, destruction of the coating layer due to thermal degradation can be prevented. Accordingly, occurrence of electric short-circuit failure such as tab short circuit, chip short-circuit and inter-wire short-circuit of the coated wire can surely be prevented.

(2) If the coated wire results in flextion or the like, neither cracking nor defoliation of the coating layer is developed and a highly reliable semiconductor device with no wiring failure can be obtained.

(3) Since the urethane bonding in the heat resistant polyurethane constituting the coating layer is decomposed into a bondable state at a bonding temperature or by means of the supersonic vibration energy upon usual wire bonding, firm bonding can be applied by means of hot-press bonding by usual heating and/or supersonic vibration.

(4) Since the coating layer is not carbonized due to the reason as described above in (3), it can prevent the carbonization product from hindering the passage of the coated wire through the capillary or from dropping on the integrated circuit to cause electric short-circuit, as well as prevent the carbonization product from worsening the wire bondability.

(5) Reliable wire bonding can be applied by the usual wire bonding apparatus by the reason described in (3) above. Particularly, by using the wire bonding apparatus as illustrated in the example, extremely reliable wire bonding can be conducted.

(6) Upon connecting the other end of the coated wire to the lead, more reliable wire bonding is possible by heating only the wire bonding portion of the lead.

(7) By adding a pigment by a predetermined amount to the coating layer of the coated wire, the upward melting or the removal of the coating layer when the metal ball is formed or the layer is removed by heating can be visually confirmed without damaging the characteristics of the coating layer, which is useful for the control and the inspection of the bonding.

(8) Multi-terminal arrangement (multi-pin arrangement) can be attained for the semiconductor device using the coated wire by the constitution (1) as described above.

(9) Electric short-circuit failure can surely be prevented by disposing the second insulative coating layer on the coating layer of the coated wire.

(10) In a method of manufacturing a semiconductor device, in which external terminals of a semiconductor chip and a lead are connected by means of coated wires each comprising a metal wire coated at the surface thereof with an insulative coating layer, since the coating layer of the coated wire is made of such material that the degradation rate in the reduction of the frequency for destroying the coating layer at 150°C - 175°C and after 100 hours is less than 20 % and that is not-carbonizable upon forming the metal ball or upon removing the coating layer, the electric short-circuit failure due to the degradation of the coating layer can surely be prevented. In addition, since the carbonization of the coating layer can be prevented, it can prevent that the coated wire is hindered from passage through the capillary by the

deposition of the carbonization product, prevent the carbonization product from dropping on the surface of the integrated circuit to form electroconductive obstacles and lead to electric short-circuit failure, as well as prevent that the bondability is worsened due to the deposition of the carbonization product.

(11) In a semiconductor device in which external terminals of a semiconductor chip and a lead are connected by means of coated wires each comprising a metal wire and an insulative coating layer coated to the surface thereof, since the coating layer of the coated wire is made of a heat resistant polyurethane prepared by reacting a polyol ingredient and an isocyanate and containing constituent unit derived from units derived from terephthalic acid in the molecule skelton, it is possible to obtain a semiconductor device with no electric short-circuit failure caused by the heat degradation of the coating layer.

(12) In a semiconductor device in which external terminals of a semiconductor chip and a lead are connected by means of coated wires each comprising a metal wire and an insulative coating layer coated to the surface thereof, since the coating layer of the coated wire is made of such material that the degradation rate in the reduction of the frequency for destroying the coating layer at 150°C - 175°C and after 100 hours is less than 20 % and shows no carbonizability upon forming the metal ball or the removal of the coating layer, it is possible to obtain a semiconductor device capable of preventing electric short-circuit failure caused by the thermal degradation of the coating layer, as well as preventing hinderance for the passage of the coated wire through the capillary due to the formation and deposition of the carbonization product, short-circuit failure of the integrated circuit due to the dropping of the carbonization product, the bonding failure due to the deposition of the carbonization product, etc.

(2) Example 2

Fig. 32 is a cross sectional view illustrating the constitution of a semiconductor device as Example 2 according to the present invention;

Fig. 33 is a plan view for a portion illustrating the configuration of a lead frame, viewed from above, used in the above-mentioned example;

Fig. 34 is a cross sectional view for a portion illustrating the inner structure of a semiconductor chip in the above-mentioned example;

Fig. 35 is a perspective view illustrating a wire used in the example;

Fig. 36 is an explanatory view illustrating the property of the wire;

Fig. 37 is a schematic explanatory view illustrating an intermediate layer forming apparatus used for coating the intermediate layer to the wire of the example;

Figs. 38(a) and (b) are explanatory view for the constitution of the wire bonding apparatus used in the example;

Fig. 39 is an explanatory view illustrating the constitution of a resin molding apparatus used for forming a package in the example;

Fig. 40 is a plan view illustrating the surface of a die in the resin molding apparatus;

Fig. 41 is an explanatory view illustrating a relationship between the heat expansion coefficient and the blending amount of the filler;

Fig. 42 is an explanatory view illustrating a relationship between the viscosity of the resin in the molten state and the blending amount of the filler;

Fig. 43 is an explanatory view illustrating a relationship between the wire short-circuit rate and the blending amount in comparison with the prior art;

Table 3 shows the frequency of temperature cycles at a predetermined failure rate in comparison with the prior art;

Fig. 44 is an explanatory view illustrating the change of the water penetration state in PCT (pressure cooker test) in comparison with the prior art.

Table 4 shows the change for the number of failures based on the number of specimens using specific products in the PCT.

As shown in Fig. 32, a semiconductor device 201 in this example comprises such a structure as having a semiconductor chip 204 mounted by way of a resin paste 203 on a tab 202, which is encapsulated at the periphery thereof with a resin 205 such as an epoxy resin. At the inside of the encapsulation, inner leads of a lead 206 led out of the package are situated at the periphery of the semiconductor chip 204 and the surface of the inner leads and the semiconductor chip 204 are connected by way of looped wires 207. Details for the connection by the wires 207 are to be described later.

The lead 206 is led from the side of the package to the outside and bent into a S-shaped cross sectional configuration. The tab 202 and the lead are provided in the state of a lead frame 208 as shown in

Fig. 33 before the resin molding step.

That is, the lead frame 208 has a tab 202 supported at the center thereof by a tab-suspending lead 210, and leads 206 are extended radially at the periphery of the tab 202 while not in contact with the tab 202.

The lead frame 208 of such a shape can be formed, for example, by fabricating an electroconductive plate-like member of about 0.15 mm thickness made of iron-nickel (Fe-Ni) alloy, Kovar or 42 alloy into a predetermined configulation by means of etching or press-punching, etc. Gold (Au) soldering, etc. may be deposited to the surface at the inner end of the tab 202 or the lead 206.

The semiconductor chip 204 mounted by means of the resin paste 203 on the tab 202 has a structure as shown schematically in Fig. 34. That is, a silicon oxide film 21, of about 0.45 µm thickness is formed above a chip substrate 211 comprising silicon (Si) formed to a thickness of about 400 µm and, further thereover, a PSG film 213 as an inter-layer insulation film is formed to a thickness of about 0.3 µm. Further, a passivation film 214 is deposited to a film thickness of about 1.2 µm as a protection film to the uppermost layer, in which an external terminal 215 (bonding pad) of about 0.8 µm thickness made of aluminum (Al) disposed partially at the lower layer is exposed upwardly through an opening to a portion thereof.

A wire 207 for connecting the external terminal 215 and the surface at the inner end of the lead 206 has a structure, as shown in Fig. 35, comprising a first intermediate layer 216A and a second intermediate layer 216B in this example. In the sebsequent explanation, the first and the second intermediate layers are collectively referred to merely as an intermeidate layer 216.

As a metal layer 217 constituting the axis of the wire 207, gold (Au), copper (Cu) or aluminum (Al) is used.

In the wire 207 of this example, the diameter of the metal wire 217 as the axis is about 25 µm and the intermediate layer 216 of a dual layer structure formed at the periphery thereof has a thickness of about 2 µm. Accordingly, the entire diameter of the wire 207 is from 29 to 30 µm. The total diameter for the wire 207 is made not greater than 30 µm, because the flow resistance is increased in the resin molding and the possibility for the disconnection in the wire 207 is increased as described later if the wire structure has a diameter greater than the above. However, this does not necessarily means that a wire with a diameter of greater than 30 µm can not be used.

As the first intermediate layer 216A disposed at the periphery of the metal wire 217, a heat resistant polyurethane resin is used in this example, which is formed by reacting a polyol ingredient and an isocyanate and contains constituent units derived from terephthalic acid in the molecule skelton. The use of the heat resistant polyurethane resin of the above-mentioned composition as the first intermediate layer 216A is extremely useful in view of the thermal degradation, and the bondability of the first intermediate layer 216A, as well as for the improvement of the peeling strength of the bonding, etc.

For the specific requirement for the characteristics of the first intermediate layer 216A, it is important to select those materials capable of satisfying the conditions that the degradation rate in the reduction of the frequency for destroying the intermediate layer is less than 20 % under the circumstance of 150 to 175 °C and after 100 hours through the temperature cycle test, abrasion test under experimental conditions shown in Fig 36, etc.

It is further necessary that the material causes no disadvantage for the bondability when actual wire bonding operation is made to the wire 207. According to the result of the study made by the present inventor in this regard it is desirable to constitute the intermediate layer 216 with those materials showing no carbonizability upon removal of the layer 216 by heating when a metal ball 218 described later is formed.

The reason is as described below. That is, during removal of the intermediate layer 216 by heating upon forming the metal ball 218, the intermediate layer 216 is melted upwardly above the metal ball 218. In this case, if the intermediate layer 216 is carbonizable, the intermediate layer 216 is not decomposed but carbonized under the heating temperature, for example, at high temperature condition of about 1,060 °C. As a result, since the carbonized intermediate layer 216 is deposited to remain at the surface of metal wire 217 while wrapping the metal wire 217 just above the metal ball 218, this constitutes adsorbed obstacles to cause clogging in a bonding tool 248 and in an extreme case, leads to wire curling and, furthermore, wire disconnection.

When such facts are collectively taken into consideration, it is necessary that the intermediate layer 216A for the wire 217 can satisfy at least the following two conditions.

At first, the degradation rate should be less than 20 % in the reduction of frequency for destroying the intermediate layer under temperature conditions of from 150 °C to 175 °C and after 100 hours through the temperature cycle test or abrasion test under experimental conditions shown in Fig. 36, etc.

Next, the intermediate layer 216 has to be constituted with such material as showing no carbonizability upon removal of the layer by heating when the metal ball 218 is formed.

Referring more specifically to the heat resistant polyurethane as the constituent material for the first intermediate layer 216 satisfying the above-mentioned conditions, the heat resistant polyurethane is obtained by using a polymer ingredient comprising a terephthalic polyol containing active hydrogens as the main ingredient and an isocyanate. In this specification, "as the ingredient" means also the case where the entire portion consists only of the main ingredient.

The terephthalic acid polyol containing active hydrogens can be obtained by using terephthalic acid and a polyfunctional alcohol and through an esterifying reaction by a customary method within a range of OH/COOH = 1.2 - 30 while setting reaction temperature to 70 - 250° C. Generally, those having an average molecular weight from 30 to 10,000 and containing about from 100 to 500 hydroxy groups and having hydroxy groups on both terminal ends of the molecular chain are used.

As the starting material for constituting the terephthalic acid polyol there can be mentioned those aliphatic glycols such as ethylene glycol, diethylene glycol, propylene glycol, dipropylene glycol, hexane glycol, butane glycol, glycerine, trimethylol propane, hexane triol and pentaerythritol. Polyhydric alcohols such as 1,4-dimethylol benzene may also be mentioned in addition to the above. Among them, ethylene glycol, propylene glycol and glycerine are used particularly preferably.

Although terephthalic acid is used as the carboxylic acid, amide acid or imide acid may also be used together if necessary.

Further, dibasic acid such as imide phthalic acid, orthophthalic acid, succinic acid, adipic acid and sebatic acid, or polybasic acid such as 1,2,3,4-butane tetracarboxylic acid, cyclopentane tetracarboxylic acid, ethylene tetracarboxylic acid, pyromellitic acid, trimellitic acid, etc. may be used together at such an extent as causing no reduction in the heat resistance.

As the isocyanate to be reacted with the terephthalic acid polyol, there can be mentioned those obtained by blocking isocyanate groups of a polyvalent isocyanate having at least two isocyanate groups in one molecule such as toluylene diisocyanate and xylylene isocyanate with those compounds having active hydrogens, for example, phenols, caprolactam and methylethyl ketoxime. Such isocyanates are stabilized. Further, there can be mentioned those prepared by reacting a polyvalent isocyanate compound as described with a polyfunctional alcohol or polyhydric alcohol such as trimethylol propane, hexane triol or butane diol and blocking with a compound having active hydrogens.

As examples of the isocyanate compounds, there can be mentioned Millionate MS-50, Colonate 2,501, 2503, 2505, Colonate AP-St, Desmodule CT-St, etc. Then, as the polyvalent isocyanate, those having a molecular weight of about 300 to 10,000 are preferably used.

In the present invention, a coating composition is prepared by using the starting materials as described above, which is coated on the metal wire 217 of the wire main body to a thickness of about several micronmeters, thereby obtaining a wire 207 in which the periphery of the metal wire 217 as the wire main body 207 is insulated. In such coating, an intermediate layer forming apparatus 220 described later and illustrated in Fig. 37 may be used. The coating composition as described above may be obtained by adding, based on one equivalent of the hydroxy groups in the polyole ingredient, from 0.4 to 4.0 equivalent, preferably, from 0.9 to 2.0 equivalent of isocyanate groups of the stabilized isocyanate and a required amount of a curing promotion catalyst and, further, an appropriate amount of an organic solvent (phenols, glycol ethers, naphthas) to a solid content usually of from 10 to 30 % by weight. In this case, additives such as an appearence improver, dye, etc. may be blended each in an appropriate amount if required.

In the present invention, from 0. 4 to 4.0 equivalent of the isocyanate groups of the stabilized isocyanate is added based on one equivalent of the hydroxy groups of the polyol ingredient, because the crazing property of the resultant insulated wire 207 is reduced if the addition amount is less than 0.4 equivalent, whereas the abrasion resistance of the coating film is worsened if it exceeds 4.0 equivalent. The curing promotion catalyst added upon preparing the coating composition is preferably from 0.1 to 10 part by weight based on 100 parts by weight of the polyol ingredient. If the addition amount is less than 0.1 parts by weight, the curing promotion effect is reduced and the coating film-forming property tends to be worsened. On the contrary, if the addition amount exceeds 10 parts by weight, the thermal degradation property of the resultant heat resistant urethane bonding wire is worsened.

As the curing promotion catalyst, there can be mentioned metal carboxylate, amino acid and phenols and, specifically, zinc salt, iron salt, copper salt, manganese salt, cobalt salt and tin salt of naphthenic acid, octenic acid, versatic acid, etc., 1,8-diazabicyclo(5,4,0) undecene-7,2,4,6-tris(dimethylaminomethyl)phenol. After coating the coating composition as described above on the surface of the metal wire 217 as the wire main body by the intermediate layer forming apparatus 220 described later, it is baked in a baking apparatus 221 described later.

The coating and baking conditions described above vary depending on the blending amounts of the polyol ingredient, stabilized isocyanate, polymerization initiator and curing promotion catalyst, etc. but it is

usually from 4 to 100 sec at 200 to 300°C. In short, baking is conducted at a temperature and for a time sufficient to substantially complete the curing reaction for the coating composition, thereby obtaining the wire 207 in this example.

As the result of the study made by the present inventor, et al, although commercially available polyurethane or formal, in addition to the heat resistant polyurethane of the composition described above, can satisfy the requirements for the no carbonizability, since their degradation rate under the foregoing conditions in the reduction of frequency for destroying the intermediate layer at a temperature from 150°C to 175°C, after 100 hours exceeds 20 %, they can not be said suitable as the first intermediate 216A.

On the other hand, it has been found that since polyimide, polyamide, nylon, polyester, polyamideimide and polyesterimide show carbonizability upon forming the metal ball 218 or removal of the first intermediate layer 216 by heating, they have a drawback when used as the first intermediate layer 216A of the wire 217 and can not be said suitable.

The second intermediate layer 216B formed at the periphery of the first intermediate layer 216 is constituted with a fluoro-resin in this example. The fluoro resin has an excellent property in view of the releasability with other resin, for example, an epoxy resin constituting the package. Accordingly, after the resin molding described subsequently, the entire wire 207 can move finely in the cured resin 205 by means of the presence of the second intermediate layer 216B to provide such a structure that disconnection of the wire 207 is prevented even if the resin 205 as the package undergoes changes of shape by thermal stresses.

Assuming such a case that the wire 207 has a structure only having the first intermediate layer 216, since the adhesion between the heat resistant polyuretane resin constituting the first intermediate layer 216A and the epoxy resin as the resin 205 in the wire structure is excessively high, the wire 207 follows after the deformation due to even slight thermal stresses. As a result, flow of wire is caused and in a case if the resin molding is applied under the state where the tab 202 or the semiconductor chip 204 and the first intermediate layer 216A of the wire 207 are in contact with each other, the wire 207 is liable to be disconnected even with slight deformation caused by thermal stresses in the resin 205.

In this regard, since the second intermediate layer 216B is disposed around the first intermediate layer 216A by means of the fluoro-resin of good releasability in this example, the wire 207 can move finely in the resin 205 also after the resin molding. Accordingly, the wire does not follow after the deformation of the resin 205 caused by thermal stresses and the disconnection of the wire 207 can be prevented effectively.

Formation of the second intermediate layer 216B described above can be attained by coating a molten fluoro-resin to the periphery of the first intermediate layer 216A.

Then, the intermediate layer forming apparatus 220 for forming the first and the second intermediate layers 216A, 216B described above is to be explained specifically.

The intermediate layer forming apparatus 220 in this example comprises, as shown in Fig. 37, a first storage reservoir 222A and a second storage reservoir 222B, in which baking devices 221, 222 are disposed corresponding to the sides of the storage reservoirs 222A and 222B respectively. The inner structure for the storage reservoirs 220A and 222B are explained below, in which the first storage reservoir 222A and the second storage reservoir 222B are collectively referred to as a storage reservoir 222 unless otherwise specified and shown by an identical reference numeral for simplifying the explanation. The storage reservoir 222 contains a stored solution 223 at the bottom and has a wire passing space 225 constituted thereabove at the inside thereof. The stored liquid 223 is a solution of a heat resistant polyurethane resin as the starting material for constituting the first intermediate layer 216 in the first storage reservoir 222, while the solution 223 is that of a fluoro-resin constituting the second intermediate layer 216B in the second storage reservoir 222. Further, heating means 224 are disposed at the periphery of the storage reservoir 222 (by means of heaters, etc.) for maintaining the molten state of the stored solution 223.

At the inside of the storage reservoir 222, there are disposed a plurality of pulleys rotatable in the vertical plain along the sending direction of the wire 207 that passes in the reservoir within the wire passing space 225. The pulley 226 is disposed such that the lowermost portion thereof is always immersed in the stored solution 223 and a wire 207 (metal wire 217) as an object to be coated is laid under the uppermost portion thereof. In this example, the pulley 226 is made rotatable around a journal portion 227, so that the pulley 226 is also rotated interlocking with the axial movement of the wire 207 that passes through the storage reservoir 222.

Accordingly, upon rotation of the pulley 226, a portion of the pulley 226 immersed in the stored solution 223 is rotationally moved to the wire passing space 225 above while carrying a predetermined amount of the stored solution 223 on the surface of the pulley and, further, brought into contact with the wire 207. In this case, the stored solution 223 at the surface of the pulley is coated to the periphery of the wire 207. The baking device 221 disposed on the side of the storage reservoir 222 incorporates a heating source, for

example, an infrared lamp or cartridge heater, so that the stored solution 223 deposited to the periphery of the wire 207 in the storage reservoir 222 is heated and cured to a predetermined state. In this way, the stored solution 223 can be formed to the periphery of the metal wire 227 and baked to form the intermediate layer 216 by merely moving the wire 207 in the axial direction in this example. In this example, since the first storage reservoir 222 and the second storage reservoir 222 are disposed continuously, the intermediate layer 216 of the dual layer structure comprising the first intermediate layer 216A and the second intermediate layer 216B can be formed extremely effectively.

Although the first storage reservoir 222 and the second storage reservoir 222 are illustrated and explained in the foregoings such that each of them has a single reservoir structure, if a predetermined layer thickness can not be obtained only by using them, the layer thickness can also be increased by dividing the inside of the storage reservoir 222 into a plurality of divisional reservoir sections, continuously disposing a plurality of pulleys 226 in the axial direction of the wire 207 and coating an identical stored solution 223 for a plurality of times.

Then, the wire bonding step by using the wire 207 obtained by way of the intermediate forming apparatus 220 is to be explained.

The wire bonding apparatus 230 used for the wire bonding step comprises, as shown in Fig. 38(a), an X-Y stage 232 on which a bonding head 231 as a driving mechanism is mounted, a bonding stage 223 on which the lead frame 208 is mounted and a control section 234 for controlling the operations of them.

The control section 234 is adapted to conduct overall control for the wire bonding apparatus 230 constituted, for example, with a microprocessor or a microcomputor system comprising a memory as a system capable of conducting bonding operation in accordance with the operation conditions set by an operator.

The bonding stage 233 has a heating source such as a heater, so that the lead frame 208 mounted on the bonding stage 233 is heated to a predetermined temperature condition.

On the other hand, a vertically movable block 235 is disposed elevatably along a guide shaft 236 disposed vertically to the X-Y stage 232 at the inside of the bonding head 231 on the X-Y stage 232, and a ball screw mechanism 238 for translating the rotation of a servo-motor 237 secured to the bonding head 231 into a linear vertical movement is disposed on the side of the movable block 235. Accordingly, the movable block 235 is made vertically movable by a predetermined amount along with the rotation of the servo-motor 237.

The movable block 235 has a bonding arm 240 rotatable within a vertical plain around a rotational axis and so constituted that the rear end of the bonding arm 240 is biased resiliently upward in Fig. 38 by resilient means 241 such as a spring secured to the movable block 235 and a counter clockwise resilient force is exerted to the bonding arm 240 along with the operation of the movable block 235. The resilient means 241 is so constituted that when the bonding tool 243 is abutted against the external terminal 215 of the semiconductor chip 204, unnecessary pressing for the external terminal 215 can be prevented so as to prevent the damages and destruction of them.

Also, a supersonic oscillator 242 is disposed to the rear end of the bonding arm 240 so that a predetermined supersonic energy can be transmitted to the bonding arm 240. In this example, operation of the supersonic oscillator 242 is controlled by the control section 234.

A bonding tool 243 is disposed being suspended vertically and downwardly to the top end of the bonding arm 240, to which the supersonic energy is transmitted. A wire 207 supplied from a wire spool 244 by way of an air back tensioner 245, a sprocket 246 and a clamper 247 is inserted through the bonding tool 243 with the top end thereof being protruded slightly.

There is a bonding space 251 at the top end of the bonding tool 243 partitioned by a cover 250 interlocking with an electric torch 248, and a fluid blowing nozzle 252 is protruded into the bonding space 251. The fluid blowing nozzle 252 is connected with a fluid source so that a cooling fluid 253 such as nitrogen gas or ionized gas can be supplied to the bonding space 251.

The electric torch 248 has a suction port 254 formed at the torch surface thereof and the suction port 254 is connected with a suction tube 255 for supporting the electric porch 248. The suction tube 255 is further supported by a support member 256 and the support member 256 is made rotatable by a rod 258 protruded from a driving source 257 comprising an electromagnetic solenoid and a crank shaft 260, so that the cover 250 and the electric torch 248 can be arranged at the top end of the bonding tool 243 only when required upon wire bonding.

In the constitution of the apparatus described above, when the X-Y stage 232 is actuated in a state where the lead frame 208 is positioned on the bonding stage 233, the bonding head 231 is moved horizontally by a predetermined amount, and the bonding tool 243 is situated at a predetermined position just above the semiconductor chip 204.

The driving source 257 is actuated in this state and the suction tube 255 is displaced to a state where the top end of the bonding tool 243 is covered with the cover 250.

Then, when a high negative voltage of about -1,000 to -3,000 (V) is applied to the electric torch 248, arc discharge is generated between the electric torch 248 and the wire 207, by which the top end of the wire 207 (metal wire 217) is melted to form a spherical metal ball 218 (refer to Fig. 38b). In this case, the intermediate layer 216 formed around the wire 207 is melted upwardly from the top end of the wire 207 by the heat of the arc discharge, by which the portion of the intermediate layer 216 is removed and the surface of the metal wire 217 is exposed.

It is desirable that the metal ball 218 is formed in a period of time as short as possible. Further, by forming the metal ball 218 by means of high energy (high current, high voltage) the amount of upward melting of the intermediate layer 216 can also be suppressed. Such a state can be attained by stabilizing the arc discharge. In this regard, arc discharge can be stabilized by setting and maintaining the reference potential (GND = 0 (V)) for the metal wire 217 of the wire 207 on one side while setting a negative voltage of about -1,000 to -3,000 (V) to the electric torch 248 as described above.

Further, when the metal ball 218 is formed, a cooling fluid 253 is supplied through the fluid blowing nozzle 252 to a bonding space 251 surrounded by a cover 250. The cooling fluid 253 is blown to the wire 207 in the bonding space 251, by which the intermediate layer 216 melted upwardly at the periphery of the metal wire 217 is scattered, and the scattered intermediate layer 216 is removed out of the system by way of the suction port 254 of the electric torch 248 and the suction tube 255. The cooling fluid 253 from the fluid blowing nozzle 252 is cooled by a cooling device, for example, to about -10 to 0 °C. As the temperature of the cooling fluid 253 from the fluid blowing nozzle 252 is lower, the upward melting amount of the intermediate layer 216 of the wire 207 is decreased. That is, since the wire 207, the metal wire 217, the intermediate layer 216, the bonding tool 243, etc. can be cooled posi tively by the cooling fluid 253, the intermediate layer 216 can be melted only in the arc-discharged portion with no effect on other portion of the intermediate layer 216 (without excessively increasing the upward melting amount).

After the metal ball 218 has been formed as described above, the driving source 257 is again actuated to rotate the suction tube 255, and the cover 250 is retracted from the periphery of the bonding tool 243 and the top end of the bonding tool 243 is left open.

In this state, when the servo-motor 237 for the bonding head 231 is actuated by a predetermined amount and the ball screw mechanism 238 is moved downwardly, the bonding tool 243 is landed on the surface of a predetermined external terminal 215 on the semiconductor chip 204 (refer to Fig. 34).

When the supersonic oscillator 242 is actuated under the control from the control section 234 in the landed state, the supersonic energy is transmitted by way of the bonding arm 240 to the bonding tool 243.

In this case, the metal ball 218 is bonded to the external terminal 215 by the synergistic effect of the urging force from the movable block 235, the supersonic energy and heating from the bonding stage 233 (first bonding).

Then, when the servo-motor 237 is driven in the state where the supersonic energy is kept to be applied, the bonding tool 243 is lifted above the semiconductor chip 204. In this case, since the top end of the wire 207 (metal ball 218) is secured to the external terminal 215 as described above, the wire 207 is delivered by a predetermined amount along with the lifting of the bonding tool 243.

Successively, when the X-Y stage 232 is actuated, the bonding tool 243 moves horizontally along the path shown by the dotted chain in Fig 34. Also in this case, the wire 207 is delivered from the top end of the bonding tool 213. In this case, there may be a possibility that the wire 207 suffers from deformation such as bending in the bonding tool 243. However, since the supersonic energy is continuously applied to the bonding tool 243 upon delivery of the wire 207, the deformation of the wire 207 in the bonding tool 243 is prevented. Further, since continuous application of the supersonic energy can make the delivery of the wire 207 smooth, damage, disconnection, etc. of the wire 207 caused by the blocking of the wire 207 upon delivery can also be prevented.

Then, when the bonding tool 243 is lowered along the direction of Z-axis by the actuation of the servo-motor 237, the top end of the bonding tool 243 is landed on the surface at the inner end of the lead 206 (inner lead) with the wire 207 being led out. The lower portion of the wire 207 is brought into contact with the surface at the inner end of the lead 206 in a vibrated state by means of the supersonic energy under continuous application, by which a portion of the intermediate layer 216 is destroyed and removed. Subsequently, as the supersonic energy is applied continuously, the metal wire 217 exposed as described above and the surface at the inner end of the lead 206 are bonded (second bonding).

Subsequently, unnecessary excess portion of the wire 207 is cut off and one cycle step of wire bonding is thus completed.

Then, explanation is made to the resin molding step for the lead frame 218, for which wire bonding has

thus been completed, in conjuction with an apparatus used therefor.

As shown in Fig. 39, a resin molding apparatus 261 used in this example comprise a top force 263 held to an upper fixing platen 262 and a bottom force 265 supported on a lower movable platen 264. Molds 266 shown in Fig. 40 are respectively disposed to the top force 263 and the bottom force 265 with their parting face being opposed to each other, the details thereof being described later.

The fixing platen 262 is supported above the stage by a plurality of support posts 268 disposed vertically from a substrate 267, and a transfer cylinder 284 to which starting material for the resin 205 is charged in the state of a tablet 283 is disposed above the fixing platen 262. The trasfer cylinder 284 is in communication with a pot 285 disposed to the inside of the top force 263 and has such a structure capable of pressing a plunger. A platen driving cylinder 288 is disposed below the substrate 267 for vertically moving the movable platen 264 and the platen driving cylinder 288 is controlled by a control section 269 disposed on the side of the stage.

The mold 266 shown in Fig. 40 is made, for example, of metal material such as dice steel capable of withstanding a molding temperature of about 180 °C and a plurality of culls 270 corresponding to the pot 265 are disposed on the parting face. As can be seen from the figure, the resin molding apparatus 261 in this example is a so-called multi-pot system having a plurality of pots 265. Each of the culls 270 has a grooved runner 271 at the parting face and the top end of the runner 271 is in communication with the runner 271 of each of chaise units 272 detacheably mounted respectively.

The chaise unit 272 has a plurality of cavities 274 each connected by way of the runner 271 to the gate 273 in communication therewith and, when the lead frame 208 is placed as a molded object on the cavity 274, resin molding can be applied over a predetermined range.

Then, the ingredient of the resin 205 as the starting material for the package used in this example is explained.

The resin 205 is made of an epoxy resin composition, which comprises a usual epoxy resin such as cresol-novolak type epoxy resin, phenol-novolak type epoxy resin, bisphenol A epoxy resin, etc. as the main ingredient and, blended therewith, filler and additive as described below. As the additive, there can be mentioned phenol-novolak resin as a curing agent for cross linking cure, a tertiary amine as a curing promotor for promoting the cure, Br-containing epoxy as a flame retardant for making the resin 205 flame proof, an epoxy silane as a coupling agent for improving the close bondability between the resin 205 and the filler, stearic acid or wax as a releasing agent for facilitating the removal from the mold 266 after curing, carbon black as a pigment, etc.

The addition amount of the releasing agent is from 0.3 to 0.8 % by weight, desirably, as much as 0.4 to 0.6 % by weight in the state of a tablet. Even if the amount of the releasing agent is increased, since the bondability between the coated lead and the resin is satisfactory, molding yield can be improved without reducing moisture proofness.

In this example, molten quartz powder is contained in the filler. Such molten quartz powder is of a spherical shape in which more than 90 % of the filler is within a range of the grain size of less than 100 µm and slope n in the grain size distribution expressed by a RRS grain size diagram shows a linearity within a range from 0.6 to 1.5. The molten quartz powder is blended by from 65 to 75 % by weight based on the entire resin.

The RRS grain size distribution indicates a grain size diagram representing the grain size distribution in accordance with the following Rosin-Rammler's equation:

$R (Dp) = 100 \exp (-b = Dp^n)$

where R (Dp) represents accumulated percent by weight (%) from the maximum grain size Dp to the grain size $D_p$, Dp represents the grain size and b and n are constants.

In the above equation, R (Dp) is also referred to as the accumulated residual weight percent (%).

The slope in the RRS grain size diagram means the value n in the Rosin-Rammlar's equation typically expressed by a straight line connecting two points in which the accumulated weight percent up to the maximum grain size lies at least within the range of between 25 and 75 % by weight. Generally, when the raw material for the filler is finely grounded, the grain size distribution agrees with the Rosin-Rammlar's equation, which is said to show a substantial linearity in the RRS grain size diagram, that represents the grain size distribution based on the above- mentioned equation.

The spherical molten quartz powder having such a grain size distribution can be obtained, for example, as shown in Japanese Patent Laid Open Publication No. Sho 59-59737, by supplying rugged molten quartz powder pulverized previously to a predetermined grain size distribution each by a predetermined amount into flame at high temperature generated from a flame-spraying apparatus using propane, butane, hydrogen, etc. as a fuel and melting and cooling them.

When the spherical molten quartz powder, in which 90 % by weight or more is within a range of the

grain size of less than 100 µm, and the slope n shows a linearity within a range from 0.6 to 1.5 if the grain size distribution is expressed by the RRS grain size diagrams is blended as a filler to the epoxy resin in an amount from 65 to 75 % by weight based on the entire amount of the resin, the heat expansion coefficient of the resin 205 thus prepared can be restricted to less than 10 x $10^{-6}$/° C.

It will be understood easily that the heat expansion coefficient can generally be restricted to the above-mentioned value by increasing the blending amount of the filler in the entire resin. Fig. 41 illustrates a relationship between the heat expansion coefficient of the resin 205 and the blending amount of the filler. It can be seen also from the figure that the heat expansion coefficient of the entire resin can be restricted by increasing the blending amount of the filler. According to the figure, for restricting the heat expansion coefficient of the resin 205 to 10 x $10^{-6}$/° C, the blending amount of the filler has to be about 75 % by weight.

However, according to Fig. 42 illustrating a relationship between the melt viscosity of the resin 205 and the blending amount of the filler, the melt viscosity of the resin 205, is relatively as high as 10,000 (poise) in a case where the resin 205 has expansion coefficient of 10 x $10^{-6}$/° C. In a case where the resin molding step is conducted at such a high viscosity, flow (deformation) of the bonded wire 207 occurs due to the resin viscosity, thereby causing bonding failure such as wire short-circuit, tab touch short-circuit, chip touch short-circuit, etc. Fig. 43 shows a relationship between the wire short-circuit rate and the blending amount of the filler. The figure shows a high wire short- circuit rate of 5 % if the blending amount of the filler is 75 % by weight in a case where a conventional wire 207 only composed of the metal wire 217 is used.

However, in the wire 207 having the intermediate layer 216 in this example, the wire short-circuit rate is substantially zero within a range for the blending amount of the filler from 60 to 75 % by weight, and it can be seen that the heat expansion coefficient of the resin 205 can be restricted only when the structure of the wire 207 having the intermediate layer 216 is employed.

That is, since the intermediate layer 216 is disposed around the metal wire 219 in this example, if the wire 207 is brought into contact with other wire, the tab 202 or the semiconductor chip 204, electric insulation can be maintained by the intermediate layer 216. Accordingly, even if the flow of wire is caused more or less, electric short-circuit can surely be prevented. Accordingly, a package structure in which the heat expansion coefficient is substantially equal with that of the semiconductor chip 204, tab 202 and lead 206 can be attained, by which defoliation at the resin boundary due to the difference in the heat expansion coefficient, that is, crack in the resin 205 can effectively be prevented.

The molten quartz powder used for the filler is made spherical, for reducing the apparent volume as the filler to attain high packing density and for preventing the damage to the chip surface due to the contact of the corner to the chip surface. The molten quartz powder is used because the molten quartz is easily available and the heat expansion coefficient is relatively small, which is effective for reducing the heat expansion coefficient of the entire resin 205. Furthermore, since the molten quartz contains extremely low ionic impurities, it can prevent the contamination to the chip surface and gives less effects on the characteristics of the device.

The resin 205 is kneaded in a 2-shaft roll or an extruder heated a temperature from 70 to 100° C into a semi-molten tablet 263 and then charged into the resin molding apparatus 261.

Then, heaters incorporated in the top force 263 and the bottom force 265 are actuated to heat the mold 266 to a predetermined temperature of about 180° C. In this state, when the lead frame 208 as the molded object is placed while being positioned between the top force 263 and the bottom force 265, the platen driving cylinder 268 is actuated under the control of the control section 269, by which the movable platen 264 is lifted to close the top force 263 and the bottom force 265.

In a state where both of the forces 263 and 265 are closed, the mold clamping force is controlled, for example, to about 150 (ton).

Then, when the transfer cylinder 264 is actuated and when a transfer pressure of about 75 ($Kgf/cm^2$) is applied to the tablet 263, the tablet 263 is injected under a high pressure from the cull 270 through the runner 271 and the gate 273 into the cavity 274 in a molten resin state by the synergistic effect with the heating as described above.

In this case, the blending amount of the filler in the molten resin, i.e. the resin 205 is increased to 75 % by weight in this example in order to attain the heat expansion coefficient of 10 x $10^{-6}$/° C as explained above (refer to Fig. 41). Along with the increase, the viscosity is also increased to a high value of greater than 10,000 poise. In a case if the resin 205 at such a high viscosity is used for the injection into the cavity 274, there is a possibility of causing clogging in the runner 271 and the flow of the wire due to the resin 205. For the former problem, a multi-pot system is employed in this example to shorten the path of the runner 271 from the cull 270 to the cavity 274 and, in addition, since the resin 205 is injected from a plurality of pots 265 (resin supply sources) to each cavity 274, the transfer pressure in each of the plungers

can effectively be transmitted to the resin 205.

For the latter problem, since a wire structure comprising the intermediate layer 216 of the dual layer structure made of an insulative resin is used in this example, even if the wire flow is caused more or less, or the wire 207 is brought into contact with the tab 202 or the semiconductor chip 204, electric short-circuit can effectively be prevented. As described above, since the structure of disposing the insulative intermediate layer 216 around the metal wire 217 is employed in this example, wire bonding can be conducted with no worry for the contact between each of the wires 207 or between the wire 207 and the tab 202, the semiconductor chip 204, etc. Accordingly, complicate wire bonding such as a cross bonding as shown in Fig. 33a or bonding overriding the tab-suspending lead 210 as shown in Fig. 33b, which has been difficult so far in the prior art metal wire 217 (not-covered wire), is also made possible to enhance the improvement in the performance and high integration degree in the semiconductor device 201.

The lead frame 208 formed with the package by means of the resin 205 as described above is cooled for the resin 205 to a predetermined temperature in the mold 266 and then taken out of the mold 266 after curing of the resin 205.

In the thus obtained package of the semiconductor device 201, the heat expansion coefficient is restricted to 10 x $10^{-6}/^{\circ}$ C, which is substantially equal with the heat expansion coefficient of the lead frame 208. Accordingly, development of crack caused by the difference of the heat expansion coefficient can effectively be prevented even in a case of undergoing heat cycle after the resin molding.

Table 3 shows the number of heat cycles till the crack failure reaches 10 % in the resin 205 used in this example and the resin 205 in the prior art. As can be seen from the table, since the heat expansion coefficient of the resin 205 is restricted to 10 x $10^{-6}$ in this example, the number of cycles with which the crack failure reaches 10 % was 300 cycles, whereas the crack failure reached 10 % only with 20 cycles in the case of using the resin 205 in the prior art, since the heat expansion coefficient is as large as 19 x $10^{-6}$ for instance.

In addition, since the crack is restricted as described above, penetration of water content attributable to the gap formed by the crack can also be suppressed. Fig. 44 shows a relationship between the penetration depth of water content into the package and the time upon practicing PCT (pressure-cooker-test) for the semiconductor device 201 obtained in this example and the semiconductor device by the prior art. According to this figure, the water content (fluorescent liquid) reaches as far as the semiconductor chip in about 300 hours in the semiconductor device of the prior art, whereas the penetration of water reaches only about one half of the distance from the external end of the package to the semiconductor chip 204 even after the elapse of 1,000 hours in the semiconductor device 201 of this example. In this way, this example also has a remarkable effect in view of the corrosion resistance.

On the other hand, Table 4 shows a comparison between the case of applying this example to a specific product: 4 mega bit DRAM (package structure: SOJ: Small Out-Line J-bend lead) and the case of constituting with the prior art, in which the number of ICs causing failures is shown in comparison with the total number of ICs. According to the table, failed ICs were observed in the prior art after the elapse of about 500 hours in the PCT (pressure cooker-test), whereas no failed ICs were detected even after the elapse of 1,000 hours in this example. In this way, moisture proof reliability is remarkably improved according to this example by the synergistic effect between the wire structure in which the intermediate layer 216 comprising the insulative resin and the package structure due to the resin 205 which is restricted regarding the heat expansion coefficient.

In addition, in the wire structure of this kind having the intermediate layer 216 comprising the insulative resin, there may be a worry that the close bondability between the intermediate layer 216 and the resin 205 is too high and the metal wire 217 at the inside of the intermediate layer 216 may be disconnected even with the miner change of the thermal stresses in the resin 205, particularly in a case where the wire 207 causes chip-touch. However, since the intermediate layer 216 in this example comprises a dual structure including the first intermediate layer 216A comprising a heat resistant polyimide resin and the second intermediate layer 216B comprising a fluoro resin of excellent releasability, property, the wire 207 does not follow after the deformation of the package and the disconnection can be prevented by the releasing effect of the second intermediate layer 216B even if a thermal stress is applied to the package.

Although the invention made by the present inventor has been explained specifically referring to examples, the present invention is not restricted only to the foregoing examples but various changes are possible within a range not departing the gist thereof.

For instance, although explanation has been made for the second intermediate layer 216B as it is constituted with a fluoro resin, other releasing agent such as silicon resin or silicon grease may also be used.

Advantageous effects obtained by typical inventions among those disclosed in this example are

explained simply as described below.

That is, in the resin constituting the package, development of crack caused by the difference of the heat expansion coefficient can effectively be prevented.

Further, disconnection of the wire caused by the thermal stresses in the package can effectively be prevented.

In view of the above, a resin molded semiconductor device of high reliability can be provided.

(3) Example 3

The constitution of a DIP type resin encapsulated semiconductor device as Example 3-I according to the present invention is shown in Fig. 45 (cross sectional view for a portion) and Fig. 46 (plan view partially in cross section). Fig. 45 is a cross sectional view for a portion taken along line I-I in the resin encapsulated semiconductor device shown in Fig. 46.

As shown in Figs. 45 and 46, in the DIP type resin encapsulated resin semiconductor device 301, an external terminal (bonding pad BP) 302 E and an inner lead 303B of a lead 303 are connected by means of a coated wire 305.

The semiconductor chip 302 comprises a DRAM (Dynamic Random Access Memory) using, as a memory cell, a serial circuit of a MOSFET for memory cell selection and an information accumulating capacitance element. In the semiconductor chip 302, a plurality of semiconductor elements including the memory cell are integrated on the main surface of a single crystal substrate 302A as shown in Fig. 45. Each of the semiconductor elements is defined for the shape with an inter-element isolation insulative film (field insulation film) 302B formed between each of the regions and electrically separated from each other.

Above the inter-element isolation insulative film 302B, there are successively laminated an interlayer insulation film 302C, an interlayer insulation film 302D, an external terminal 302E, a protection film (passivation film) 302F and a barrier metal film 302H.

The interlayer insulation film 302C is so constituted as to electrically separate a semiconductor element (for example, gate electrode or word line of MOSFET), and a first layer wiring for connecting semiconductor elements (for example, data line) with each other. The interlayer insulation film 302D is so constituted as to electrically separate the first layer wiring and the second layer wiring (for example, shunt wiring short-circuited with the word line). The second layer wiring constitutes the external terminal 302E.

A barrier metal film 302H is formed on the surface of the external terminal 302E. The barrier metal film 302H is brought into contact with the surface of the external terminal 302I through an opening 302G formed to the protection film 302F.

The thus constituted semiconductor chip 302 is mounted on the surface of a tab portion 303A of a lead 303 while intervaning the adhesive metal (for example, Au-Si eutectic alloy or Ag paste) 302. A lead 303 is made, for example, of Fe-Ni alloy (alloy, for example, containing 42 (%) nickel). A tab 303A is connected to the lead frame by way of the tab-suspending lead 303 in Fig. 46. The tab portion 303A is constituted as an elongate rectangular shape corresponding to the plan shape of the semiconductor chip 302, and the tab-suspending lead 303D supports each of the shorter sides of the tab portion 303A and is extended in the same direction as the longitudinal direction of the tab 303A.

A plurality of inner leads 303B are disposed on one side thereof to the periphery on the shorter side of the tab 303A of the lead 303. The inner leads 303B are electrically connected at the other end integrally with the outer leads 303C. The respective outer leads 303C are defined with functions respectively as shown in Fig. 46. That is, I/01-I/04 are outer leads 303C (pins) for input/output signals. $\overline{WE}$ is an outer lead 303C for write enable signal. $\overline{RAS}$ is an outer lead 303C for raw address strobe signal. $A_0$ - $A_8$ are outer leads 303C for address signal. OE is an outer lead 303C for output enable signal. $\overline{CAS}$ is an outer lead 303C for column address strobe signal.

Vcc is an outer lead 303C for power source voltage (for example, 5(V)). Vss is an outer lead 303C for difference voltage (for example, 0 (V)).

The coated wire 305 is formed by coating the surface of a metal wire 305A with an insulator 305B as shown in Fig. 45. Gold (Au) is used for the metal wire 305A in this example. The metal wire 305A may be made of other materials than above such as copper (Cu) or aluminum (Al). For the insulator 305B, a polyurethane resin or polyimide resin is used in this example. Further, the insulator 305B may be formed of other resin materials than the above such as an ester imide resin or ester amide resin.

The coated wire 305 is connected by way of a ball & wedge bonding method or wedge & wedge bonding method to the external terminal 302E. That is, a metal ball $305A_1$ formed with the metal wire 305A exposed by melting to remove the insulator 305B at one end of the coated wire 305 (top end on the side of

supplying the wire) to the external terminal 302E of the semiconductor chip 302. The metal ball $305A_1$ has a diameter which is larger, for example, by about 2 - 3 times of the diameter for the metal wire 305A of the coated wire 305. The metal ball $305A_1$ of the coated wire 305 is connected to the external terminal 302E by the hot-press bonding or by the combined use of the hot-press bonding with supersonic vibration (first bonding).

A metal wire $305A_2$ exposed by destructing the insulator 305B for the connection portion at the other end of the coated wire 305 (rear end opposite to the wire supplying side) is connected to the inner lead 303B of the lead 303). At the other end of the coated wire 305, only the portion of the insulator 305B connected with the inner lead 303B is substantially removed while leaving other portion of the insulator 305B as it is. The insulator 305B at the other end of the coated wire 305 is destroyed and connected with the inner lead 303 by means of hot-press bonding by bonding technique or by hot-press bonding by bonding technique used in combination with supersonic vibration (second bonding).

In this way, in the resin encapsulated semiconductor device 301 using the coated wire 305, since the surface of the metal wire 305A is covered with the insulator 305, it is possible to prevent short-circuit between the coated wires 305, between the coated wire 305 and the semiconductor chip 302, the tab 303A and the inner lead 303B respectively. As a result, electric reliability of the resin encapsulated semiconductor device 301 can be improved.

Further, in the resin encapsulated semiconductor device 301 using the coated wire 305, the metal ball $30A_1$ formed with the metal wire 305A at one end of the coated wire 305 is connected to the external terminal 302E of the semiconductor chip 302 and the metal wire $305A_2$ exposed by destructing the insulator 305 for the connection portion at the other end of the coated wire 305 is connected with the inner lead 303B. Accordingly, since the size of the metal ball $305A_1$ is large, it is possible to increase the area of contact between the metal ball $305A_1$ and the external terminal 302E thereby improving the bondability between both of them, as well as since the other end of the coated wire 305 for the portion other than that connected with other inner lead 303B is coated with the insulator 305B thereby enabling of prevent short-circuit due to the contact between the other end of the coated wire 305 and the other end of other coated wire 305 in adjacent therewith, the distance between the inner leads 303B can be reduced to provide a multi-terminal arrangement (multi-pin arrangement).

The semiconductor chip 302, the tab 303A, the inner lead 303B and the coated wire 305 are encapsulated with resin material 306 (for example, epoxy resin material). The resin material 306 is formed by injecting resin material from the direction of arrow G shown in Fig. 46 into a region defined with a mold (region corresponding to the outer circumferential shape of the resin material 306) and coagulating the same. The resin injection port (gate) of the mold is disposed on the side of the tab-suspending lead 303B in the right portion of Fig. 46.

The shape of the lead frame used in the resin encapsulated semiconductor device 301, that is, the respective shapes for the tab 303A, the inner lead 303B, the outer lead C and the tab-suspending lead 303D are formed by punching. The lead frame thus formed by the punching is used, while facing the surface on which burrs formed at the corner for each of the ends by the punching to downward and facing the surface on which sag formed at the corner for each of the ends by the punching to upward, as shown by dotted circles in Fig. 45. That is, the semiconductor chip 302 is mounted on the surface where the sags are formed at the corner by the punching of the tab 303A, while the coated wire 305 is connected on the surface where sags are formed at the corner of the inner lead 303B by the punching. In the sagged portion at each of the corner of the lead 303, the shape of the sharp corner is moderated just like that it is chamfered.

If the surface with the burrs at each of the corners of the lead 303 is used, short-circuit is caused between the tab portion 303A and the coated wire 305 in the resin encapsulated semiconductor device 301 as shown in Fig. 47 (enlarged cross sectional view for a part). That is, the thin insulator 305B of the coated wire 305 (about 1.0 µm in this example) is destroyed by the concentration of the stresses at the burrs due to the shrinking stresses of the resin material 306 and short-circuit is caused between the burrs at the corner of the tab portion 303A and the metal wire 305A of the coated wire 305.

Fig. 51 (illustrating a short-circuit rate between tab and wire) shows the short circuit rate (%) between the tab portion 303A and the coated wire 305 relative to the temperature cycle. As shown in Fig. 51, in a case if the surface with burrs at each of the corners of the lead 303 is used, the short-circuit rate is increased along with the increase of the temperature cycle. On the other hand, in a case of using the sagged surface at each of the corners of the lead 303, short-circuit is scarcely caused even if the temperature cycle is increased.

Further, in the case of using the surface with burrs at each of the corners of the lead 303, the coated wire 305 is disconnected in the resin encapsulated semiconductor device 301 as shown in Fig. 48 (enlarged

cross sectional view for a portion). Disconnection of the coated wire 305 is caused because of the stress concentration at the burrs due to the shrinking stresses of the resin material 306 in the same manner as described above.

Fig. 52 (illustrating the wire disconnection rate) shows the disconnection rate (%) of the coated wire 305 relative to the temperature cycle. As shown in Fig. 52, in a case of using the surface with burrs at each of the corners of the lead 303, the disconnection rate is increased along with the increase in the temperature cycle. On the other hand, in the case of using the surface formed with sags at each of the corners of the lead 303, disconnection is scarcely caused even if the temperature cycle is increased.

As described above, in the resin encapsulation semiconductor device 301 in which the external terminal 302 of the semiconductor chip mounted on the tab 303A and the inner lead 303B are connected by way of the coated wire 305 and the coated wire 305 and the connection portion of the connected wire 305 are covered with the resin material 306, since the shape is moderated at least for the corner of the tab portion 303A or the corner of the inner lead 303B on which the coated wire 305 is extended, thereby reducing the stress concentration due to the shrinkage of the resin material 306 to the portion of the coated wire 305 in contact with the corner of the tab 303A or the corner of the inner lead 303B, it is possible to prevent short-circuit between the tab 303A and the metal wire 305A of the coated wire 305 caused by the destruction of the insulator 305 or the disconnection of the coated wire 305. As a result, the electric reliability of the resin encapsulated semiconductor device 301 can be improved.

Further, as shown in Figs. 49 and 50 (enlarged cross sectional views for a portion), since the destruction of the insulator 305B or the desconnection of the coated wire 305 is caused also in a case where the coated wire 305 is brought into contact with the corner at the end of the semiconductor chip 302 in the resin encapsulated semiconductor device 301, the shape for the corner of the semiconductor chip 302 is moderated at the portion where the coated wire 305 is extended. That is, the resin encapsulated semiconductor device 301 is chamfered for the corner at the end of the semiconductor chip 302, specifically, for the corner of the scribing area at the peripheral portion of the semiconductor chip 302, so that the destruction of the insulator 305B of the coated wire 305 or the disconnection of the coated wire 305 can be prevented.

Further as shown in Fig. 45, the trace of the coated wire 305 may be controlled such that it is not in contact with the corner of the semiconductor chip 302, the corner of the tab 303A or the corner of the inner lead 303B, that is, the portion where burrs are protruded. The trace for the coated wire 305 is controlled by means of the position for arranging the external terminal 302E of the semiconductor chip 302, the height of the coated wire 305 above the external terminal 302E, the connection position between the inner lead 303B and the coated wire 305, etc.

As described above, in the resin encapsulated semiconductor device 301, since stresses due to the shrinkage of the resin material 306 are not concentrated to the coated wire 305 if the trace of the coated wire 305 is controlled such that it is not in contact with the corner of the semiconductor chip 302, the corner of the tab 303A or the corner of the inner lead 303B, it is possible to prevent short-circuit between the semiconductor chip 302 or the tab 303A and the metal wire 305A of the coated wire 305 due to the destruction of the insulator 306B or the disconnection of the coated wire 35. As a result, electric reliability of the resin encâpsulated semiconductor device 301 can be improved. Although the coated wire 305 causes no short-circuit, in principal, even if it is brought into contact with the semiconductor chip 302 and the tab 303A respectively, since the damage for the insulator 305B of the coated wire 305 or the disconnection of the coated wire 305 is actually caused as described above, the trace of the coated wire 305 is controlled for positively isolating it from the corner of the semiconductor chip 302 and the corner of the tab 303A in the present invention so that such failure can be prevented. Further, as shown in Fig. 53 (enlarged cross sectional view for a portion), in the case of using the surface of the lead 303 from which the burrs are protruded, the sharp shape of the burrs is moderated (chamfered) as shown in Fig. 54 (enlarged cross sectional view for a portion). The shape can be moderated, for example, by applying pressing to the punched lead frame.

The present invention is also applicable in the same manner to a case where the lead frame is formed by etching. That is, the shape for each of the corners of the lead frame formed by the etching is moderated in the present invention.

Furthermore, a shape-moderating member may be disposed to each of the corners of the lead frame for moderating the shape of such portion in the present invention. The shape moderating member is formed, for example, by means of Ag or Au plating layer or resin film.

Example 3-II shows another embodiment of the present invention in which the development cost for the resin encapsulated semiconductor device is reduced. The method of forming the resin encapsulated semiconductor device in Example 3-II according to the present invention is shown in Figs. 55 and 56,

(schematic plan views illustrating each of the forming steps).

The resin encapsulated semiconductor device of this Example 3-II is formed as described below.

At first, as shown in Fig. 55, a semiconductor chip 302 is mounted on a tab 303A, and external terminals 302E and inner leads 303B are connected by means of coated wires 305. Then, a resin encapsulated semiconductor device 301 is formed by encapsulating the semiconductor chip 302, etc. with resin material 306. That is, in the resin encapsulated semiconductor device 301, the semiconductor chip 302 is encapsulated with a first package (including the lead 303 and the resin material 306).

Then, in a case where it is intended to use an identical semiconductor chip 302 (of identical function), but a board on which the resin encapsulated semiconductor device 1 is mounted or the arrangement for the terminals of external devices are different, a second package having an arrangement for leads 303 depending on the board and the arrangement for the terminals of the external devices, different from the first package, is developed and prepared. Then, as shown in Fig. 56, the identical semiconductor chip 302 with that of the resin encapsulated semiconductor device 301 described previously is mounted on the tab 303A of the second package and the external terminals 302E of the semiconductor chip 302 and the inner leads 303B are connected by way of the coated wires 305. If the coated wire 305 is in contact with other coated wire 305 in adjacent therewith or if it intersects the inner lead 303B or the tab-suspending lead 303B, it can be freely bonded since the wire does not cause short-circuit therewith. Then, the resin encapsulated semiconductor device 301A can be formed by encapsulating the semiconductor chip 302, etc. with the resin material 306. In the resin encapsulated semiconductor device 301A, the semiconductor chip 302 identical with that of the resin encapsulated semiconductor device 301 described previously is encapsulated within the second package different from the first package.

In this way, in the method of forming the resin encapsulated semiconductor device 301 using the coated wire 305, the semiconductor chip 302 is mounted on the tab portion 303A of the first package (chip mounting position), the external terminals 302E of the semiconductor chip 302 and the inner leads 303B are connected by way of the coated wires 305 to form the first resin encapsulated semiconductor device 301, while an identical semiconductor chip with the semiconductor chip 302 of the first resin encapsulated semiconductor device 301 is mounted on the tab portion 303A of a second package, different from the first package for the first resin encapsulated semiconductor device 301, and the external terminal, 302 of the semiconductor chip 302 and the inner leads 303B are connected by way of the coated wires 305 to form the second resin encapsulated semiconductor device 301a, whereby the external terminals 302E of the semiconductor chip 302 and the inner leads 303B can be connected by way of the coated wires 305 while intersecting other inner leads 303B and the external terminals 302E of the semiconductor chip 302 and the inner leads 303B can be connected by intersecting the coated wires 305. Accordingly, a plurality kind of resin encapsulated semiconductor devices 301 and 301A can be formed respectively by using identical semiconductor chips 302 (standardization of the semiconductor chip 302) and using different kind of packages. As a result, since the development cost for the package is less expensive as compared with that for the semiconductor chip 302, a plurality kind of resin encapsulated semiconductor devices 301 and 301A can be formed at a reduced developing cost. For instance, various resin encapsulated semiconductor devices 301 such as pin-insertion type, for example, DIP or ZIP type or plain mounting type, for example, SOJ, SOP, QFP or PLCC type can be formed by using only one identical kind of semiconductor chip 302 at a reduced developing cost in the present invention.

The resin encapsulated semiconductor device in this Example 3-II is formed as described below.

At first, as shown in Fig. 55, the semiconductor chip 302 is mounted on the tab 303A of the lead 303 and the external terminals 302B of the semiconductor chip 302 and the inner leads 303B are connected by way of the coated wires 305. The tab portion 303A is made somewhat larger as compared with the usual tab size, so that a plurality kind of semiconductor chips 302 can be mounted. Then, by encapsulating the semiconductor chip 302, etc. with the resin material 306, resin encapsulated semiconductor device 301 is formed. That is, in the resin encapsulated semiconductor device 301, the first semiconductor chip 302 is mounted on the tab portion 303A of the lead 303 and encapsulated with the resin material 306.

Then, as shown in Fig. 56, by using an identical lead (lead frame) 303 as that for the resin encapsulated semiconductor device 301 described above, the semiconductor chip 302′ of the kind different from the semiconductor chip 302 (a semiconductor chip, for example, of identical function but of different arrangement for the external terminals 302E) is mounted on the tab portion 303A, and the external terminals 302E of the semiconductor chip 302′ and the inner leads 303B are connected by way of the coated wires 305. Even if the coated wire 305 is in contact with other coated wire 305 in adjacent therewith or if the wire intersects the inner lead 303B or the tab-suspending lead 303D, it does not cause short-circuit therewith, and it can be bonded as desired. Then, by encapsulating the semiconductor chip 302′ with the resin material 306, a resin encapsulated semiconductor device 301A can be formed. In the resin encapsulated

semiconductor device 301A, the semiconductor chip 302′ of the kind different from the semiconductor chip 302 is mounted on the tab portion 303A of the identical lead 303 with that of the resin encapsulated semiconductor device 301 described previously and encapsulated with the resin material 306.

In the method of forming the resin encapsulated semiconductor device 301 using the coated wire 305, the first semiconductor chip 302 is mounted on the tab portion 300A of the lead 303 (chip mounting position), the external terminals 302E of the first semiconductor chip 302 and the inner leads 303B are connected by way of the coated wires 305 and then encapsulated with the resin material 306 to form the first resin encapsulated semiconductor device 301, while the second semiconductor chip 302′ of a kind different from the first semiconductor chip 302 of the first resin encapsulated resin semiconductor device 301 is mounted on the tab portion 303A of the identical lead 303 with that of the first resin encapsulated semiconductor device 301, the external terminals 302E of the second semiconductor chip 302′ and the inner leads 303B are connected by way of the coated wires 305 and the encapsulated with the resin material 306 to form the second resin encapsulated semiconductor device 301A, whereby the external terminals 302E of the semiconductor chip 302′ and the inner leads 303B can be connected by way of the coated wires 305 while intersecting other inner leads 303B, and the external terminals 302E of the semiconductor chip 302′ and the inner leads 303B can be connected while intersecting the coated wires 305, a plurality kinds of resin encapsulated semiconductor devices 301 and 301A can be formed respectively by using an identical type of lead (lead frame) 303 (standardization of lead frame) and using different kinds of semiconductor chips 302 and 302′. As a result, since there is no more required to develop the lead 302 on every development for the respective semiconductor chips 302 and 302′, it is possible to form a plurality kinds of resin encapsulated semiconductor devices 301 and 301a at a reduced developing cost. For instance, according to the present invention, a semiconductor chip 302′ mounted on an SOJ type resin encapsulated semiconductor device 301 (for example, having an identical function and identical number of external terminals 302 but of different arrangement for the position of the external terminals 302E) is mounted on a DIP type resin encapsulated semiconductor device 301 instead of a semiconductor chip 302 mounted on the DIP type resin encapsulated semiconductor device 301, thereby forming the DIP resin encapsulated semiconductor device 301A in which the semiconductor chip 302′ is mounted.

Although the inventions made by the present inventor has been explained specifically referring to the example, the present invention is not restricted only to the foregoing example but various modifications and changes are of course possible within the scope not departing the gist of the invention.

For instance, the present invention is also applicable to such a semiconductor device in which a plurality of semiconductor chips are mounted on the surface of a wiring substrate, respective terminals of the wiring substrate and external terminals of the semiconductor chip are connected by way of the coated wire by using ball & wedge bonding method or wedge & wedge bonding method, and at least the coated wire and the connection portion thereof are covered with a resin. The resin used in the semiconductor device is, for example, a polyimide type resin, which is coated by means of potting.

Further, the present invention is also applicable to a ceramic encapsulated semiconductor device in which external terminals of a semiconductor chip and a lead are connected by way of coated wires and at least the coated wires and the connection portions thereof are covered with a resin and further encapsulated with ceramic material.

Advantageous effects obtained by typical inventions among those disclosed in this example are briefly explained as below.

In a semiconductor device using coated wires, damages to the insulator for the coated wires or the disconnection of the coated wires can be prevented to improve the electric reliability.

Further, in a semiconductor device using the coated wires, the developing cost for the semiconductor device of an identical function with a plurality of kind of packages can be reduced.

Furthermore, in a semiconductor device using the coated wires, the development cost for a plurality kind of semiconductor devices on which semiconductor chips of different functions are mounted can be reduced.

(4) Example 4

This example concerns details or modifications for the chamfering at the periphery of the upper main surface of a chip shown in the previous Example 3 which constitutes a portion of a semiconductor integrated circuit device shown in other preceding examples and examples to be explained subsequently.

This example is explained referring to Figs. 57 through 60.

Fig. 57 is a cross sectional view for a wafer after completing the dicing step by semi-full cutting

system. In the figure, are shown a cutting groove 401 formed by a main blade, a bevelled portion 402 formed by chamfering blade, a device main surface 403 of a pellet, an Si wafer substrate 404, an uncut portion 405 left after the cutting, an adhesive layer 406 and a resin sheet 407.

Referring to the dimension, etc. for each of the portions, they are: 5-20 μm for a, 5 - 20 μm b, 20 - 100 μm for c, 200 - 400 μm for d and 5 - 20 μm for e, and 20° - 45° for θ.

Fig. 58 is a schematic cross sectional view for a portion illustrating the process for bevel chamfering dicing. In the figure, are shown a primary vertical cut groove 401A formed by the main blade, a vertical cut groove 401B formed by further applying bevel cutting, a chamfered portion 402 at the periphery of the chip formed by the bevelling blade (auxiliary blade), an Si wafer substrate 404, an uncut portion 405 left after cutting, an adhesive layer 406, a sheet 407, a main spindle 408a, an auxiliary spindle 408B, a main rotational blade 409A and an auxiliary rotational blade 409B.

Fig. 59 is a cross sectional view illustrating the state in which the wafer is appended on a frame by way of the resin sheet upon dicing. In the figure, there are shown an Si wafer 404 which is adhered with the device main surface being upward, a resin sheet 407 having the adhesive layer formed at the upper surface thereof and a circular frame 410 made of metal or resin (rigid).

Fig. 60 is an upper plan view illustrating the device main surface of the wafer. In the figure, there are shown an Si wafer 404, an orientation flat 411, longitudinal scribe lines $A_1$ - $A_5$ to be cut by the blade, that is, avenues and lateral scribe lines $S_1$ - $S_7$, that is, streets.

The dicing process according to present invention is to be explained referring to Figs. 57 through 60.

As shown in Fig. 59, the wafer 404 after completing an electrical test (wafer test by means of a probe) at the stage of wafer is secured with the device surface being upward to the frame 410 by way of the adhesive sheet 407.

Then, in this secured state, the lower surface is fixed by vacuum adsorption on an adsorption stage of a dicer (for example, dual dicer DFD-3D/8, manufactured by Disco Co.). Further, under this state, each of the avenues is successively cut by a rotary blade and, thereafter, the stage is rotated by 90 degree and then each of the streets is cut in the same manner by the rotary blade as shown in Fig. 60. In this case, as shown in Fig. 58, the main blade 409a and the auxiliary blade 409b conduct cutting while being displaced by one block from each other so that the auxiliary blade follows after the main blade. The cutting is conducted by a so-called semi-full cutting method to leave an uncut portion of about several micron meters after the cutting.

The wafer after completing the cutting is transferred to a die bonding step while being fixed to the frame 410. In the die bonding, the aimed chip is lifted from below the sheet 407 by a lifting pin and then transferred by an adsorption collet approaching from above the die pad of the lead frame and then applied with die bonding.

(5) Example 5

In this example, a bonding process as details or modifications for the partial step in each of the foregoing examples is to be explained.

Fig 61 is a schematic view partially in cross section illustrating a portion of a coated wire bonding device according to this invention. In the figure, there are shown a ball 501 having a diameter of about 70 to 90 μm formed by aparted arc discharge, a coating removed portion 502 from which the resin coating is melted upwardly (20 -200 μm) by the heat upon forming the ball, a gas nozzle 503 for supplying a ball-forming atmosphere, a discharge electrode 504 integrated therewith, a core material 505a for the bonding wire, that is, a metal core, a coating layer 505b therefor, a capillary 506 (bonding tool) for thermosonic ball bonding (ball-wedge type) which can be applied with vertical pressure and applied with supersonic vibrations in the horizontal direction (in the direction of extending the bonding arm) There are also shown gas nozzles 507a and 507b for preventing upward melting, a successive of lead frame 508, integrated circuit chips 509a - 509f die-bonded respectively on the die pads of the lead frame (in which wire bonding has been completed to the chip 509a), a heat block 510 for heating the lead and the chip, a tube 511 opened on both sides so as to pass the lead frame therethrough, an opening 512 formed on the upper portion of the tube for the wire bonding, a gas stream 521 for preventing upward melting, a ball-forming atmospheric gas 522 for shielding the ball portion upon forming the ball and subsequent annealing, lead gas atmosphere streams 523a -523d for preventing oxidation of the lead frame, etc. and transferring direction 524 for the lead frame.

Tables 5 and 6 show various conditions upon bonding shown in Fig. 61.

Concrete process for the wire bonding is to be explained referring to Fig. 61 and Tables 5 and 6.

At first, in a state where the distance between the top end of the wire and the discharge electrode 504 is kept constant while grounding the terminal end of the wire on the side of the spool to the earth, a pulse voltage is applied so that the side of the wire constitutes a positive electrode Then, arc discharge is generated between the top end of the wire and the electrode 504, by which the ball 501 is formed by the heat of the discharge and the coating at the top end of the wire is melted upwardly. In this case, the ball atmospheric gas 522 is blown from the side of the wire before and after the formation of the ball for preventing the oxidation thereof. On the other hand, the cooling gas 521 is supplied from above to the wire neck portion just above the ball for preventing excess upward melting of the coating during formation of the ball and till the upward melting of the coating is stopped.

The ball cooled gradually from the ball temperature during electric discharge (higher than 1,000°C) to about 300 - 200°C in the ball-forming gas 522 is supplied to the wire bonding. When the formation of the ball has been completed, the electrode 504 is retracted, and the capillary 506 is lowered and intrudes through the opening 512 to the inside of the tube 511 to conduct first bonding (nail-head bonding to the A1 pad on the chip 509b by thermosonic bonding). Successively, the capillary 506 moves while deliverying the wire 505 to the second bonding point on the corresponding lead. At this point, wedge bonding is applied while destructing the coating. In the course of the step, the inside of the tube is filled with the lead atmospheric gas.

The bonding cycle for one wire described above is conducted within a time of about 0.1 to 0.3 sec. By repeating the foregoing cycle, bonding is conducted to all of the wires.

(6) Example 6

This example shows details or modification for a portion of the structure or the step in the preceding examples.

Fig. 62 is a cross sectional view for a portion of a face mounted resin package in the present invention. In the figure, there are shown an Si substrate 602a (200 to 400 µm thickness) a final passivation film 602b comprising $SiO_2$ (1 µm thickness), an Al bonding pad 602c (1 µm thickness; 100 µm x 100 µm square), interlayer insulation films 602d and 602e comprising PSG, etc. (0.5 to 1.5 µm thickness), a field $SiO_2$ film 602f formed by LOCOS oxidation (selective oxidation with SiN) (0.3 to 1 µm thickness), lead frames 603a - 603c patterned from a metal sheet, in which 603a is a die pad portion, 603b is an inner lead portion and 603c is an outer lead portion, an adhesive layer 604 for die bonding made of Ag paste, etc. a bonding wire core material 605a, a coating 605d thereof, a low stress resin material 606b shown in the previous example, a spot plated portion 607 for the lead inner end and a chamfered portion 608 at the chip end.

Table 7 shows materials for each of the portions in the specific embodiment of these resin encapsulated devices, which are corresponded to those in Tables 5 and 6.

It will be apparent to those skilled in the art that the various embodiments as particularly described above may provide one or more of the following:

techniques for manufacturing a semiconductor device by using a coated wire, with less risk of short-circuit, chip short-circuit or inter-wire short-circuit due to the destruction of layer caused by the thermal degradation of the coating layer;

techniques for manufacturing a semiconductor device by using a coated wire, capable of ensuring the bondability of the coated wire, particularly, the bonding strength between the coated wire and the lead; and without the techniques for manufacturing a semiconductor device by using a coated wire, capable of applying bonding with no bonding failure of usual wire bonding techniques; with improved techniques for manufacturing a semiconductor device by using a coated wire, capable of improving the reliability of the semiconductor device;

and

techniques for manufacturing a semiconductor device by using a coated wire, capable of providing a multiterminal arrangement in the semiconductor device.

It will also be apparent to those skilled in the art that the various embodiments as particularly described above may help prevent one or more of the following:

cracking in a package-constituting resin, at the interface with constituent members such as a semiconductor chip or lead;

disconnection of wires caused by thermal stresses to the package; and

destruction of the insulator for the wire or disconnection of the coated wire, thereby improving the electric reliability.

It will be further apparent to those skilled in the art, that the various embodiments as particularly described above may provide one or more of the following:
a technique in a semiconductor device using a coated wire, capable of reducing the development cost;
a resin encapsulated semiconductor device of excellent releasability from the mold;
a resin encapsulated semiconductor device suitable for face mounting;
a wafer dicing (pelletization) method suitable for bonding using a coated wire; and
to facilitate the manufacture of a resin encapsulated thin semiconductor device.

Table 1

| No. | P-1 | P-2 | P-3 |
|---|---|---|---|
| Terephthalic acid [(mol)g] | (2.0) 332 | (1.66) 276 | (1.54) 255 |
| *1 Imide acid | - | - | (0.08) 28.6 |
| Ethylene glycol | (2.35) 146 | (1.95) 121 | (1.90) 118 |
| Trimethylol propane | - | (0.58) 78 | (0.57) 76 |
| Glycerin | (0.7) 64.4 | - | - |
| Total | 542.4 | 475 | 477.6 |
| OH/COOH | 1.7 | 1.7 | 1.7 |
| Theoretical reaction water (g) | 36.0 | 29.9 | 29.2 |
| Reaction temperature (°C) | 170 ~ 240 | 170 ~ 240 | 170 ~ 240 |
| Reaction time (hr) | 6 | 6 | 7 |
| *2 OH value | 250 | 258 | 240 |
| Acid value | 4.0 | 3.2 | 4.5 |
| OH equivalent | 224 | 217 | 234 |

*1: Structural formula of imide acid

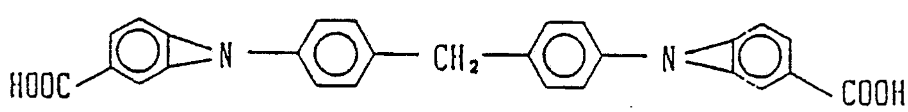

Mwt = 354

*2: OH value: measured by acetylation method according to JIS

Table 2

| | Bonding wire No. | #1 | #2 | #3 | #4 | #5 | #6 | (Reference) General purpose polyurethane | Not coated wire |
|---|---|---|---|---|---|---|---|---|---|
| Blending composition (solid component ratio) | [Blocked isocyanate resin] | | | | | | | | |
| | Millionate MS-50[part] | 250 | 250 | 250 | | | | 250 | |
| | Desmodule CT-St | | | | 260 | 260 | 260 | | |
| | [Polyol resin] | | | | | | | | |
| | P - 1 | 224 | | | 224 | | | | |
| | P - 2 | | 217 | | | 217 | | | |
| | P - 3 | | | 234 | | | 234 | | |
| | Nipporan 2006 *1 | | | | | | | 147 | |
| | Zinc octenate (metal noble portion) | 0.95 | 0.93 | 0.97 | 0.97 | 0.95 | 0.99 | 0.79 | |
| Wire characteristics | [Characteristics of coated film] Thickness of coated layer[μm] | 1.1 | 1.1 | 1.0 | 1.0 | 1.0 | 1.0 | 1.0 | - |
| | Pin hole (one side) | 2 | 1 | 1 | 2 | 3 | 2 | 2 | - |
| | Withstand voltage (V) | 1070 | 1000 | 1050 | 1060 | 1035 | 1020 | 1010 | - |
| Film property | Heat resistant (residual rate) *2 | 80 | 85 | 93 | 97 | 101 | 105 | 15 | - |
| | Decomposition temperature (°C) *3 | 343 | 355 | 345 | 355 | 355 | 343 | 327 | |

*1: Orthophthalic acid polyol, manufactured by Nippon Polyurethane Co.

*2: 1.5 g of film prepared under curing condition at 170 °C for 2 h was subjected to with heat reduction at 200 °C for 168 hr in a petri dish made of glass, to determine the residual rate.

*3: Slight decomposition amount was observed by a magnifying lens at 10X.

Table 3

| | Linear expansion coefficient of resin | Number of cycles reaching resin crack failure rate of 10% |
|---|---|---|
| Device of the invention | $10 \times 10^{-6}/^{\circ}C$ | 300 cycles |
| Device of the prior art | $19 \times 10^{-6}/^{\circ}C$ | 20 cycles |

Table 4

| Specimen | Number of failed IC/total number of IC | | | |
|---|---|---|---|---|
| | PCT100h | PCT300h | PCT500h | PCT1000h |
| Device of the invention (wire intermediate layer) | 0/80 | 0/80 | 0/80 | 0/80 |
| Device in the prior art (not coated wire) | 0/80 | 0/80 | 4/80 | 10/80 |

Table 5 Bonding Condition I

| # | Kind of wire | Wire purity | Wire diameter | Strength at break (wire) | Elongation (wire) | Chip temperature | Lead temperature |
|---|---|---|---|---|---|---|---|
| 1 | Au (Not coated) | 4N | 25~30μm | 10~12g | 3~8% | 200°C | 160°C |
| 2 | Cu (Not coated) | 6N | 25~30μm | 10~16g | 5~30% | 300°C | 160°C |
| 3 | Aℓ (Not coated) | 4N | 25~30μm | 8~10g | 3~8% | 300°C | 160°C |
| 4 | Au (Coated) | 4N | 25~30μm | 10~12g | 3~8% | 300°C | 200°C |
| 5 | Cu (Coated) | 6N | 25~30μm | 12~16g | 5~30% | 300°C | 200°C |
| 6 | Aℓ (Coated) | 4N | 25~30μm | 8~10g | 3~8% | 300°C | 200°C |

[Note 1] Thermosonic ball bonding on the side of chip side, while capillary wedge bonding alone or in combination with supersonic bonding as required on the side of chip.

[Note 2] 4N indicates 99.99% and 6N indicates 99.9999% purity.

Table 6 Bonding Condition II

| # | Ball forming atmosphere | | Gas for preventing upward melting of coating | | Lead atmosphere | | Type of discharge |
|---|---|---|---|---|---|---|---|
| | Gas | Temperature | Gas | Temperature | Gas | Temperature | |
| 1 | Air | Room temperature | - | - | $N_2$ | Room temperature | Aparted arc discharge, with the wire side as positive electrode |
| 2 | Ar + 7% $H_2$ | 175°C | - | - | $N_2$ + 7% $H_2$ | ↑ | ↑ |
| 3 | ↑ | Room temperature | - | - | ↑ | ↑ | ↑ |
| 4 | Air or $N_2$ | ↑ | Air or $N_2$ | Room temperature | $N_2$ | ↑ | ↑ |
| 5 | Ar + 7% $H_2$ | 175°C | $N_2$ or $N_2$ + 7% $H_2$ | ↑ | $N_2$ + 7% $H_2$ | ↑ | ↑ |
| 6 | ↑ | Room temperature | ↑ | ↑ | ↑ | ↑ | ↑ |

[Note 1] Serial Nos. (#1 - 6) identical with those in Table 5 indicate that identical wires are used in accordance with identical conditions.

Table 7 Inner Lead Structure

| # | Wire | Lead substrate material | Plating and other structure in second bonding portion |
|---|---|---|---|
| 1/4 | Au | 42 alloy | Spot Ag plating |
| 2/5 | Cu | Cu or Cu alloy | Non-plating or pure copper spot plating |
| 3/6 | Aℓ | 42 alloy | Aℓ sputtered film |

[Note 1] Serial Nos. (#1 - 6) identical with those in Table 5 indicate that identical wires are used in accordance with identical conditions.

## Claims

1. A method of manufacturing a semiconductor device in which external terminals of a semiconductor chip and a lead are connected by way of coated wires comprising a metal wire coated at the surface thereof with an insulative coating layer, wherein the coating layer for said coated wire comprises a heat resistant polyurethane prepared by reacting a polyol ingredient and an isocyanate and containing constituent units derived from terephthalic acid in the molecule skelton, and said coated wire is connected at one end thereof to said external terminal of the semiconductor chip while connected at the other end thereof to said lead.

2. A method of manufacturing a semiconductor device as defined in claim 1, wherein the coating layer at one end of the coated wire is removed upon forming a metal ball, and said metal ball is connected to the external terminal of the semiconductor chip.

3. A method of manufacturing a semiconductor device as defined in claim 1, wherein the one end of the coated wire is connected to the external terminal of the semiconductor chip by the combined use of supersonic vibration and hot-press bonding.

4. A method of manufacturing a semiconductor device as defined in claim 1, wherein the other end of the coated wire is brought into contact with the lead and the coating layer at the portion of contact is destroyed, and the metal wire on the other side of said coated wire is connected with said lead.

5. A method of manufacturing a semiconductor device as defined in claim 1, wherein the coating layer at the other end of the coated wire is previously removed prior to the connection of said the other end to said lead.

6. A method of manufacturing a semiconductor device as defined in claim 1, wherein the wire bonding portion of the lead is particularly heated locally upon connecting the other end of the coated wire to said lead.

7. A method of manufacturing a semiconductor device as defined in claim 1, wherein a pigment is added by a predetermined amount to the coating layer of the coated wire.

8. A method of manufacturing a semiconductor device as defined in claim 1, wherein a second insulative coating layer is disposed on the above-mentioned coating layer of the coated wire.

9. A method of manufacturing a semiconductor device in which external terminals of a semiconductor chip and a lead are connected by way of coated wires comprising a metal wire coated at the surface thereof with an insulative coating layer, wherein said coating layer of said wire comprises material having a

degradation rate of less than 20 % in relation with the reduction of cycles for the destruction of said coating layer on the coated wire at a temperature from 150 °C to 175 °C after 100 hours, and showing no carbonization upon forming a metal ball or upon removal of said coating layer.

10. A semiconductor device in which external terminals of a semiconductor chip and a lead are connected by way of coated wires comprising a metal wire coated at the surface thereof with an insulative coating layer, wherein the coating layer of said coated wire comprises a heat resistant polyurethane prepared by reacting a polyol ingredient and an isocyanate and containing constituent units derived from terephthalic acid in the molecule skelton.

11. A semiconductor device in which external terminals of a semiconductor chip and a lead are connected by way of coated wires comprising a metal wire coated at the surface thereof with an insulative coating layer, wherein the coating layer of said coated wire comprises material having a degradation rate of less than 20 % in relation with the reduction of cycles for the destruction of said coating layer on the coated wire at a temperature from 150 °C to 175 °C after 100 hours and showing no carbonization upon forming a metal ball or upon removal of said coating layer.

12. A resin encapsulated semiconductor device, in which external terminal formed on a semiconductor chip and a lead led out of a package are connected by way of metal wires and the periphery of them is molded with a resin composition, wherein an intermediate layer comprising an insulative resin is disposed between said metal wire and said resin composition, and the heat expansion coefficient of said resin composition is controlled to less than $10 \times 10^{-6}/°C$.

13. A resin encapsulated semiconductor device as defined in claim 12, wherein the intermediate layer comprises an insulative resin of a polyurethane prepared by reacting a polyol ingredient and an isocyanate and containing constituent units derived from terephthalic acid in the molecule skelton.

14. A resin encapsulated semiconductor device in which external terminals formed on a semiconductor chip and a lead led out of a package are connected by way of metal wires each having an intermediate layer comprising an insulative resin formed therearound and, further, the periphery thereof is molded with a resin composition, wherein the total diameter for said metal wire and said intermediate layer is not greater than 30 µm and the heat expansion coefficient of said resin composition is controlled to less than $10 \times 10^{-6}/°C$.

15. A resin encapsulated semiconductor device as defined in claim 14, wherein the metal wire comprises gold (Au) and the intermediate layer is formed with an insulative resin comprising a polyurethane prepared by reacting a polyol ingredient and an isocyanate and containing constituent units derived from terephthalic acid in the molecule skelton.

16. A resin encapsulated semiconductor device, wherein a metal wire for connecting an external terminal formed on a semiconductor chip and a lead has a first intermediate layer comprising an insulative resin formed therearound and a second intermediate layer comprising a resin of satisfactory releasability further formed to the outer circumference thereof.

17. A resin encapsulated semiconductor device as defined in claim 16, wherein the second intermediate layer is prepared by forming an intermediate layer comprising a heat resistant polyurethane resin at the periphery of the metal layer and, thereafter, depositing a fluoro resin or silicone resin.

18. A method of manufacturing a resin encapsulated semiconductor device which comprises, upon connecting an external terminal on a semiconductor chip and a lead by way of a metal wire, press-bonding one end of said metal wire protruded from the top end of a bonding tool applied with supersonic vibrations to said external terminal, then moving said bonding tool while maintaining said supersonic vibrations, deliverying said metal wire from the top end of said bonding tool, bonding the other end of said metal wire to said lead and then applying molding for the wiring region by said metal wire using a resin composition the expansion coefficient of which is controlled to less than $10 \times 10^{-6}/°C$.

19. A method of manufacturing a resin encapsulated semiconductor device as defined in claim 18, wherein the resin composition contains a spherical molten quartz powder as the filler in an epoxy resin, in which not less than 90 % by weight of said powder has a grain size of less than 100 µm, which has such a grain size distribution that the slope n in said grain size distribution expressed type RRS grain size diagram exhibits a linearity within a range from 0.6 to 1.5, and in which said filler is blended in an amount from 65 to 75 % by weight based on the entire resin composition.

20. A method of manufacturing a resin encapsulated semiconductor device, which comprises forming an intermediate layer by depositing an insulative resin comprising a polyurethane prepared by reacting a polyol ingredient and a isocyanate and containing constituent units derived from terephthalic acid in the molecule skelton around the periphery of a metal wire, connecting an external terminal of a semiconductor chip and a lead by way of said metal wire and then applying molding over wiring region with a resin composition the heat expansion coefficient of which is controlled to less than $10 \times 10^{-6}/°C$.

21. A method of manufacturing a resin encapsulated semiconductor device, which comprises forming an intermediate layer comprising an insulative resin at the peri phery of a metal wire to obtain a wire, connecting a semiconductor chip mounted on a lead frame and a lead by using said wire, placing said lead frame in a mold in which a plurality of cavities are formed and injecting a molten resin under a high pressure from at least two resin supply sources to the plurality of cavities in said mold, thereby forming a package.

22. A method of manufacturing a resin encapsulated semiconductor device as defined in claim 21, wherein the resin supply source is a plurality of pots in communication with a transfer cylinder, tablets each comprising the resin composition are charged in the plurality of pots and, thereafter, plungers disposed to the respective pots are pressed in synchronization, thereby charging the molten resin under high pressure to each of said cavities.

23. An intermediate layer forming apparatus for forming first and second intermediate layers at the periphery of a metal wire, wherein the apparatus comprises a first storage reservoir and a second storage reservoir disposed continuously, a pulley rotatable in a vertical plain is disposed in each of the storage reservoirs, the lowermost portion of said pulley is immersed in a stored solution, and a predetermined amount of the stored solution paddled by said pulley at the uppermost portion thereof is brought into contact with said metal layer to thereby form the first or the second intermediate layer at the periphery of said metal wire.

24. An intermediate layer forming apparatus as defined in claim 23, wherein baking means is disposed between said first storage reservoir and said second storage reservoir.

25. A semiconductor device in which external terminals of a semiconductor chip mounted on a tab and a lead are connected by way of coated wires each comprising a metal wire coated at the surface thereof with an insulator and said coated wire and the connection portion of said coated wire are covered with a resin, wherein the shape is moderated at the corners for the semiconductor chip, corners for the tab and the corners for the lead within a range where said coated wire is extended is moderated.

26. A semiconductor device as defined in claim 25, wherein said tab and said lead are formed by punching, the semiconductor chip is mounted on the surface of said tab where burrs formed at the corners upon punching are not protruded, and the external terminals of the semiconductor chip and the surface of the lead, in which burrs formed at the corners by said punching are not protruded, are connected by way of the coated wire.

27. A semiconductor device as defined in claim 25, wherein the tab and the lead are formed by punching, and burrs formed at the corners of tab and the lead by punching are removed.

28. A semiconductor device as defined in claim 25, wherein the corners for the semiconductor chip, the corners for the tab or the corners for the lead are chamfered.

29. A semiconductor device as defined in claim 25, wherein shape moderating members are disposed to the corners for the tab or to the corners for the lead for moderating the shape.

30. A semiconductor device as defined in claim 25, wherein the metal wire of the coated wire is formed with Au, Cu, Al, etc. and the insulator is formed with a resin film such as of polyurethane resin, polyester resin, polyimide resin, esteramide resin, esterimide resin, etc.

31. A semiconductor device in which external terminals of a semiconductor chip and a lead are connected by way of coated wire each comprising a metal wire coated at the surface thereof with an insulator and the coated wire and the connection portion of said coated wire are covered with a resin, wherein said coated wire is extended such that it is not in contact with the corners for the semiconductor chip, corners for the tab or the corners for the lead.

32. A method of forming a semiconductor device by using a coated wire comprising a metal wire coated at the surface thereof with an insulator, which includes steps of mounting a semiconductor chip on a first package at a position of mounting said chip, connecting external terminals of said semiconductor chip and a lead by way of said coated wire to form a first semiconductor device, mounting a semiconductor chip identical with the semiconductor chip of said first semiconductor device on a second package of a kind different from that of the first package for said first semiconductor device at a position for mounting said chip, connecting the external terminals of said semiconductor chip and said lead by way of said coated wire to form a second semiconductor device.

33. A method of forming a semiconductor device by using a coated wire comprising a metal wire coated at the surface thereof with an insulator, which includes steps of mounting a first semiconductor chip to a lead at a chip mounting position, connecting external terminals of said first semiconductor chip and a lead by way of said coated wire and applying resin encapsulation to form a semiconductor device, mounting a second semiconductor chip of a kind different from the first semiconductor chip of said first semiconductor device to a lead identical with the lead for said first semiconductor device at the chip

mounting position, connecting external terminals of said second semiconductor chip and said lead by way of said coated wire and applying resin encapsulation to form a second semiconductor device.

34. A semiconductor device as defined in claim 26, wherein the metal wire of the coated wire is formed with Au, Cu, Al, etc. and the insulator is formed with a resin film such as of polyurethane resin, polyester resin, polyimide resin, esteramide resin, esterimide resin, etc.

35. A semiconductor device as defined in claim 27, wherein the metal wire of the coated wire is formed with Au, Cu, Al, etc. and the insulator is formed with a resin film such as of polyurethane resin, polyester resin, polyimide resin, esteramide resin, esterimide resin, etc.

36. A semiconductor device as defined in claim 28, wherein the metal wire of the coated wire is formed with Au, Cu, Al, etc. and the insulator is formed with a resin film such as of polyurethane resin, polyester resin, polyimide resin, esteramide resin, esterimide resin, etc.

37. A semiconductor device as defined in claim 29, wherein the metal wire of the coated wire is formed with Au, Cu, Al, etc. and the insulator is formed with a resin film such as of polyurethane resin, polyester resin, polyimide resin, esteramide resin, esterimide resin, etc.

38. A molding method of applying a resin transfer molding for a semiconductor device, in which a resin composition for encapsulation is extruded from a cylinder, injected into a cavity and then cured therein to encapsulate at least a portion of a semiconductor device chip and a lead connected electrically therewith directly or indirectly, wherein the content of a releasing agent in the composition before charging into the cavity is more than 0.3 % by weight.

39. A molding method as defined in claim 38, wherein the content of the releasing agent is less than 0.6 % by weight.

40. A molding method as defined in claim 39, wherein the heat expansion coefficient of the composition after curing is less than $10 \times 10^{-6}/^{\circ}C$.

41. A molding method as defined in claim 40, wherein the semiconductor chip and the lead are connected by way of an insulative coated wire.

42. A molding method as defined in claim 41, wherein the peripheral portion of at least one of the main surfaces of the semiconductor chip are chamfered.

43. A method of manufacturing a semiconductor integrated circuit device having :

(a) a semiconductor chip,

(b) an Al bonding pad disposed on the first main surface of said semiconductor chip,

(c) leads extended on the first or the second main surface of said semiconductor chip or the periphery thereof,

(d) a coated wire having a core portion comprising copper at a purity of 99.999 % or higher for connecting said pad and said lead, and

(e) a resin encapsulating material for encapsulating at least a portion of said chip wire and said lead, wherein

the method comprises, upon forming a ball at one end of a wire on said pad or lead, supplying an annealing gas heated to a temperature or $100^{\circ}C$ of higher to the periphery of the ball upon forming by said electric discharge, so that the molten ball after the formation thereof by electric discharge is not cooled rapidly.

44. A semiconductor device manufactured by the method as defined in any one of claims 38 to 43.

FIG. 1

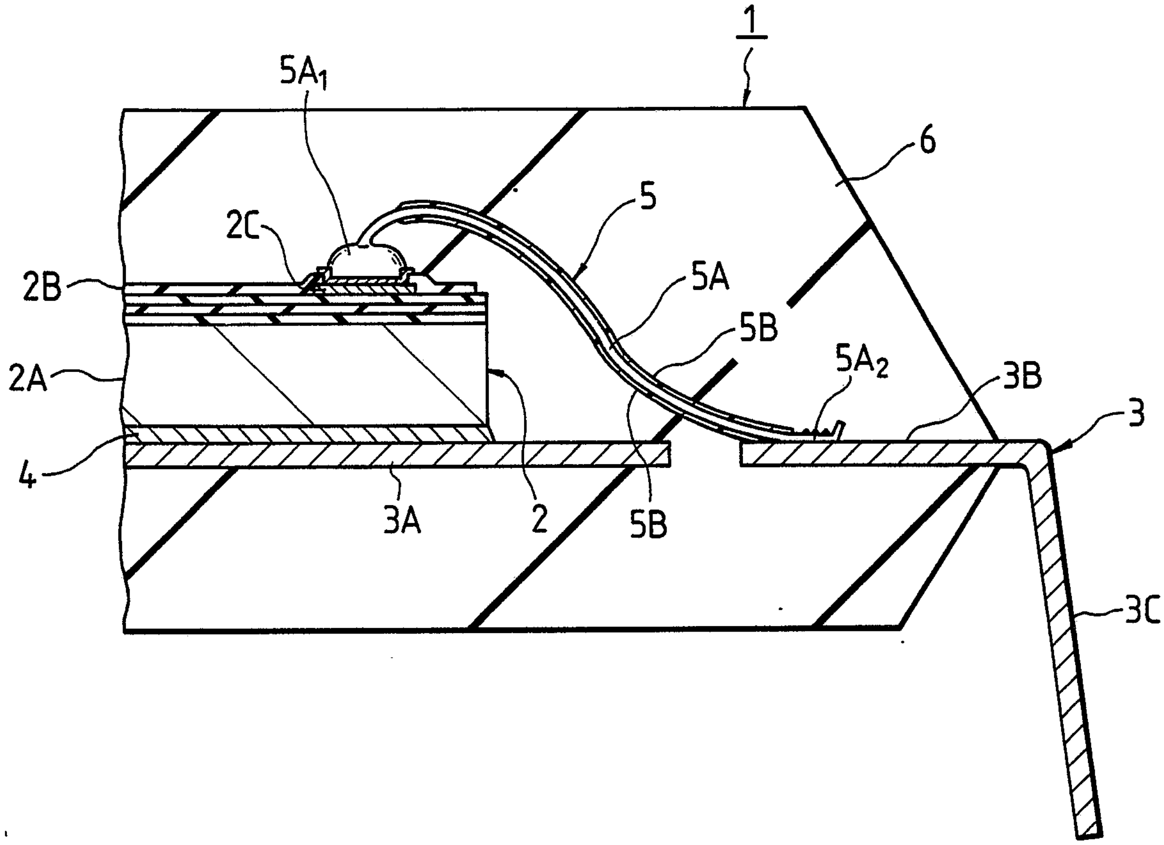
1
6
5
5A1
2C
2B
2A
5A
5B
5A2
3B
3
4
3A
2
5B
3C

FIG. 2

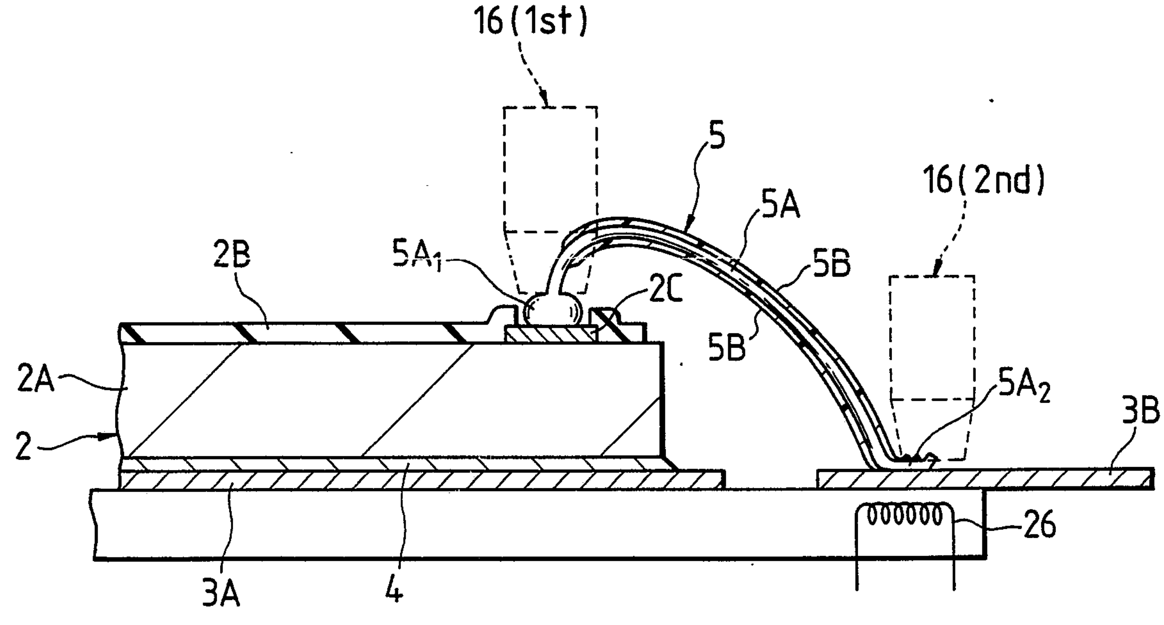
16 (1st)
5
5A
16 (2nd)
5B
2B
5A1
2C
5B
2A
5A2
3B
2
26
3A
4

FIG. 3

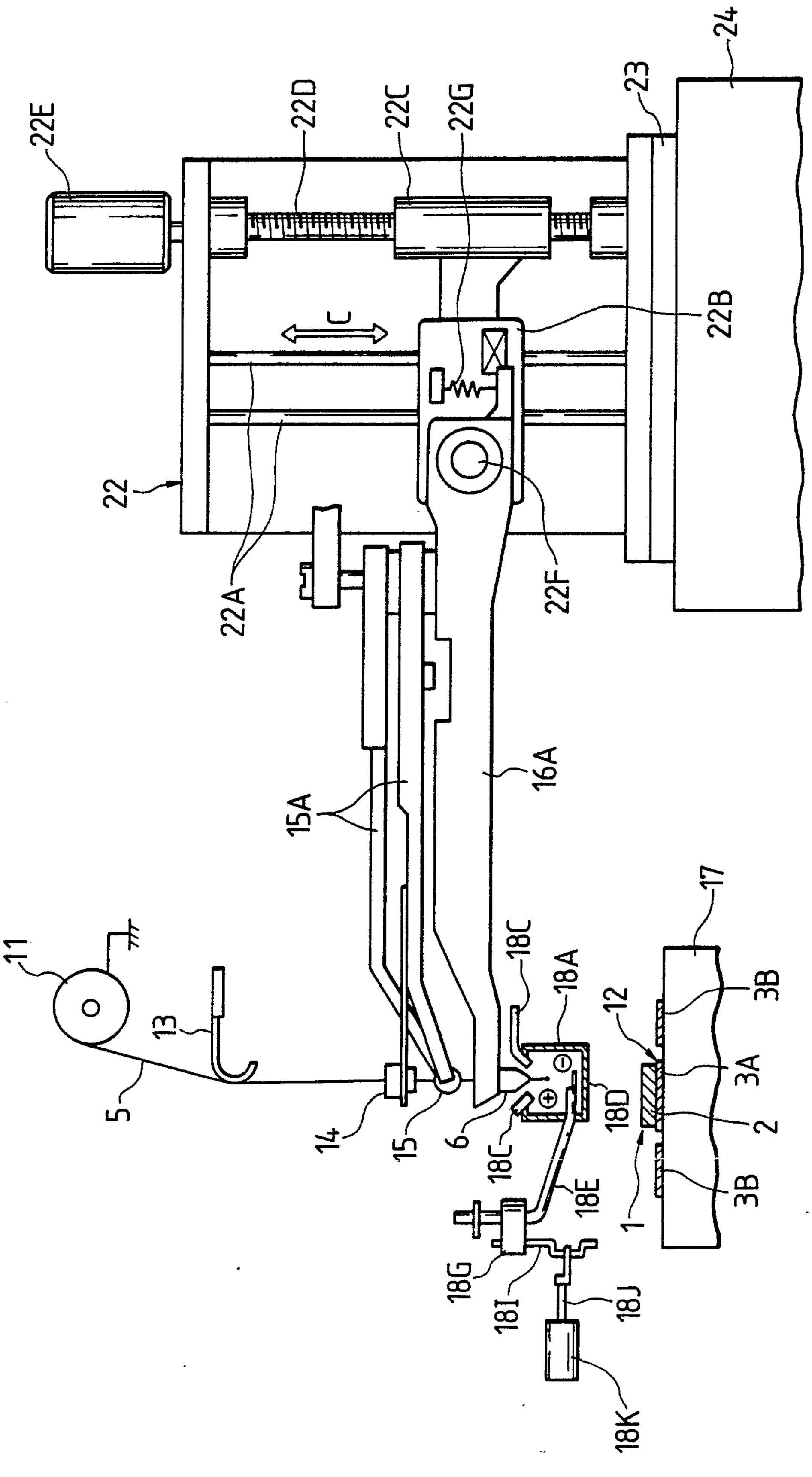
22E
22D
22C
22G
23
24
22B
C
22
22A
22F
16A
15A
11
13
5
14
15
6
18C
18A
18D
18C
18E
18G
18I
18J
18K
17
12
3B
3A
2
1
3B

FIG. 4

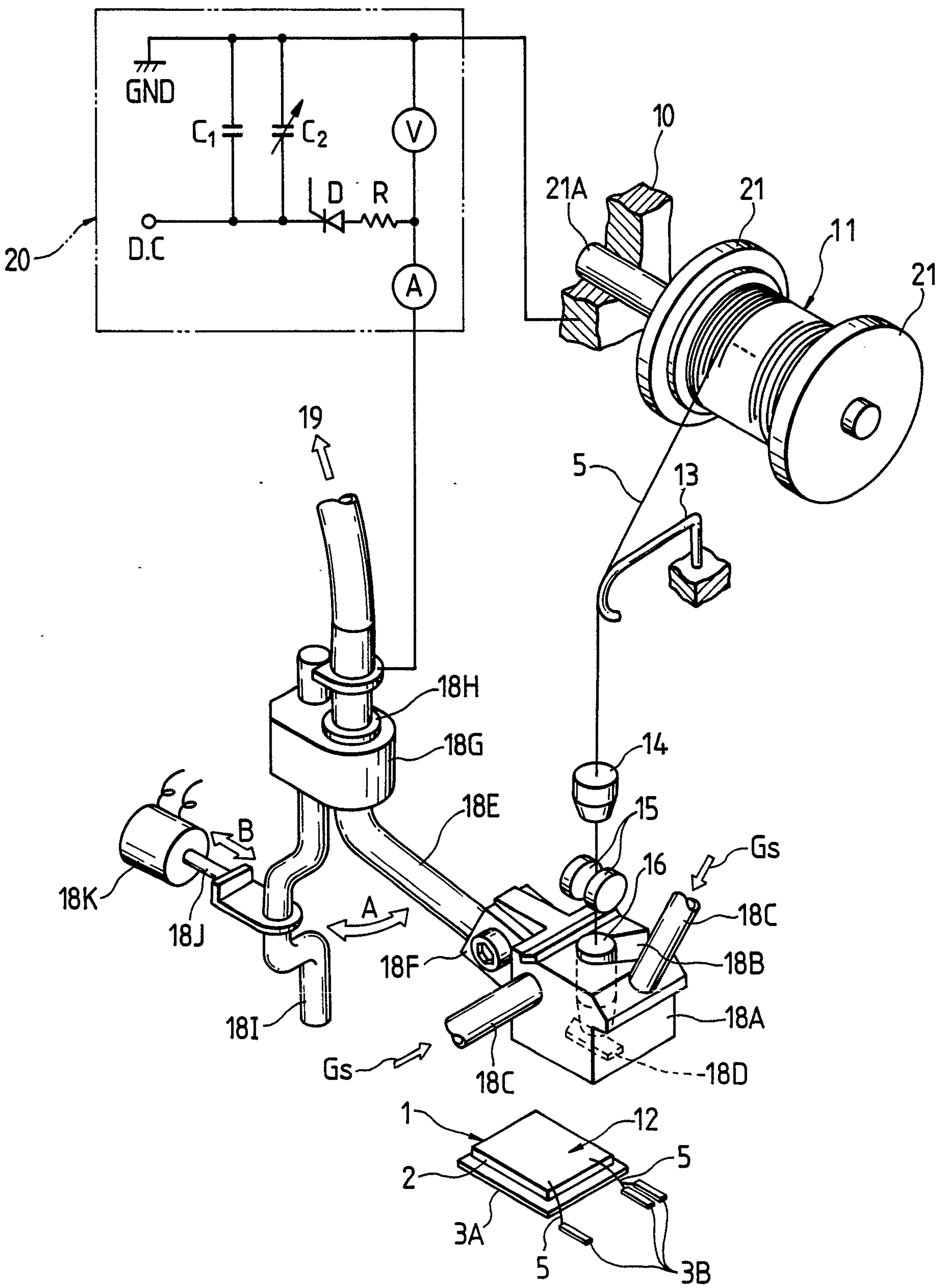
GND
C1
C2
V
D
R
D.C
A
20
10
21A
21
11
21
19
5
13
18H
18G
14
18E
15
B
16
Gs
18K
A
18C
18J
18F
18B
18A
18I
Gs
18C
18D
1
12
2
5
3A
5
3B

FIG. 5

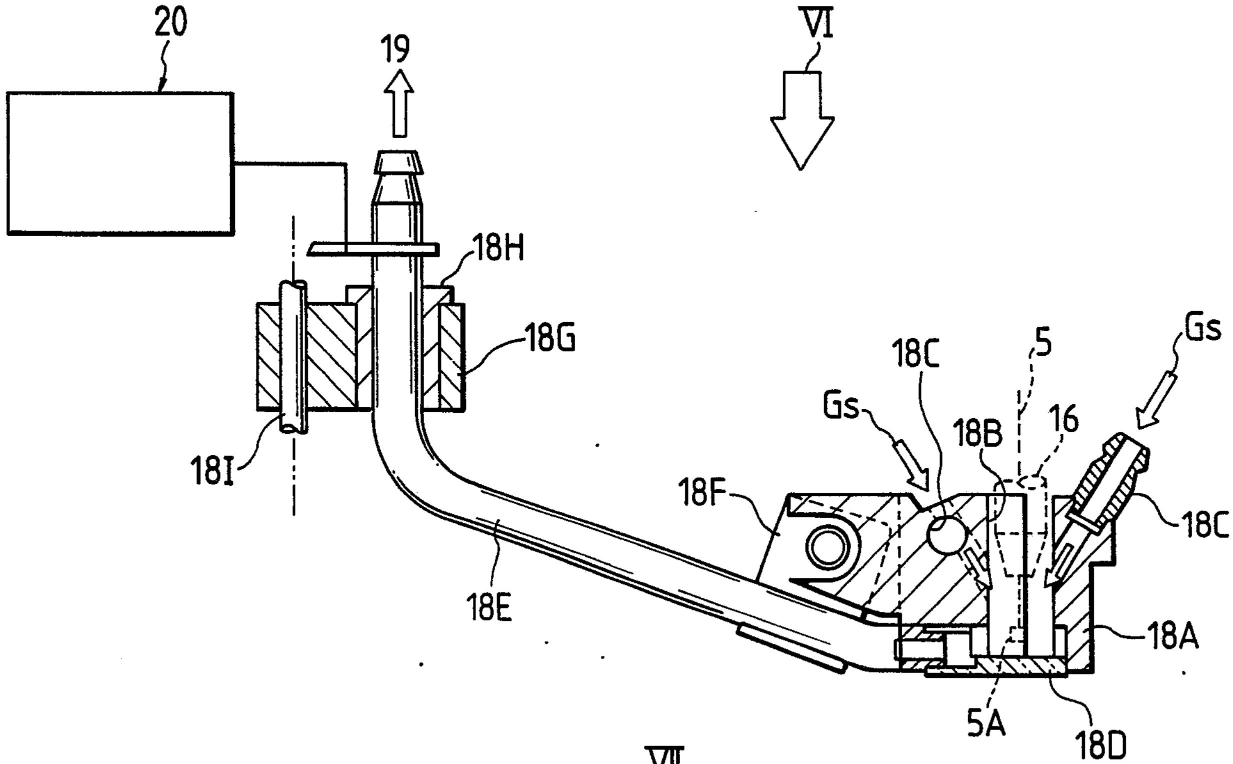


FIG. 6

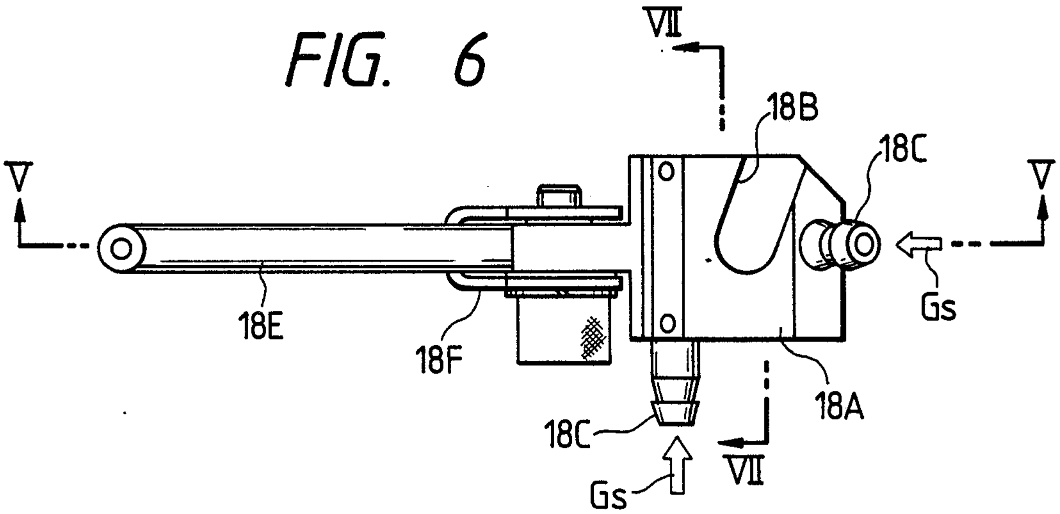


FIG. 7

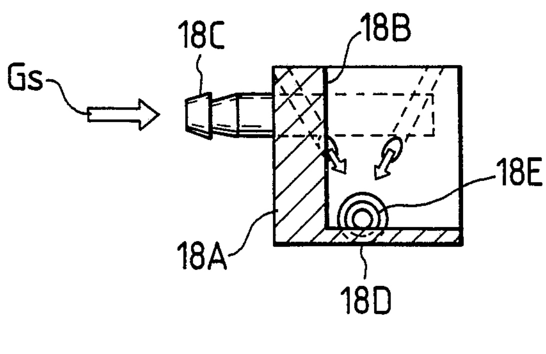

FIG. 8

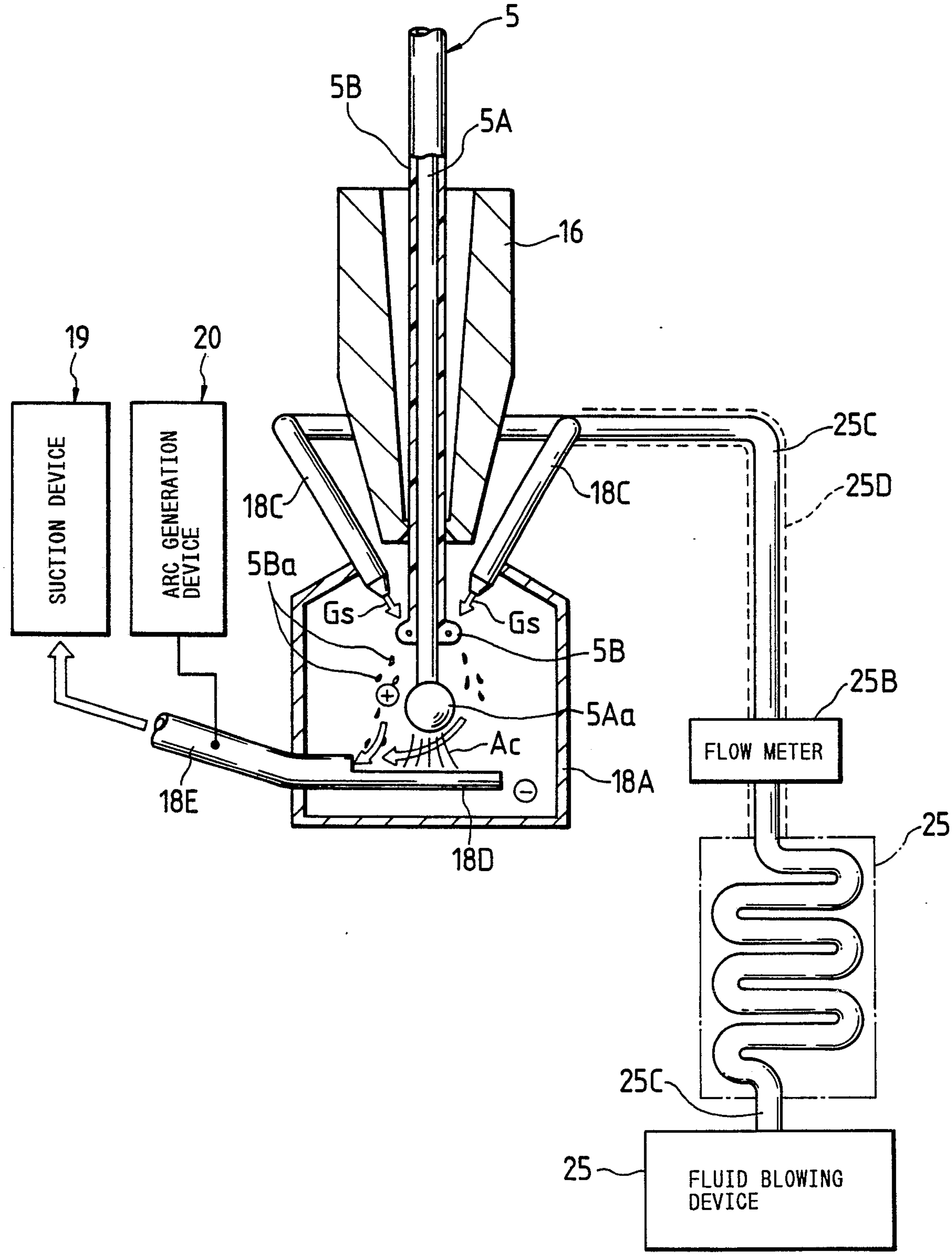
5
5B
5A
16
19
20
SUCTION DEVICE
ARC GENERATION DEVICE
25C
25D
18C
18C
5Ba
Gs
Gs
5B
25B
5Aa
FLOW METER
Ac
18A
18E
18D
25A
25C
25
FLUID BLOWING DEVICE

FIG. 9

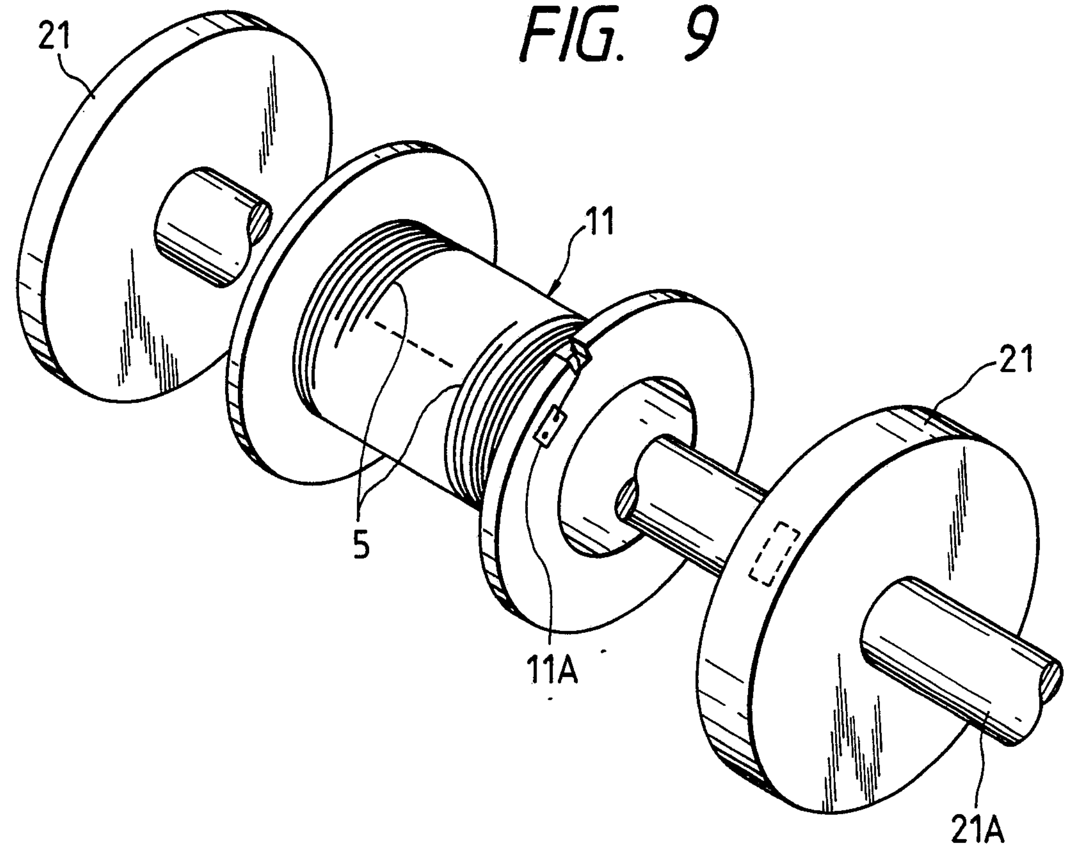


FIG. 10

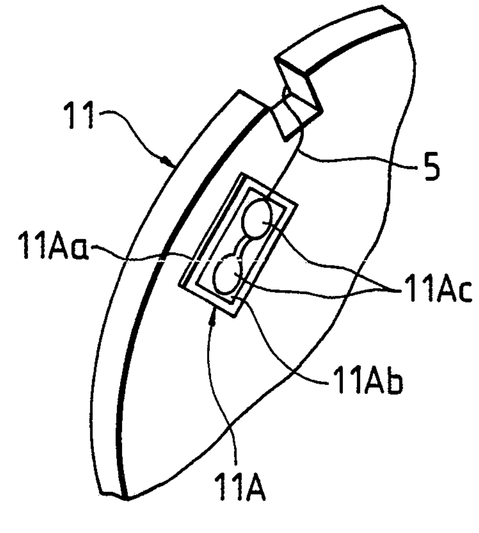

FIG. 11

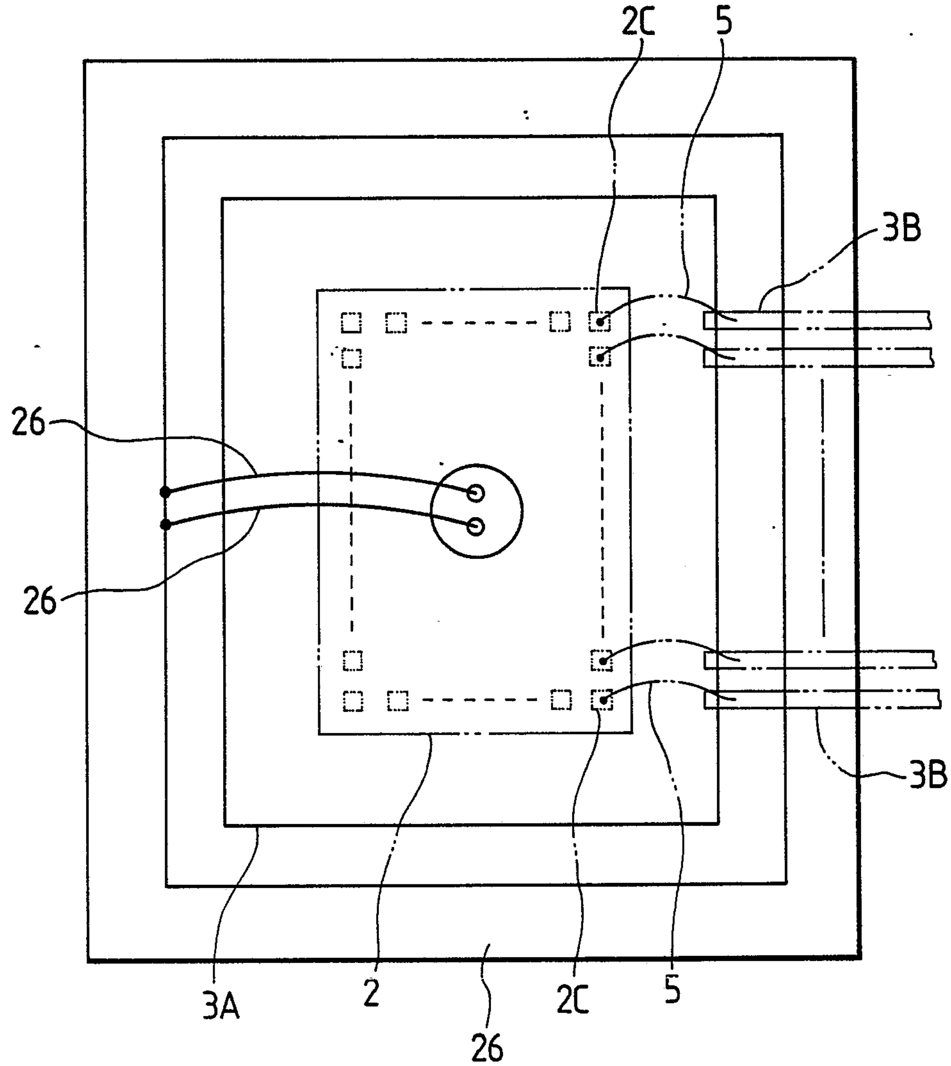

FIG. 12

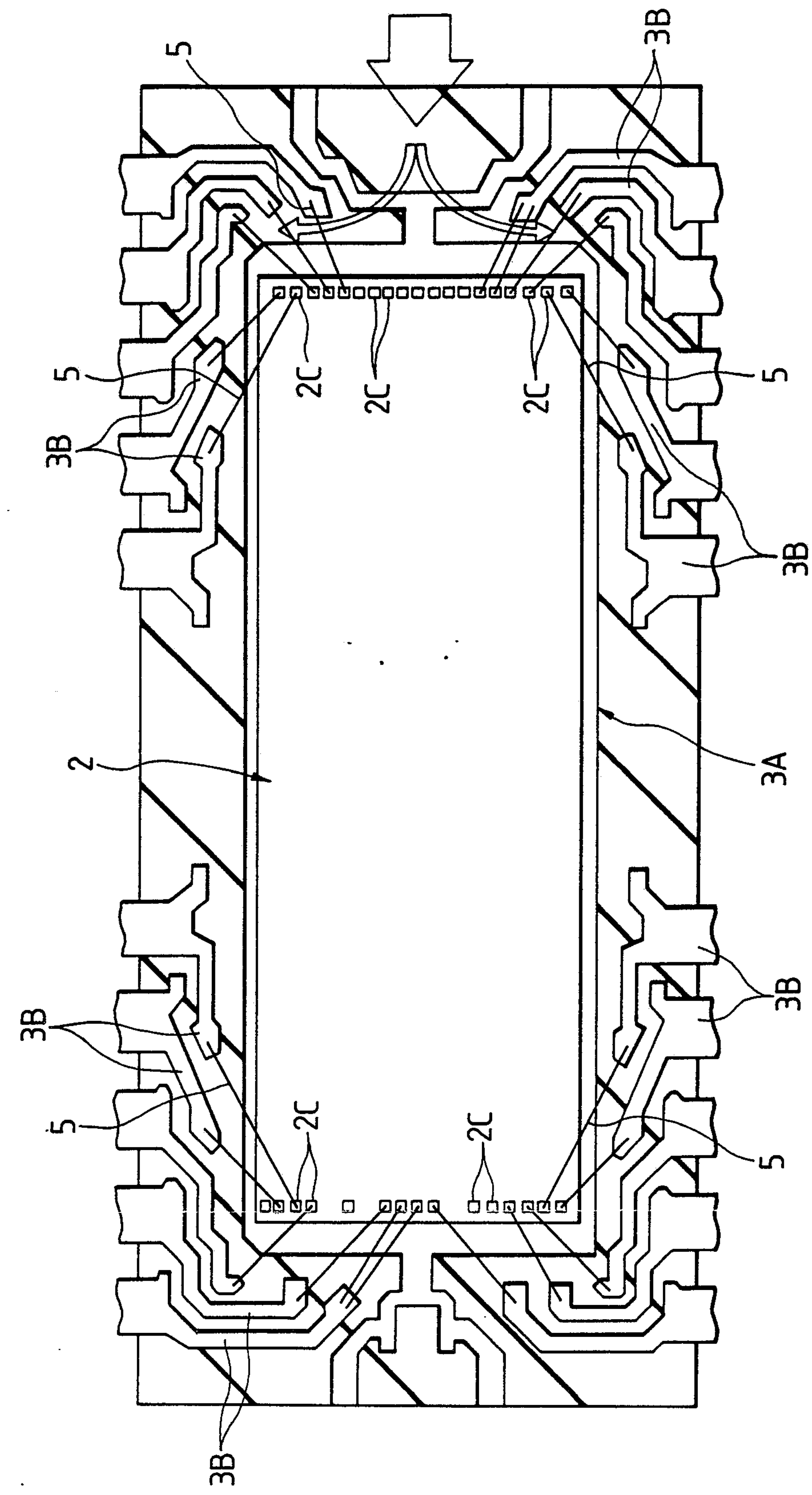

FIG. 13

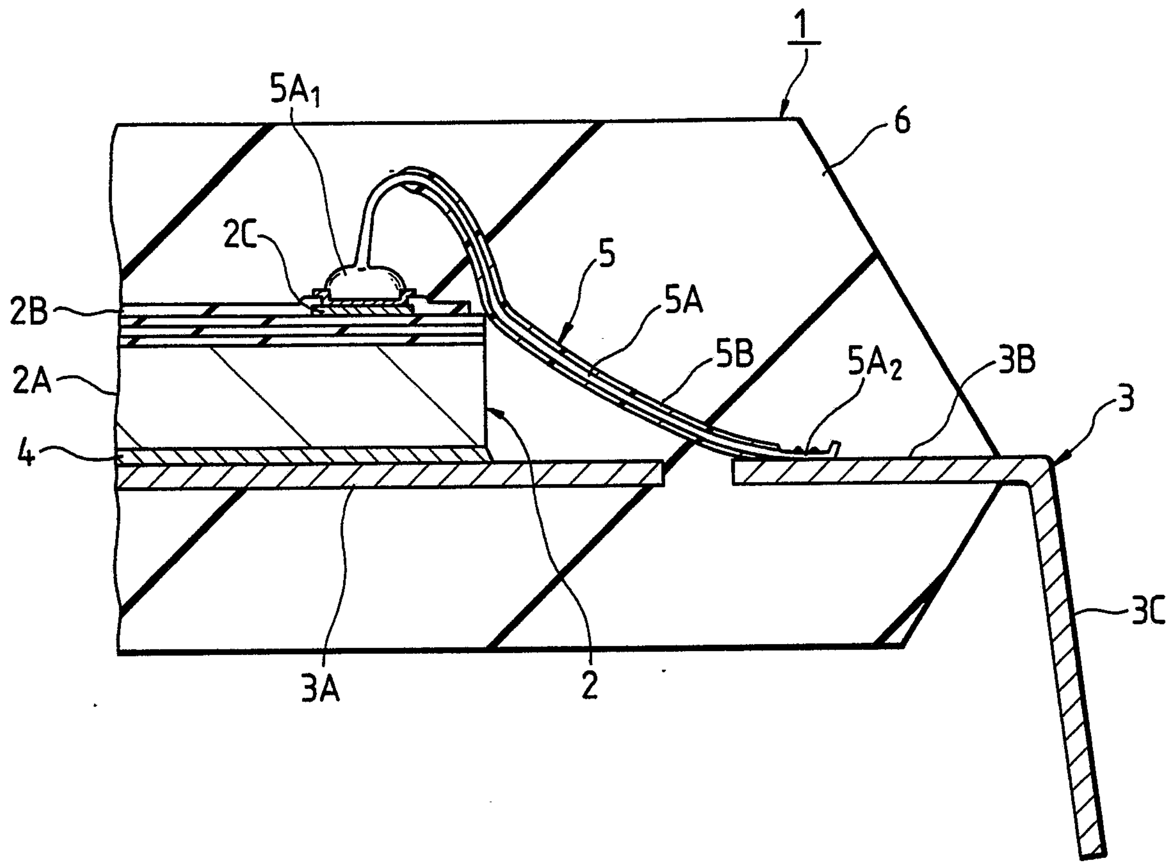


FIG. 14

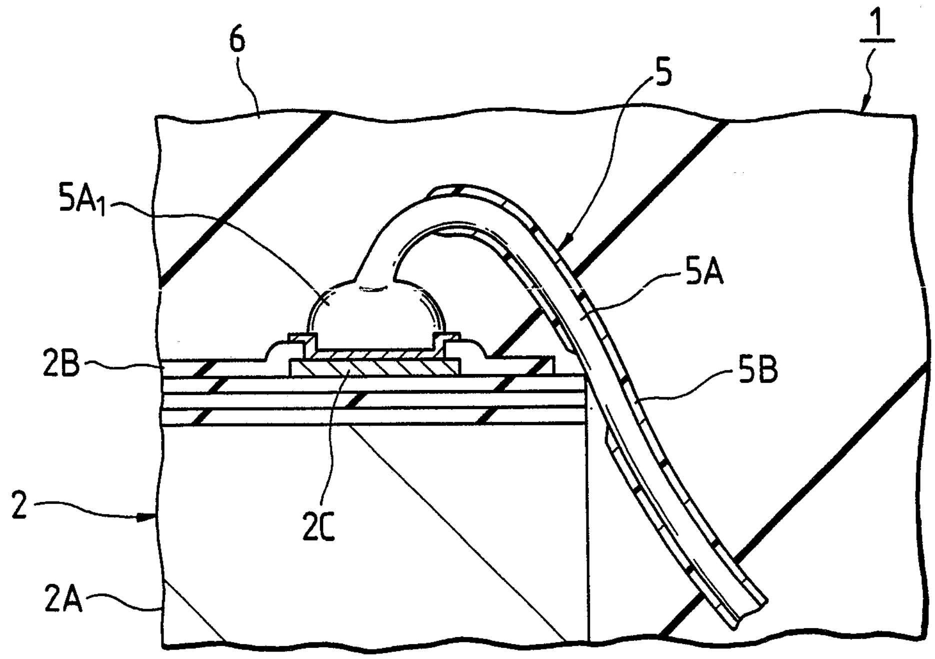

FIG. 15

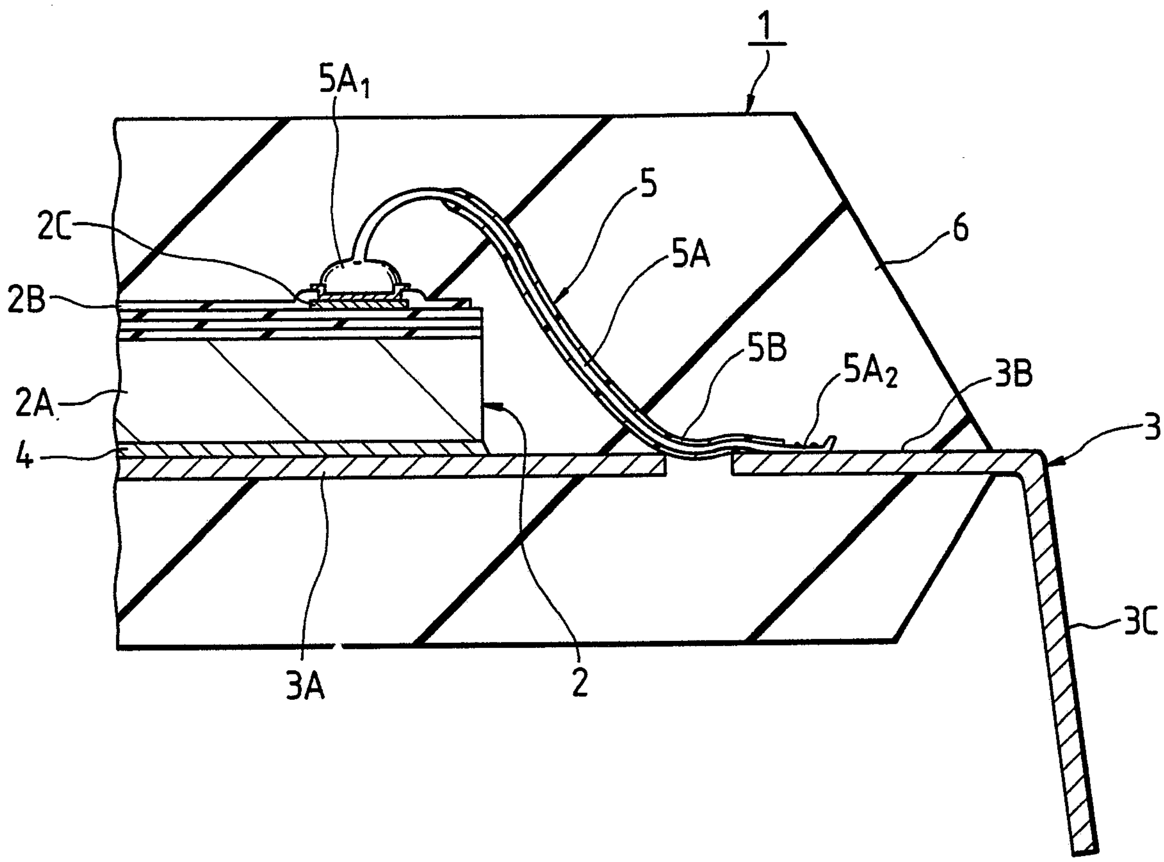


FIG. 16

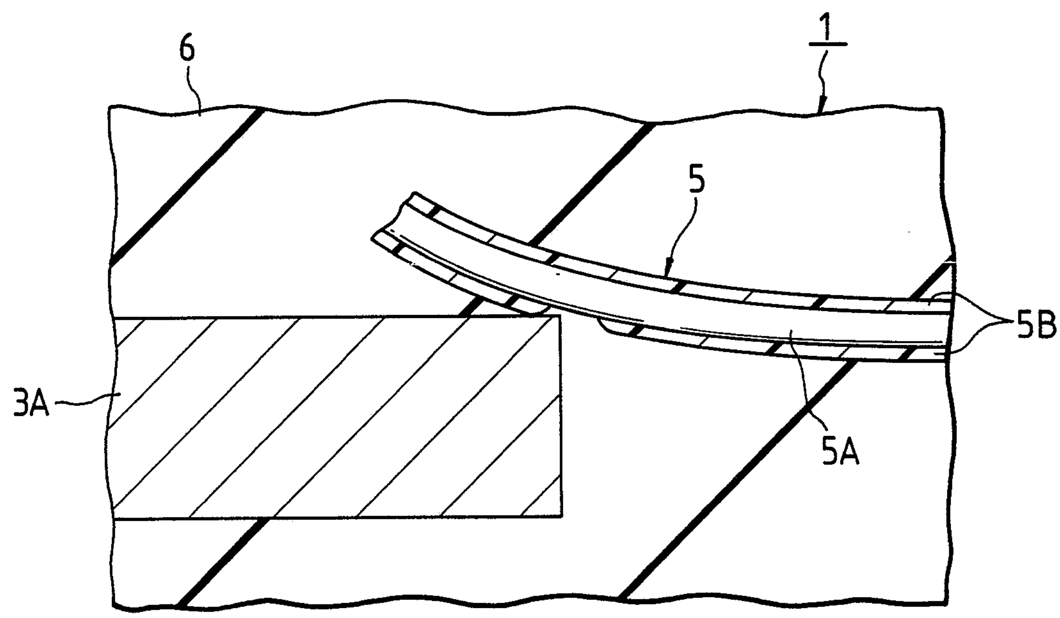

# FIG. 17

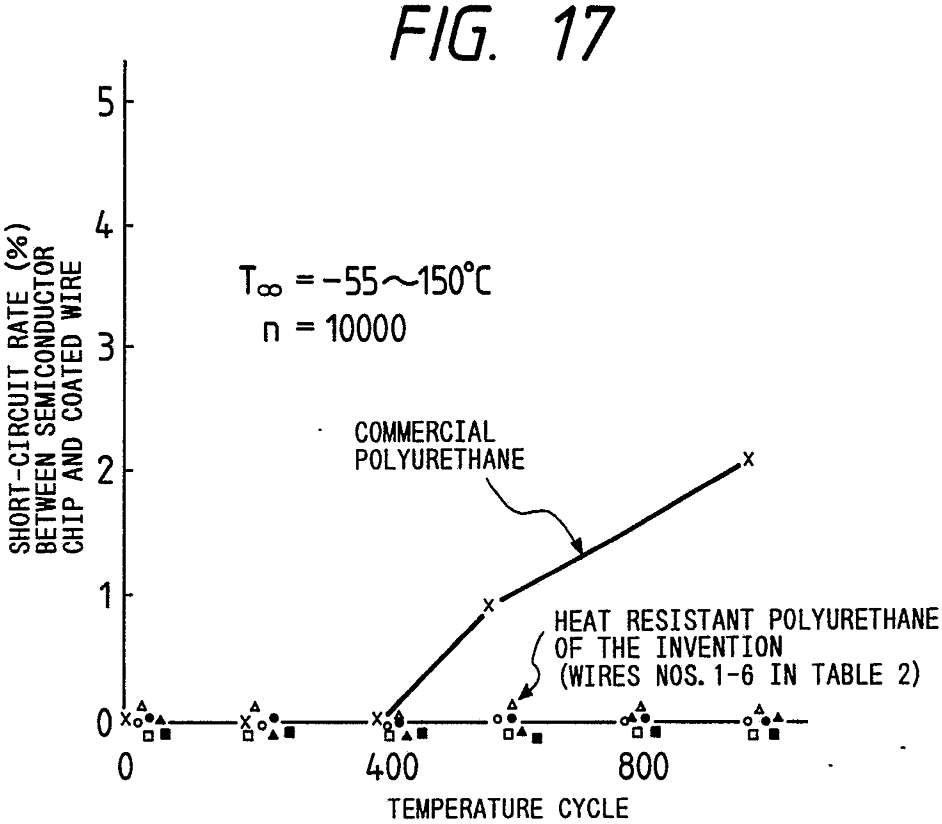

5
4
3
2
1
0
SHORT-CIRCUIT RATE (%) BETWEEN SEMICONDUCTOR CHIP AND COATED WIRE
T∞ = −55～150°C
n = 10000
COMMERCIAL POLYURETHANE
HEAT RESISTANT POLYURETHANE OF THE INVENTION (WIRES NOS. 1-6 IN TABLE 2)
0
400
800
TEMPERATURE CYCLE


# FIG. 18

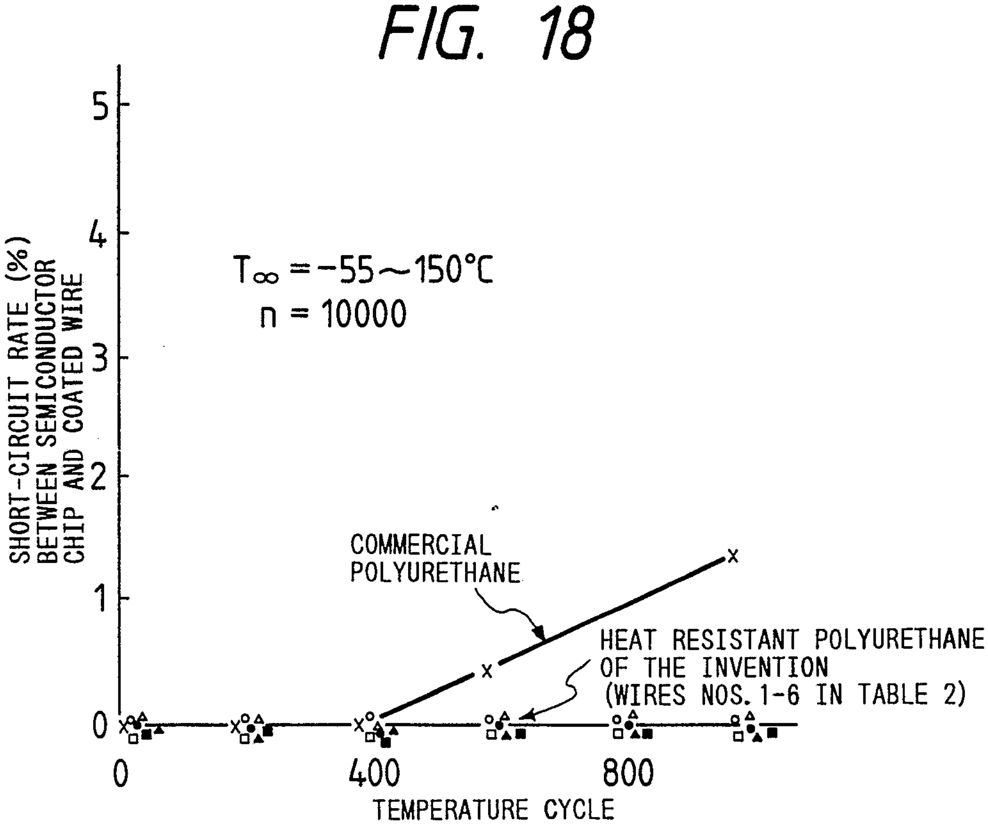

5
4
3
2
1
0
SHORT-CIRCUIT RATE (%) BETWEEN SEMICONDUCTOR CHIP AND COATED WIRE
T∞ = −55～150°C
n = 10000
COMMERCIAL POLYURETHANE
HEAT RESISTANT POLYURETHANE OF THE INVENTION (WIRES NOS. 1-6 IN TABLE 2)
0
400
800
TEMPERATURE CYCLE

FIG. 19

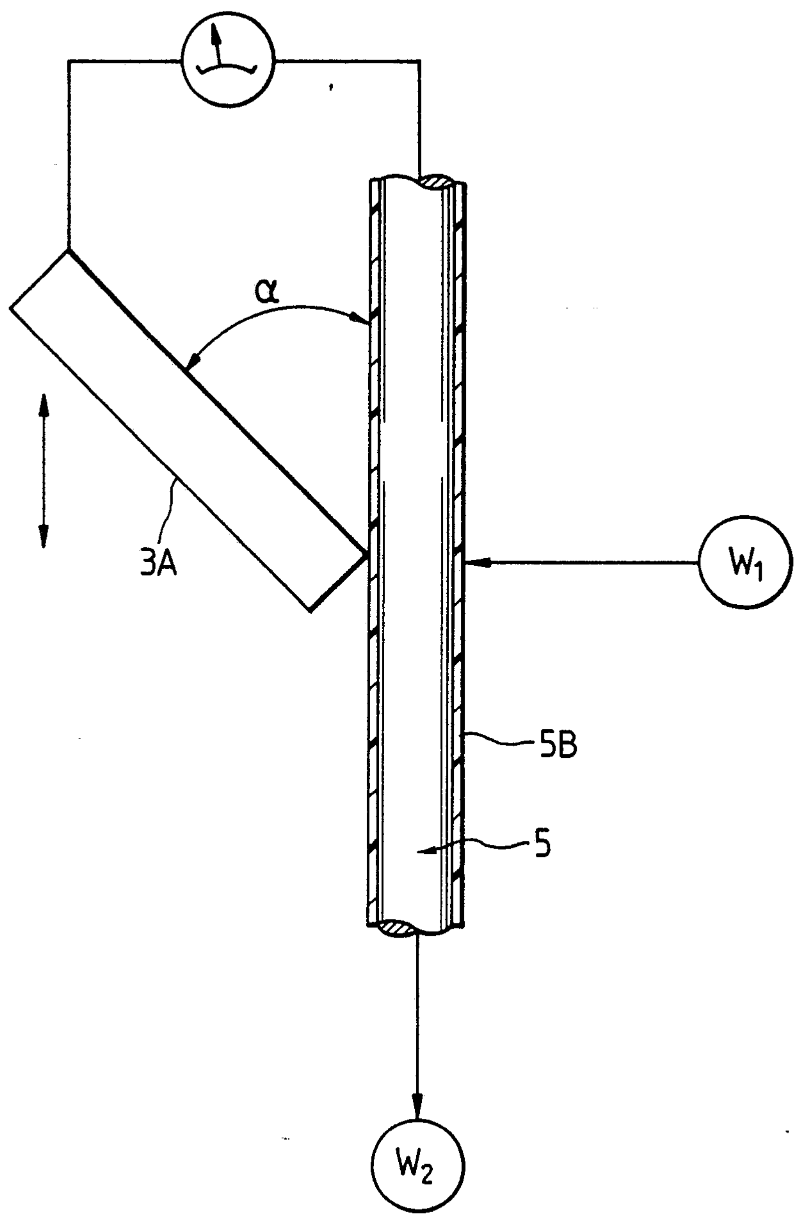

FIG. 20

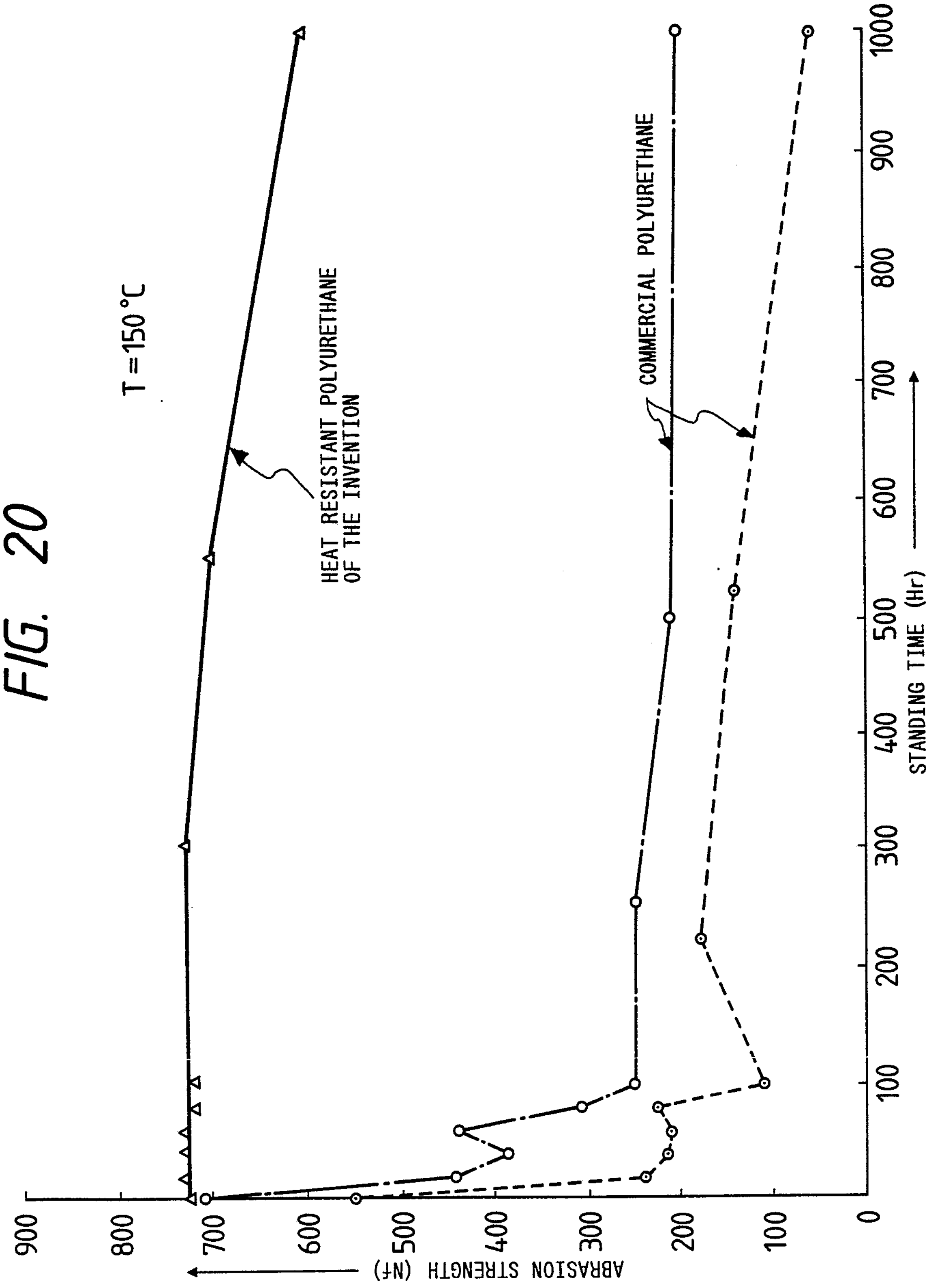
T = 150 °C
HEAT RESISTANT POLYURETHANE
OF THE INVENTION
COMMERCIAL POLYURETHANE
ABRASION STRENGTH (Nf)
STANDING TIME (Hr)
900
800
700
600
500
400
300
200
100
0
100
200
300
400
500
600
700
800
900
1000

FIG. 21

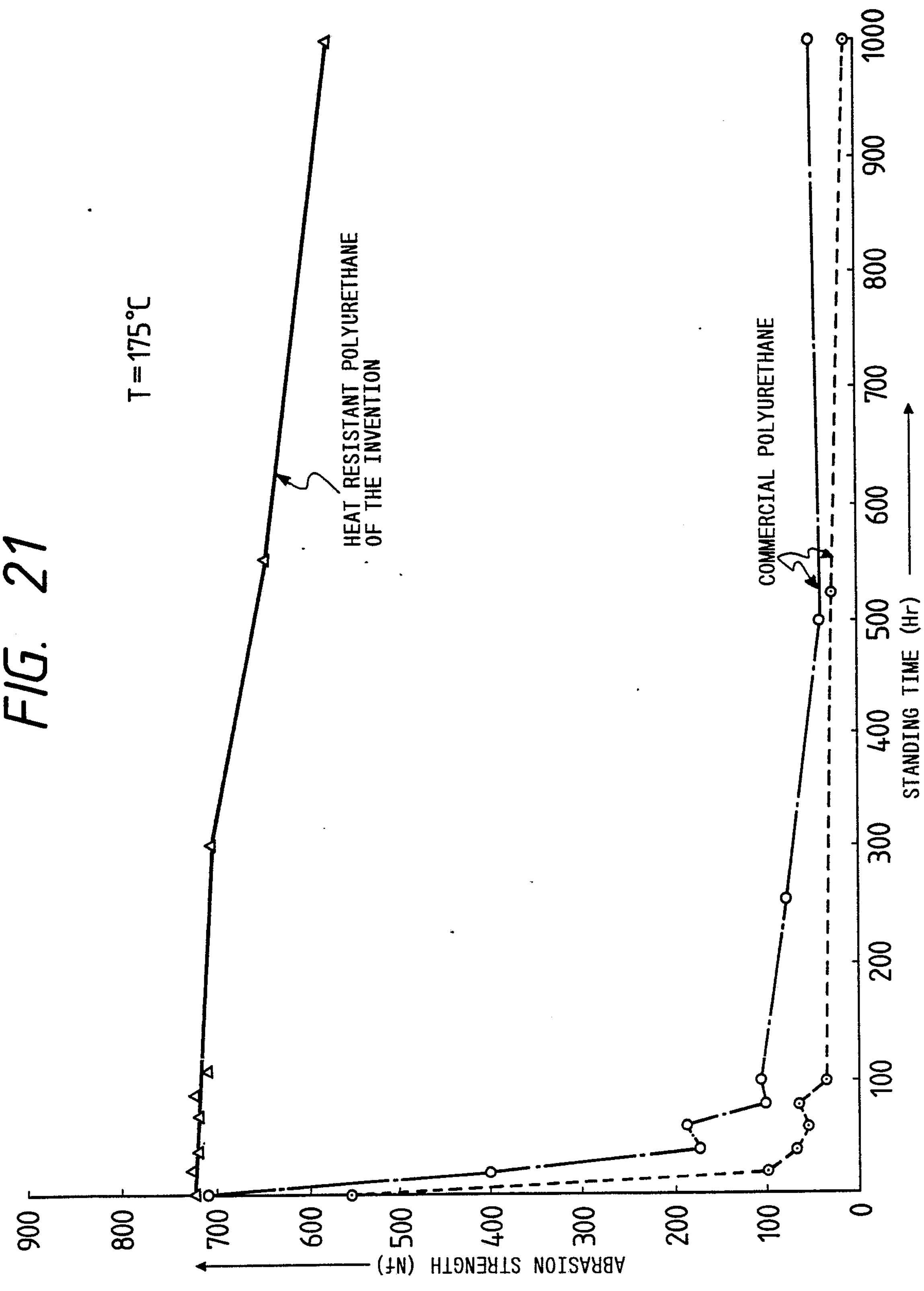
T=175°C
HEAT RESISTANT POLYURETHANE
OF THE INVENTION
COMMERCIAL POLYURETHANE
ABRASION STRENGTH (Nf)
900
800
700
600
500
400
300
200
100
0
STANDING TIME (Hr)
100
200
300
400
500
600
700
800
900
1000

FIG. 22

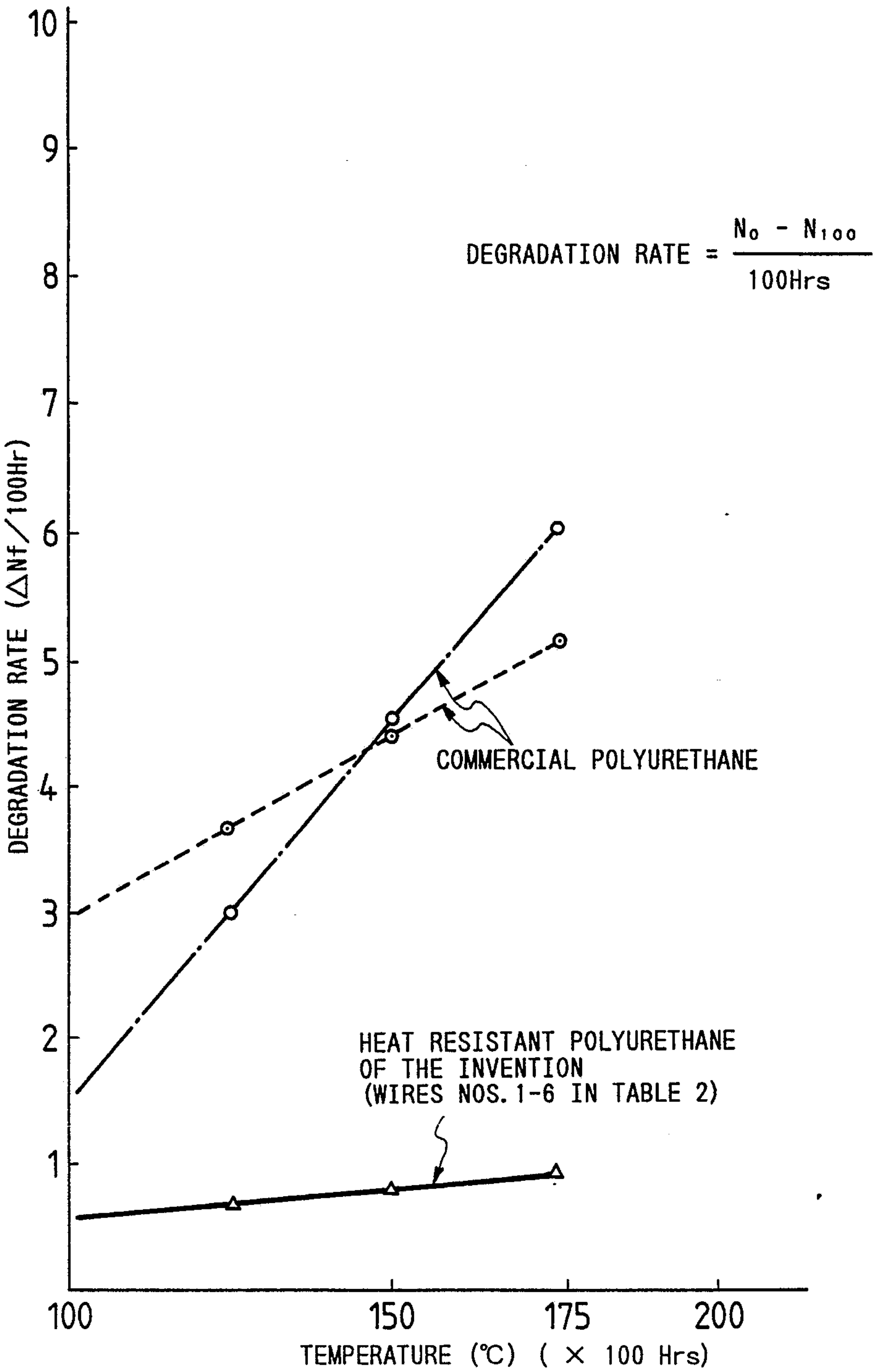
DEGRADATION RATE = (N0 - N100) / 100Hrs
DEGRADATION RATE (ΔNf/100Hr)
10
9
8
7
6
5
4
3
2
1
COMMERCIAL POLYURETHANE
HEAT RESISTANT POLYURETHANE
OF THE INVENTION
(WIRES NOS. 1-6 IN TABLE 2)
100
150
175
200
TEMPERATURE (℃) ( × 100 Hrs)

FIG. 23

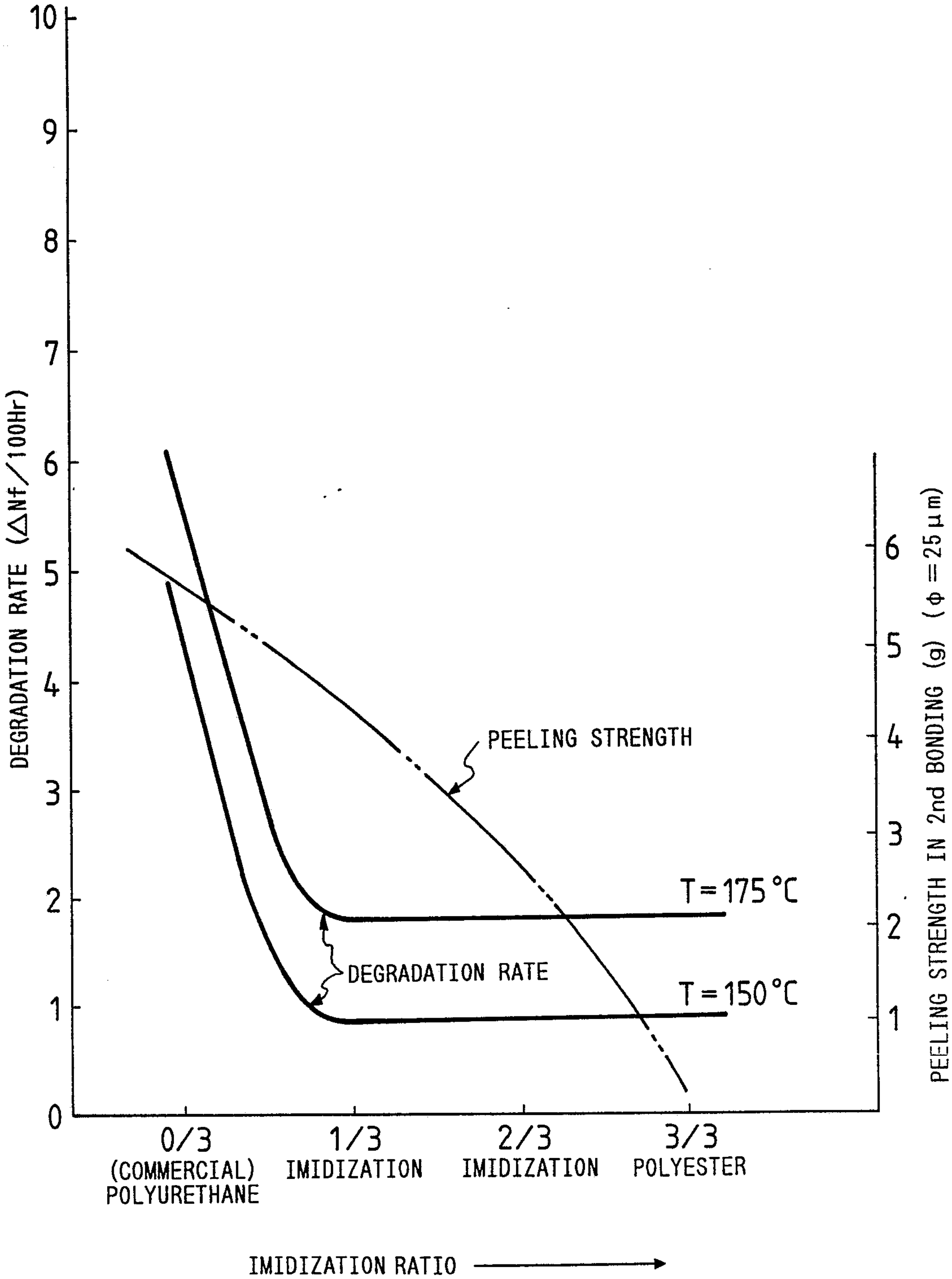
10
9
8
7
6
5
4
3
2
1
0
DEGRADATION RATE (△Nf/100Hr)
PEELING STRENGTH
T=175°C
T=150°C
DEGRADATION RATE
6
5
4
3
2
1
PEELING STRENGTH IN 2nd BONDING (g) (φ=25μm)
0/3
(COMMERCIAL)
POLYURETHANE
1/3
IMIDIZATION
2/3
IMIDIZATION
3/3
POLYESTER
IMIDIZATION RATIO

FIG. 24

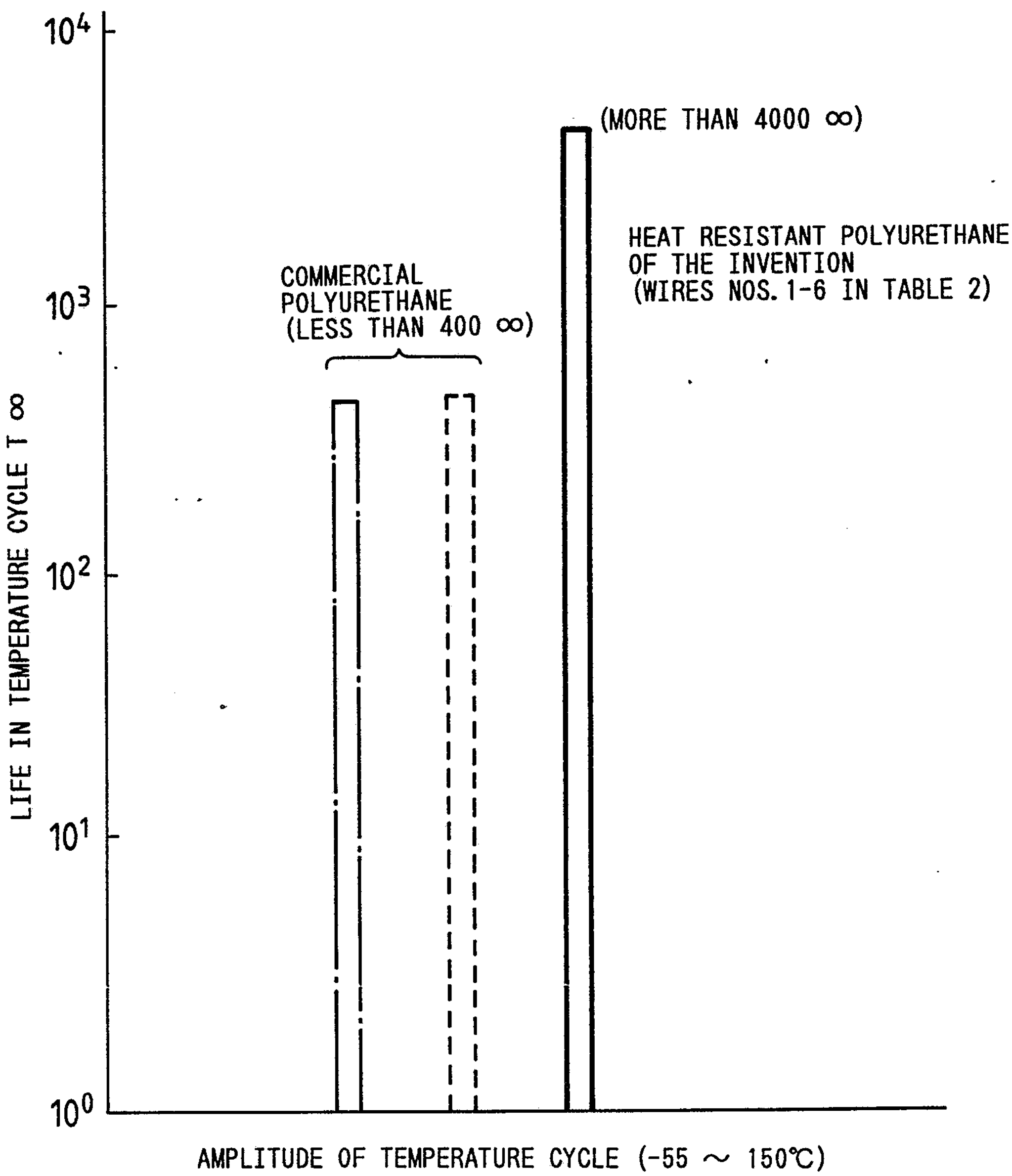
$10^4$
$10^3$
$10^2$
$10^1$
$10^0$
LIFE IN TEMPERATURE CYCLE T ∞
(MORE THAN 4000 ∞)
HEAT RESISTANT POLYURETHANE
OF THE INVENTION
(WIRES NOS. 1-6 IN TABLE 2)
COMMERCIAL
POLYURETHANE
(LESS THAN 400 ∞)
AMPLITUDE OF TEMPERATURE CYCLE (-55 ~ 150℃)

FIG. 25

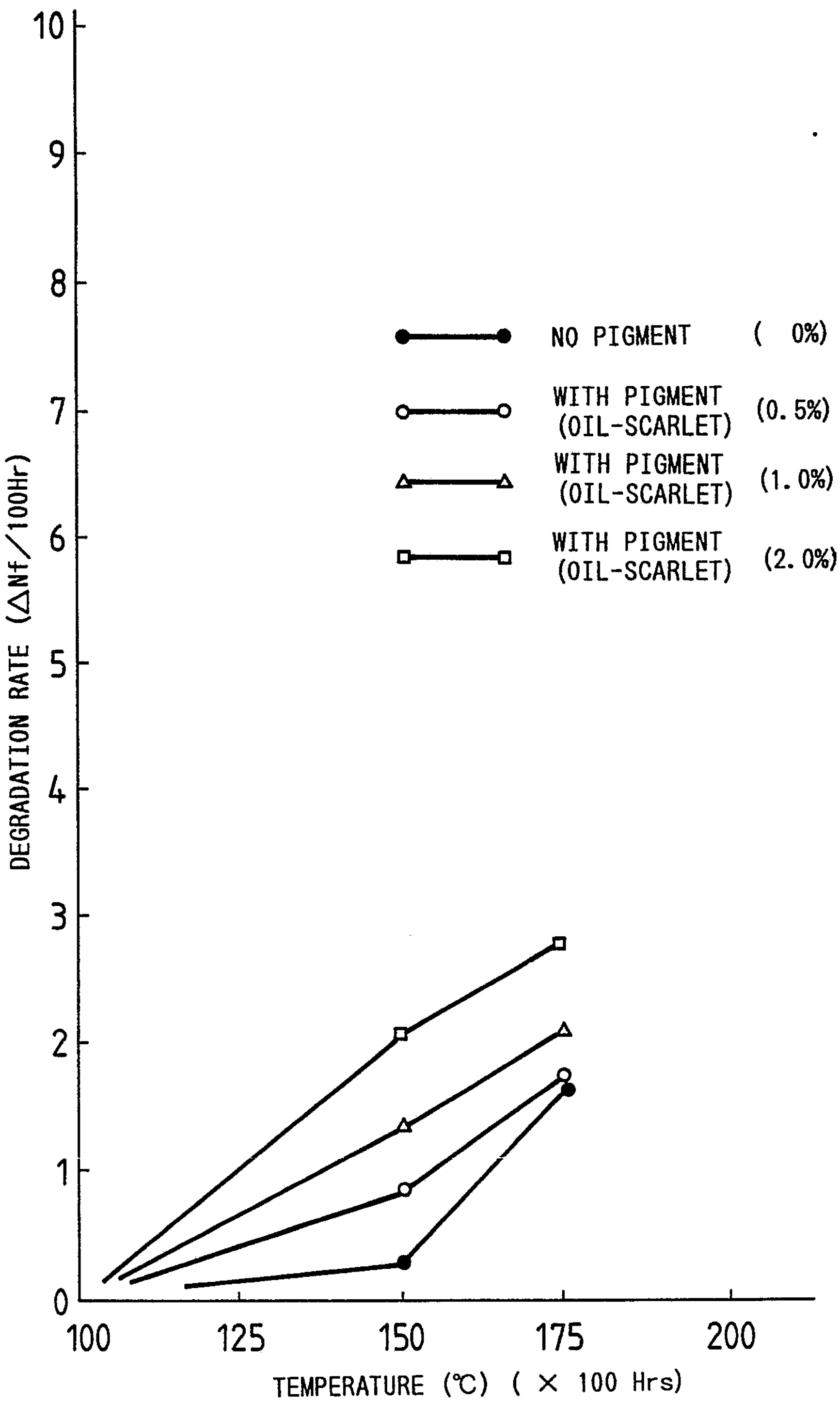
10
9
8
7
6
5
4
3
2
1
0
DEGRADATION RATE (△Nf/100Hr)
NO PIGMENT ( 0%)
WITH PIGMENT (OIL-SCARLET) (0.5%)
WITH PIGMENT (OIL-SCARLET) (1.0%)
WITH PIGMENT (OIL-SCARLET) (2.0%)
100
125
150
175
200
TEMPERATURE (℃) ( × 100 Hrs)

FIG. 26

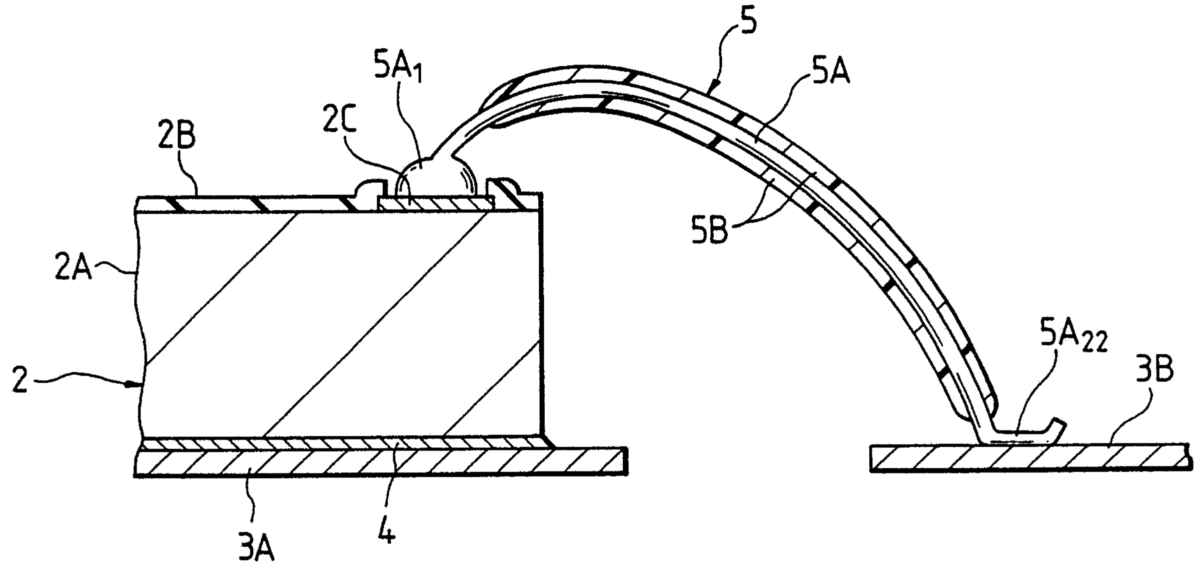


FIG. 27

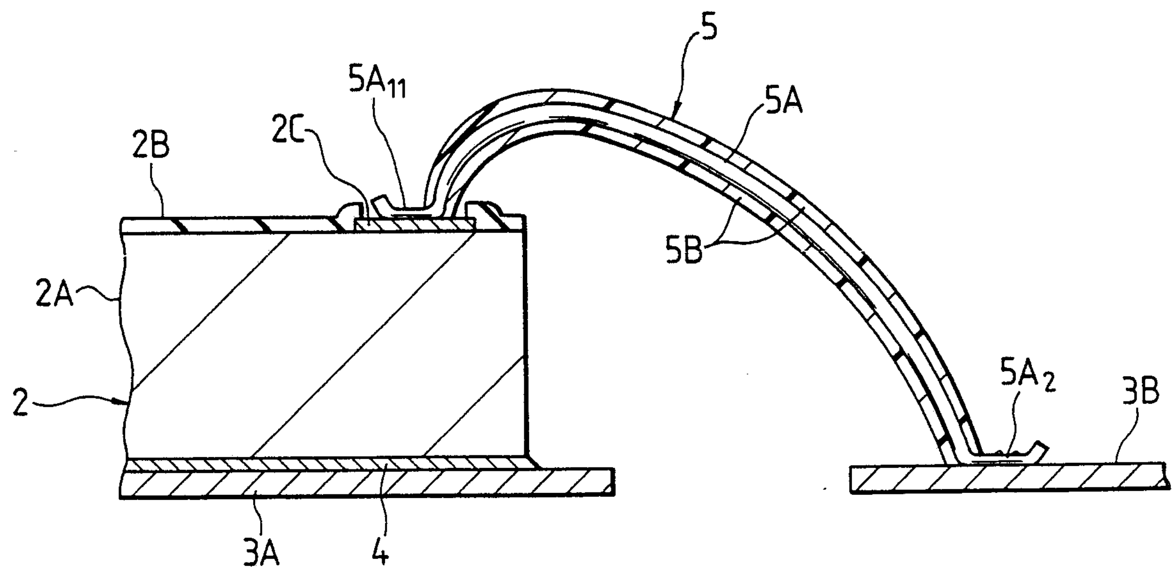

FIG. 28

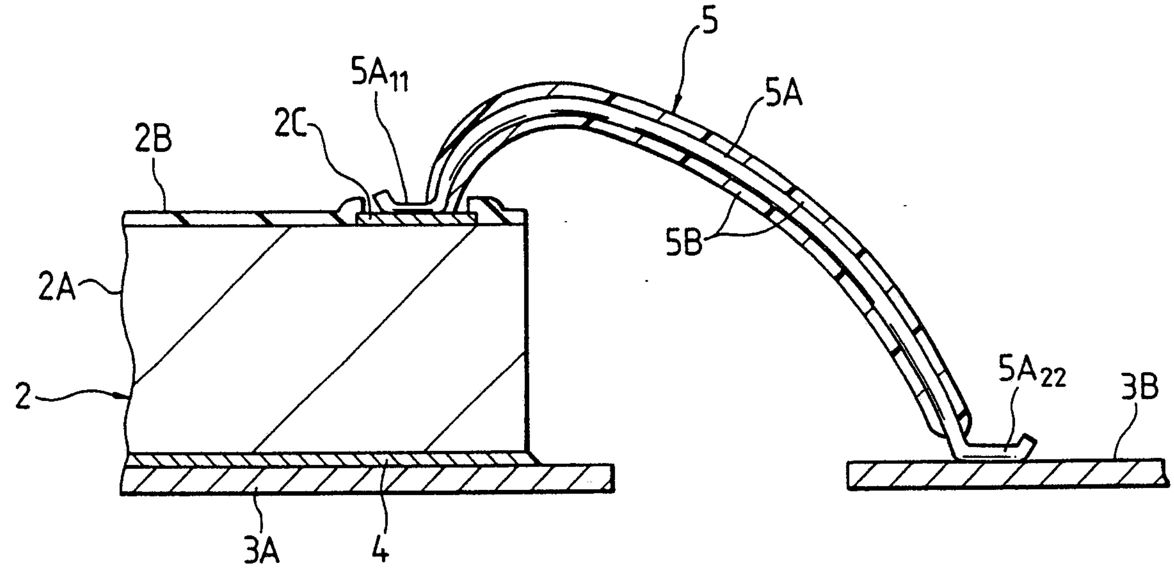


FIG. 29

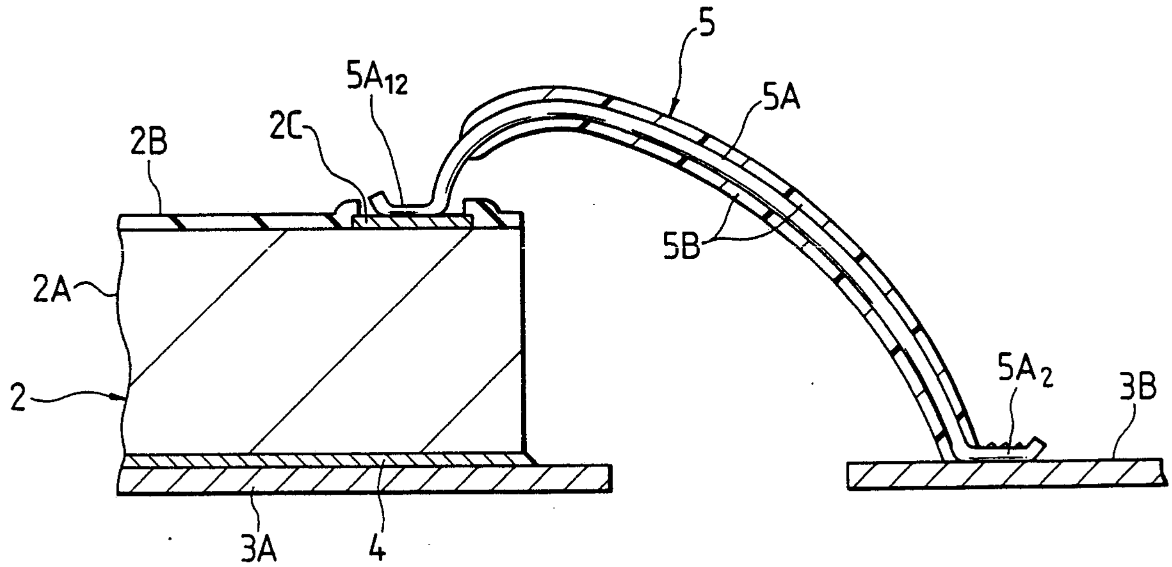

FIG. 30

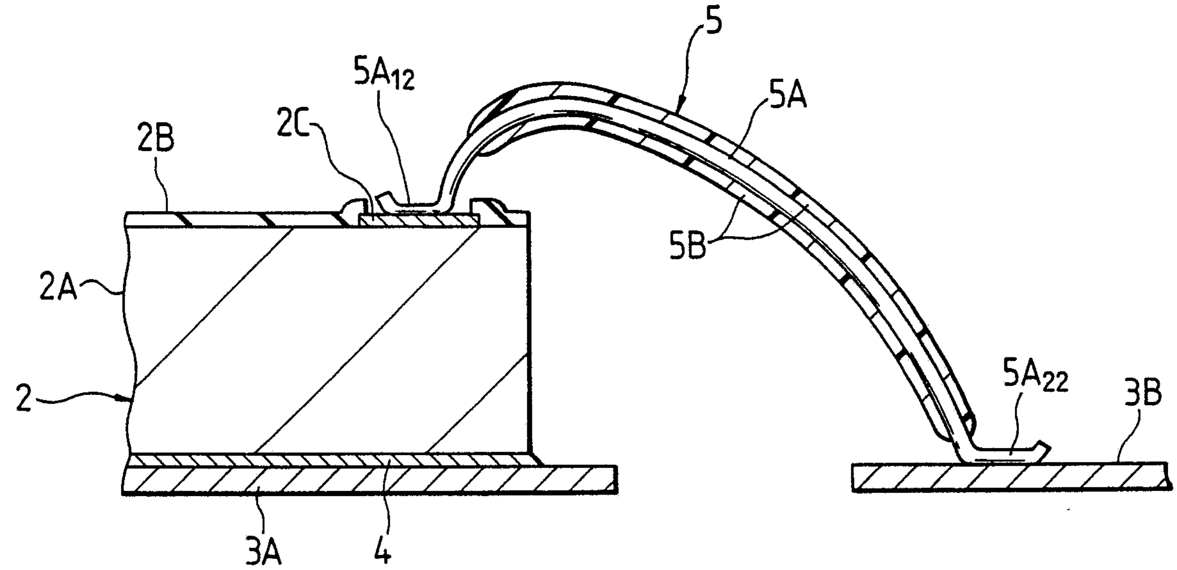
5
5A$_{12}$
5A
2C
2B
5B
2A
5A$_{22}$
3B
2
3A
4

FIG. 31

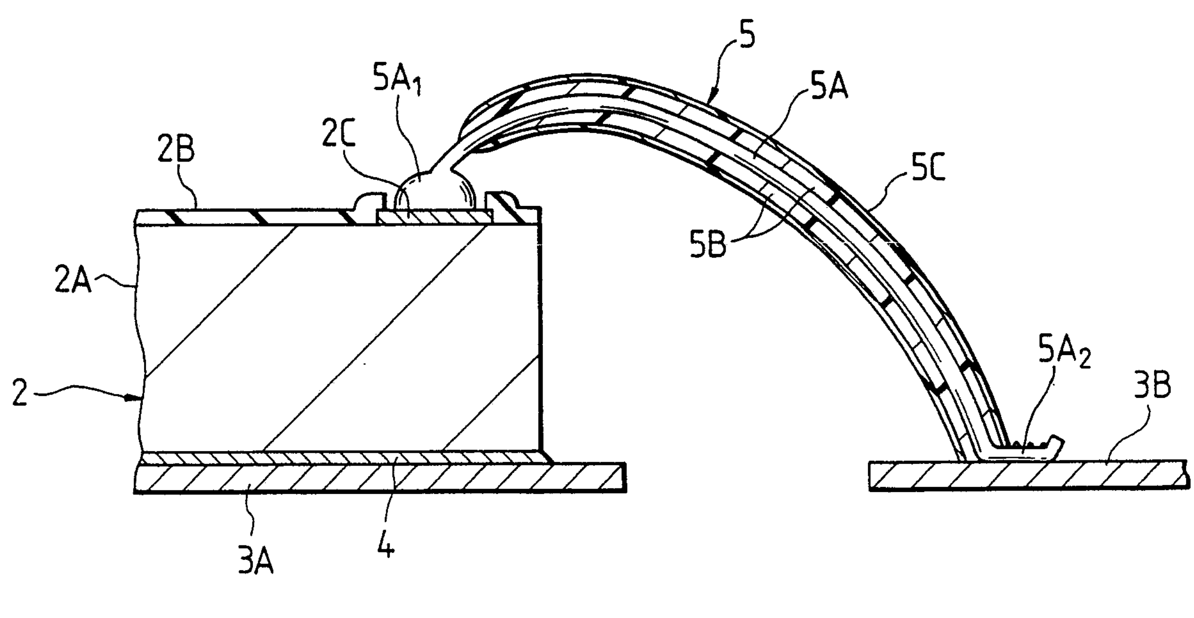
5
5A$_1$
5A
2B
2C
5C
5B
2A
5A$_2$
3B
2
3A
4

FIG. 32

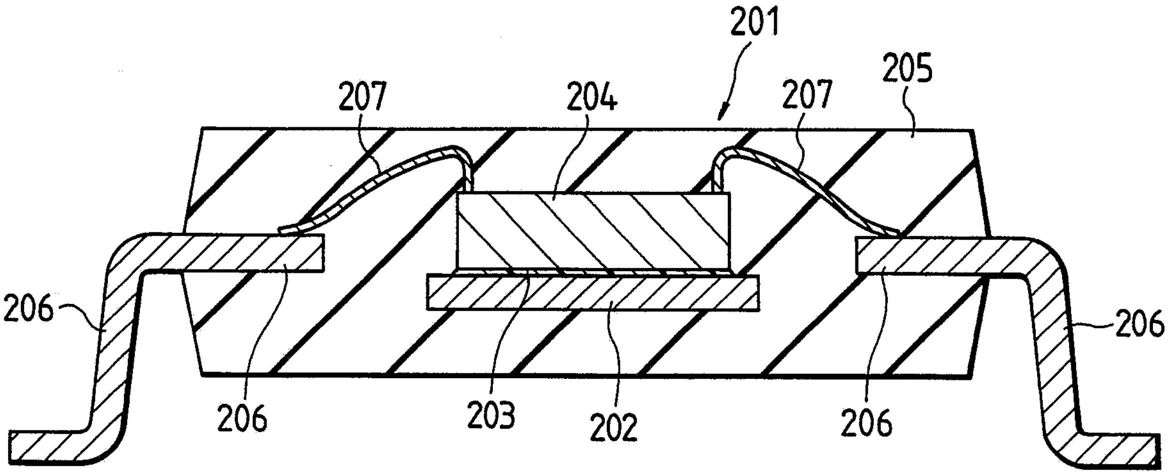
201
205
207
204
207
206
206
206
206
203
202

FIG. 33

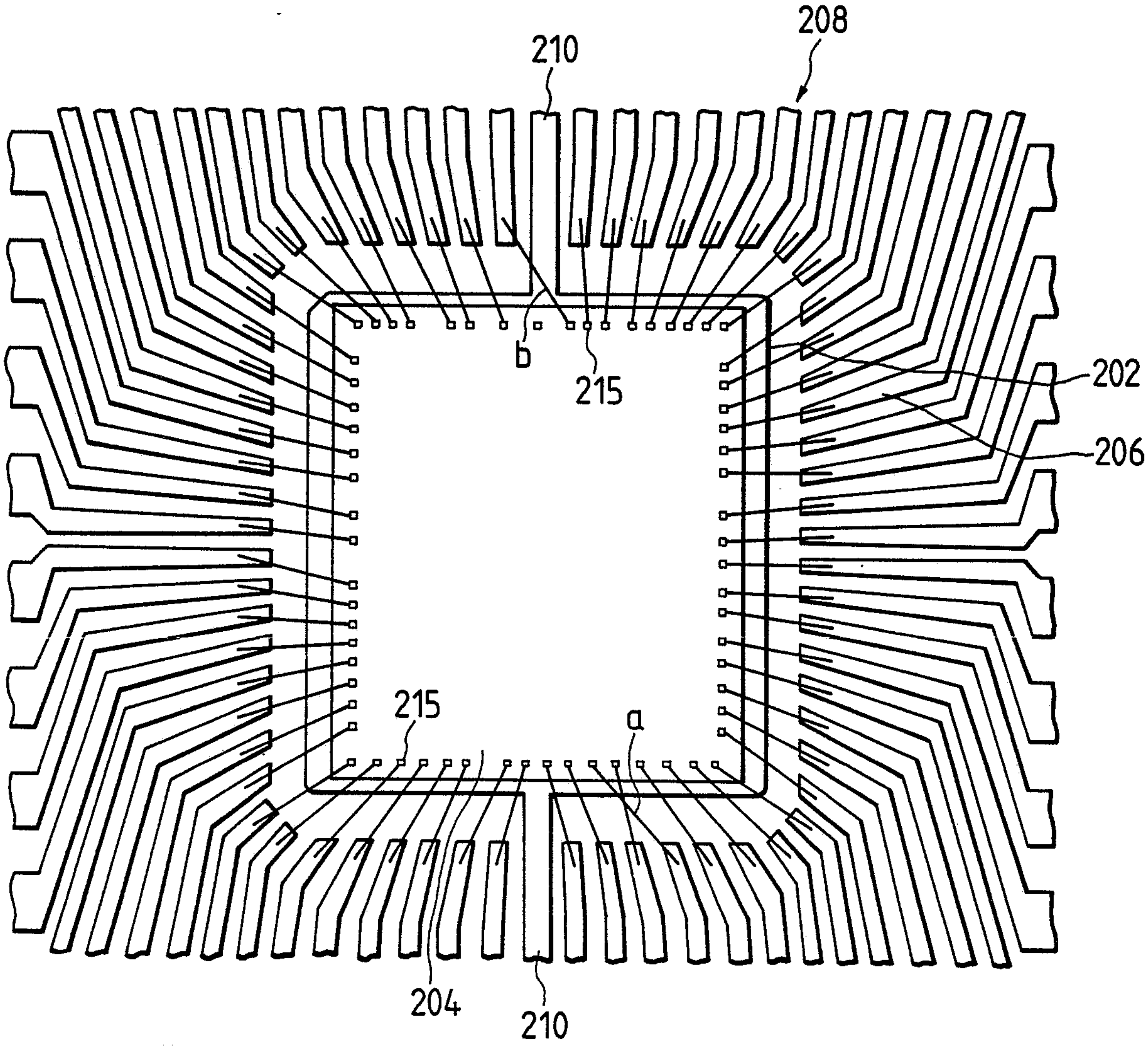
208
210
b
215
202
206
215
a
204
210

FIG. 34

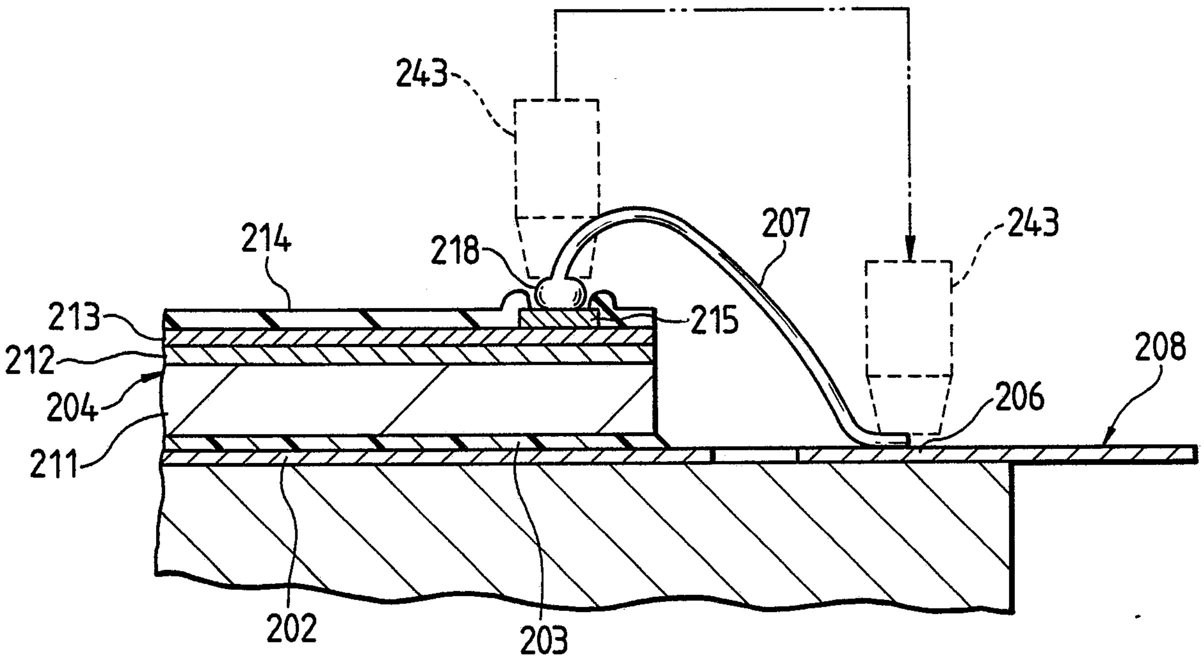
243
243
214
218
207
213
215
208
212
204
206
211
202
203

FIG. 35

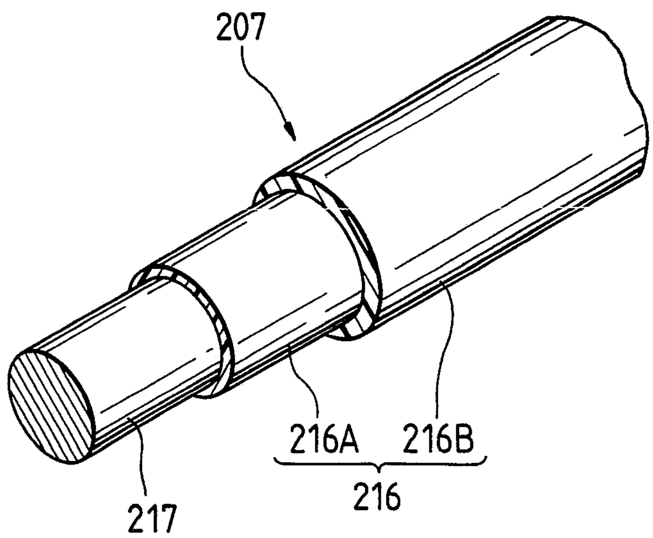
207
216A
216B
216
217

FIG. 36

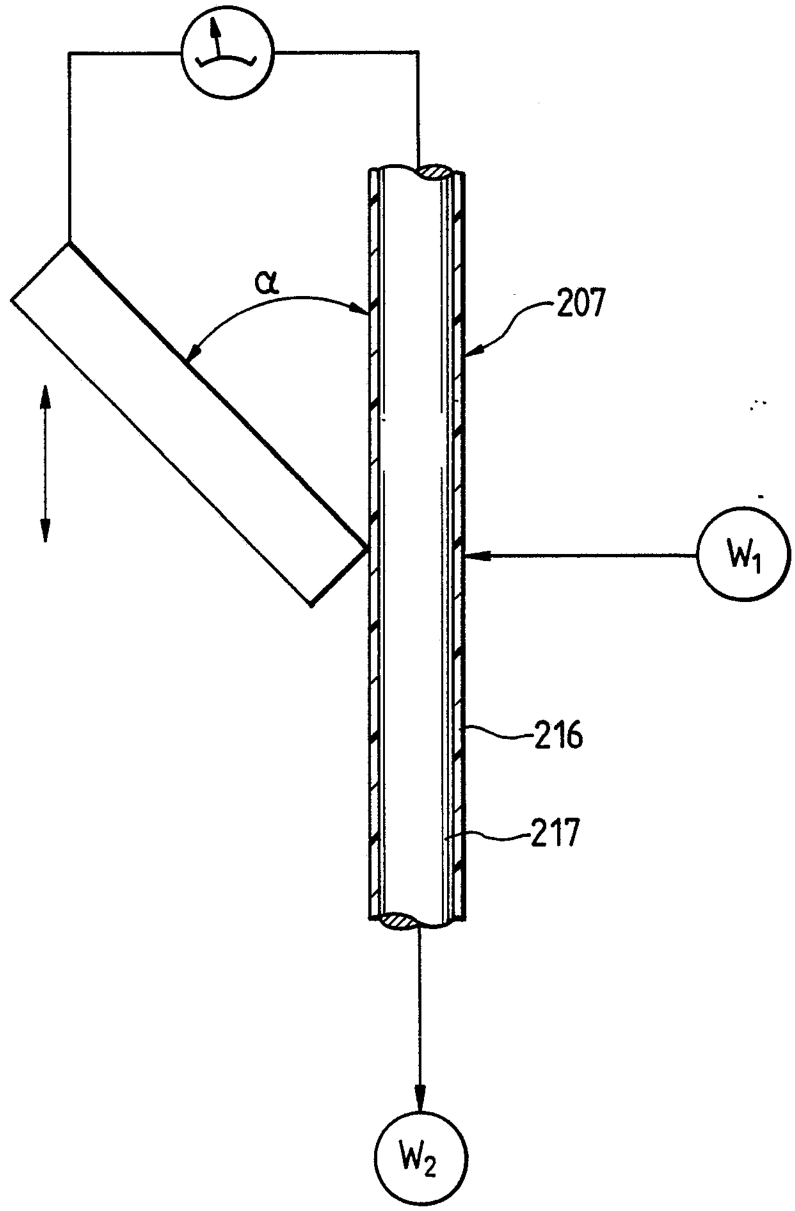

FIG. 37

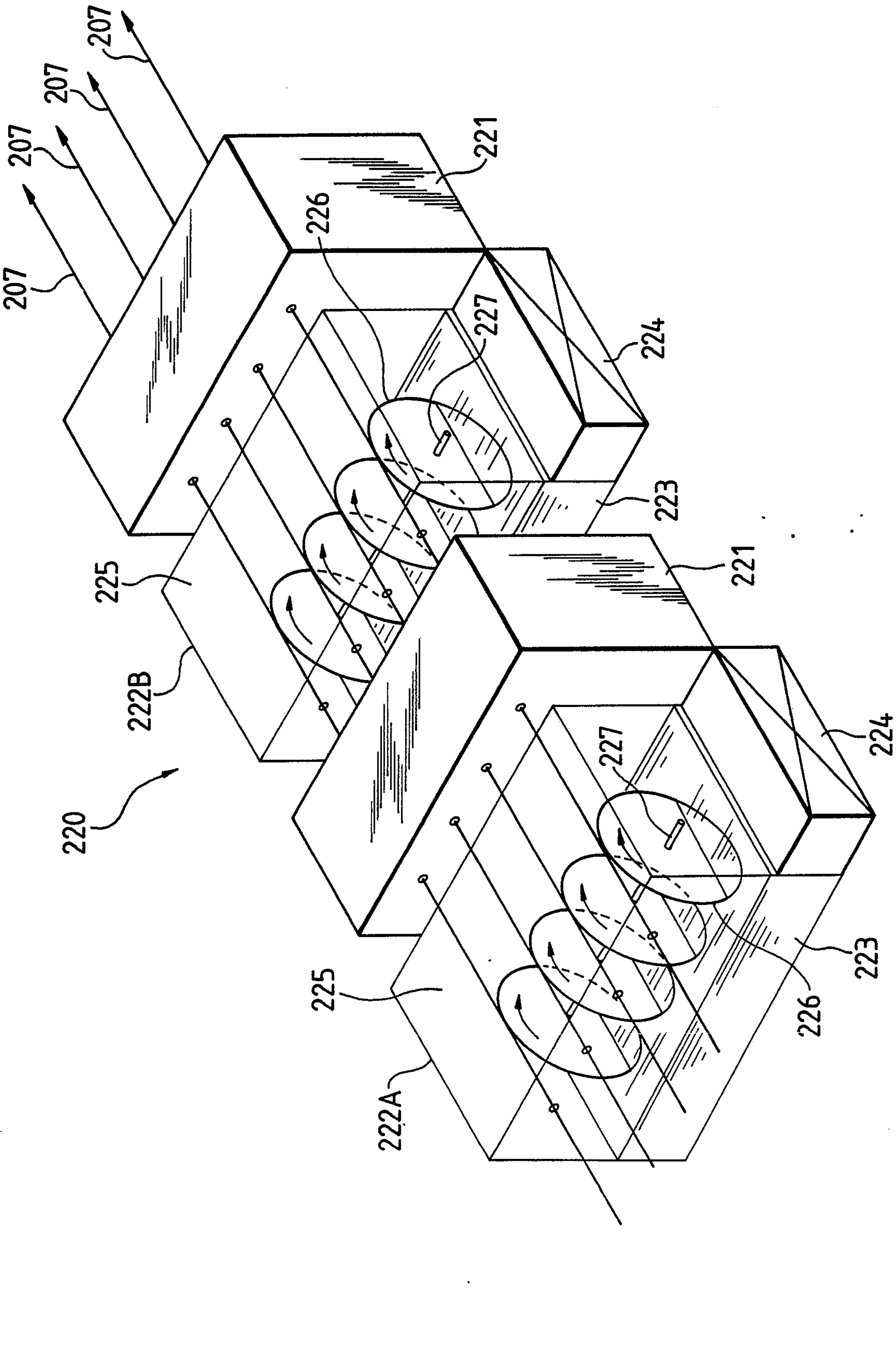
207
207
207
207
207
221
226
227
224
223
225
222B
220
221
224
227
225
223
226
222A

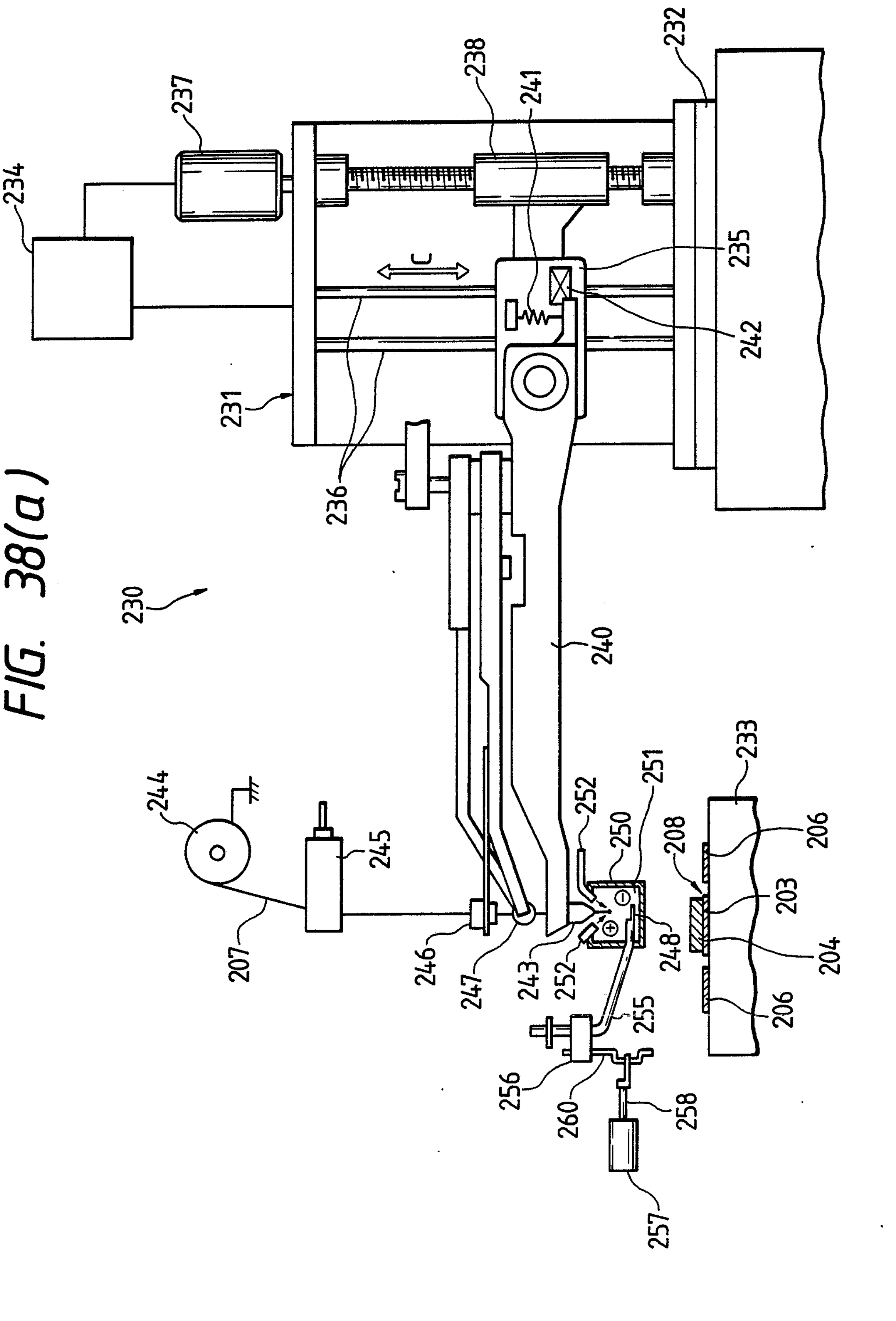
230
231
232
233
234
235
236
237
238
240
241
242
243
244
245
246
247
248
250
251
252
255
256
257
258
260
203
204
206
207
208
C

FIG. 38(a)

FIG. 39

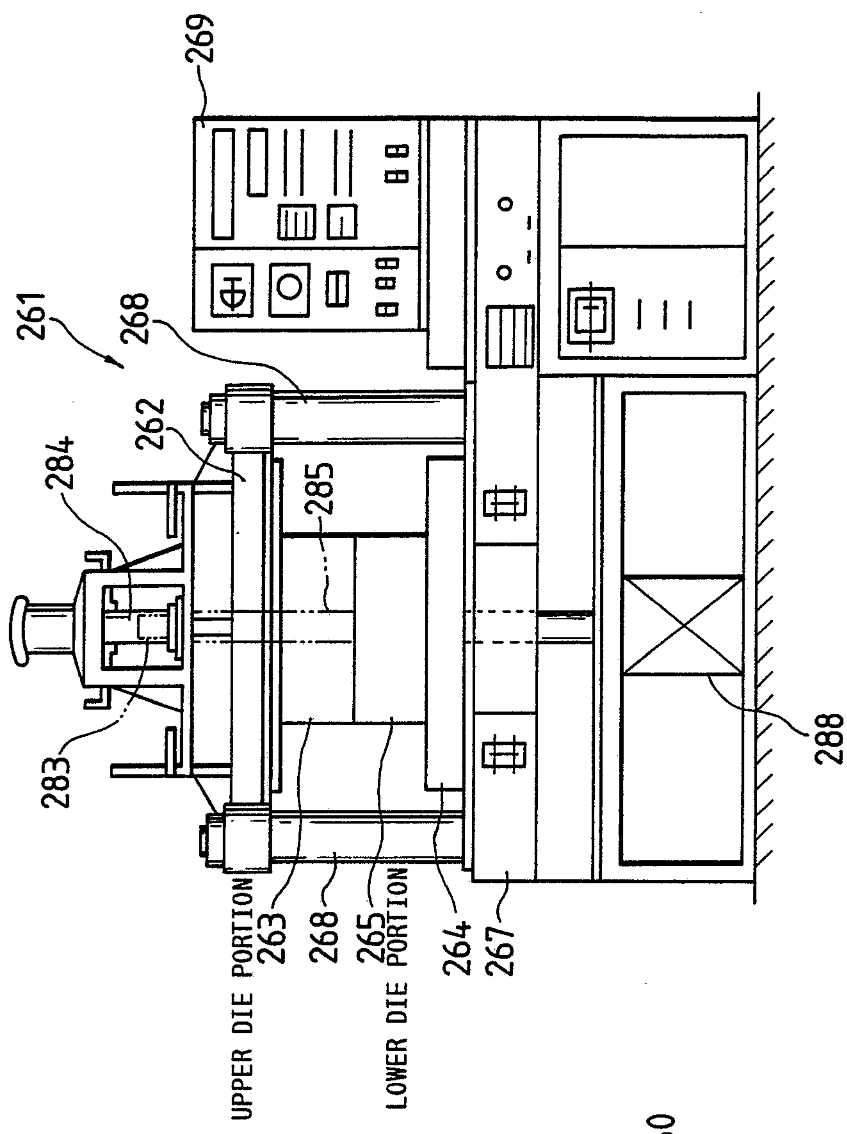


FIG. 38(b)

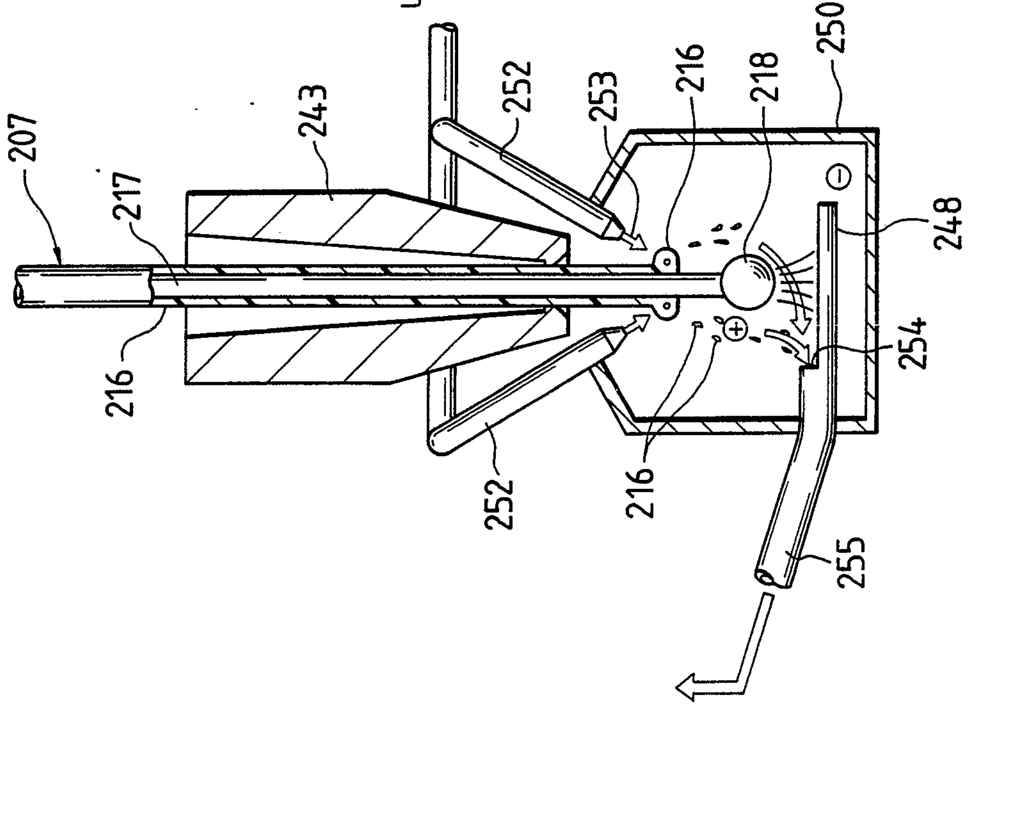

FIG. 40

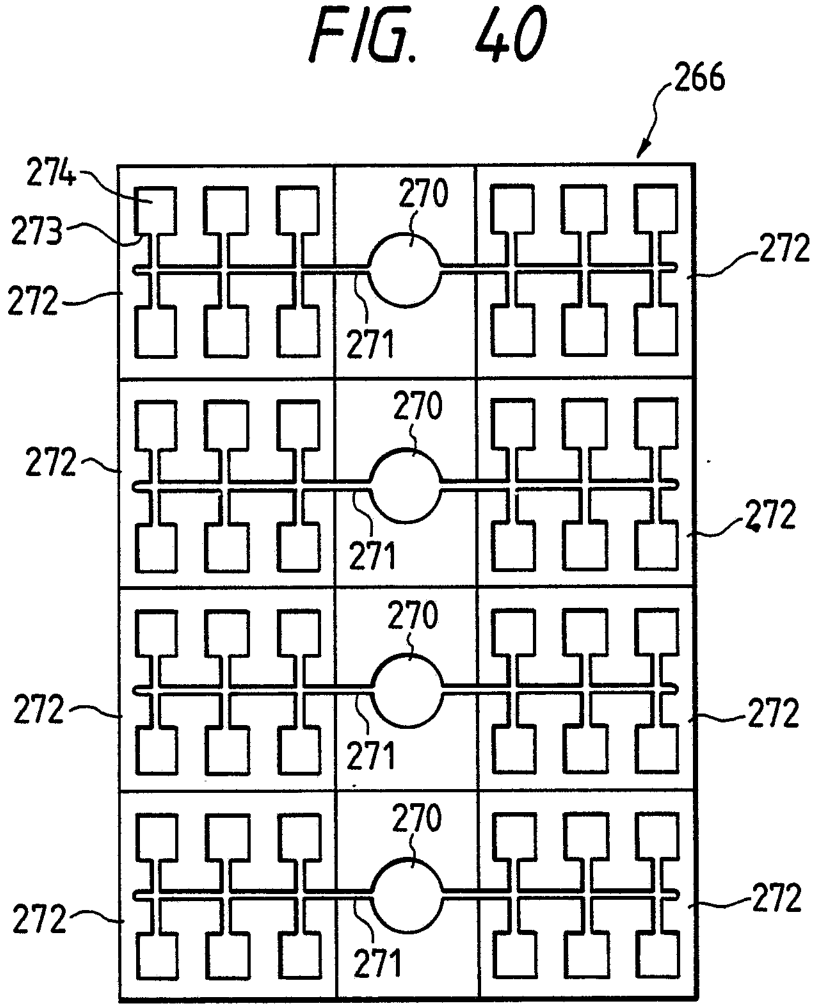
266
274
273
272
270
271
272
270
271
272
272
270
271
272
272
270
271
272

FIG. 41

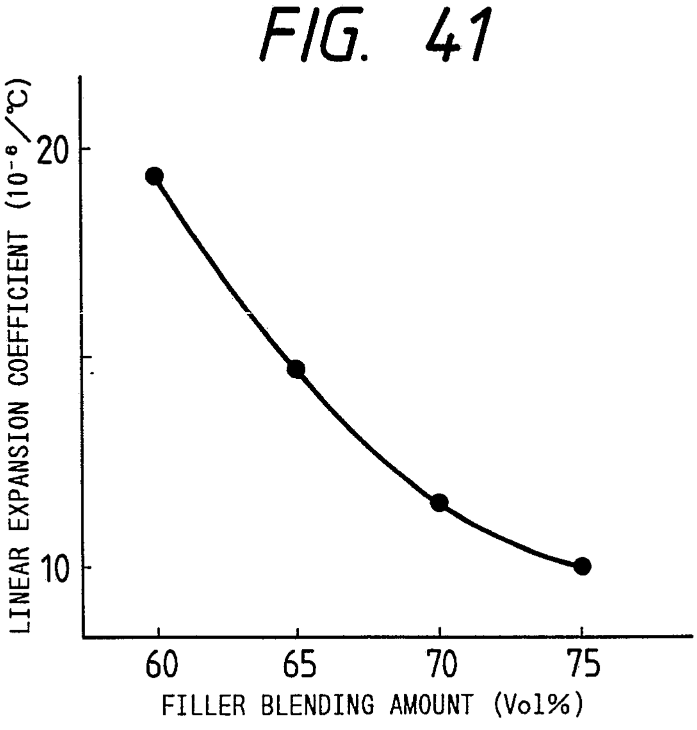
LINEAR EXPANSION COEFFICIENT ($10^{-6}$/°C)
20
10
60
65
70
75
FILLER BLENDING AMOUNT (Vol%)

FIG. 42

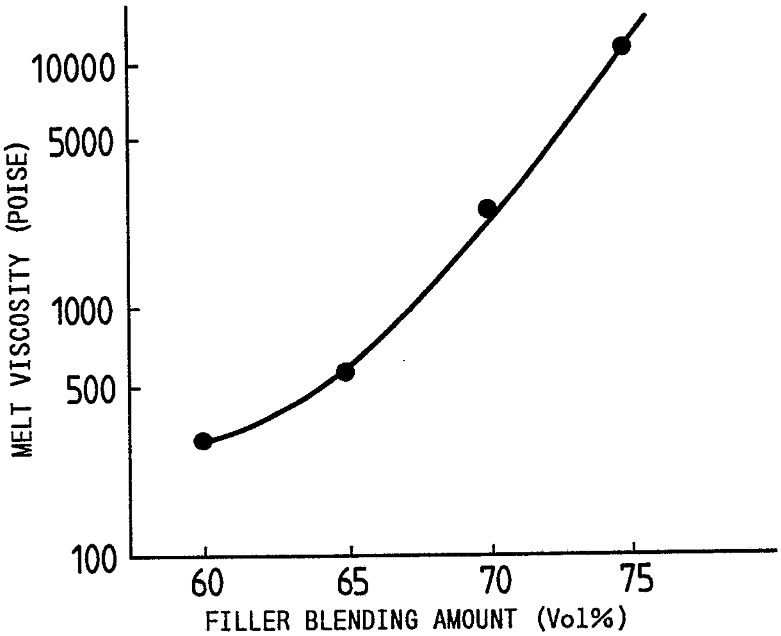

MELT VISCOSITY (POISE)
10000
5000
1000
500
100
60
65
70
75
FILLER BLENDING AMOUNT (Vol%)


FIG. 43

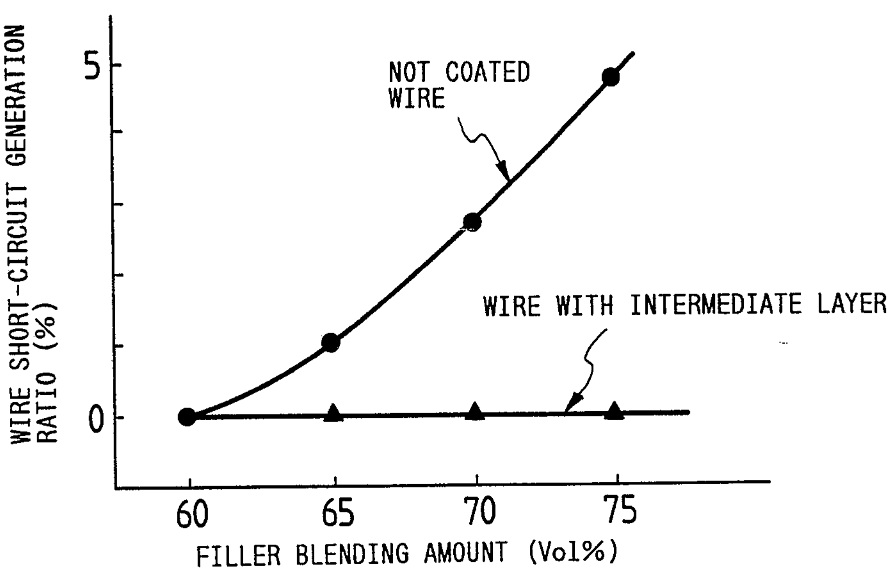

WIRE SHORT-CIRCUIT GENERATION RATIO (%)
5
0
NOT COATED WIRE
WIRE WITH INTERMEDIATE LAYER
60
65
70
75
FILLER BLENDING AMOUNT (Vol%)

FIG. 44

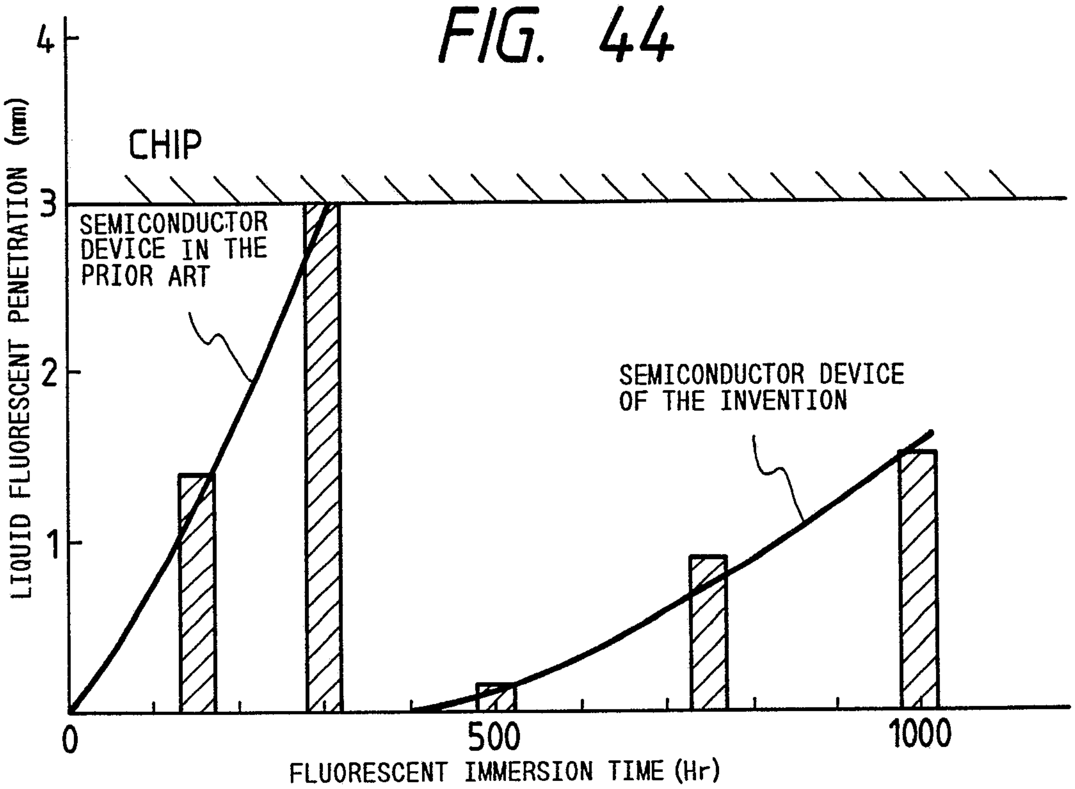
LIQUID FLUORESCENT PENETRATION (mm)
4
3
2
1
0
CHIP
SEMICONDUCTOR DEVICE IN THE PRIOR ART
SEMICONDUCTOR DEVICE OF THE INVENTION
500
1000
FLUORESCENT IMMERSION TIME (Hr)

FIG. 45

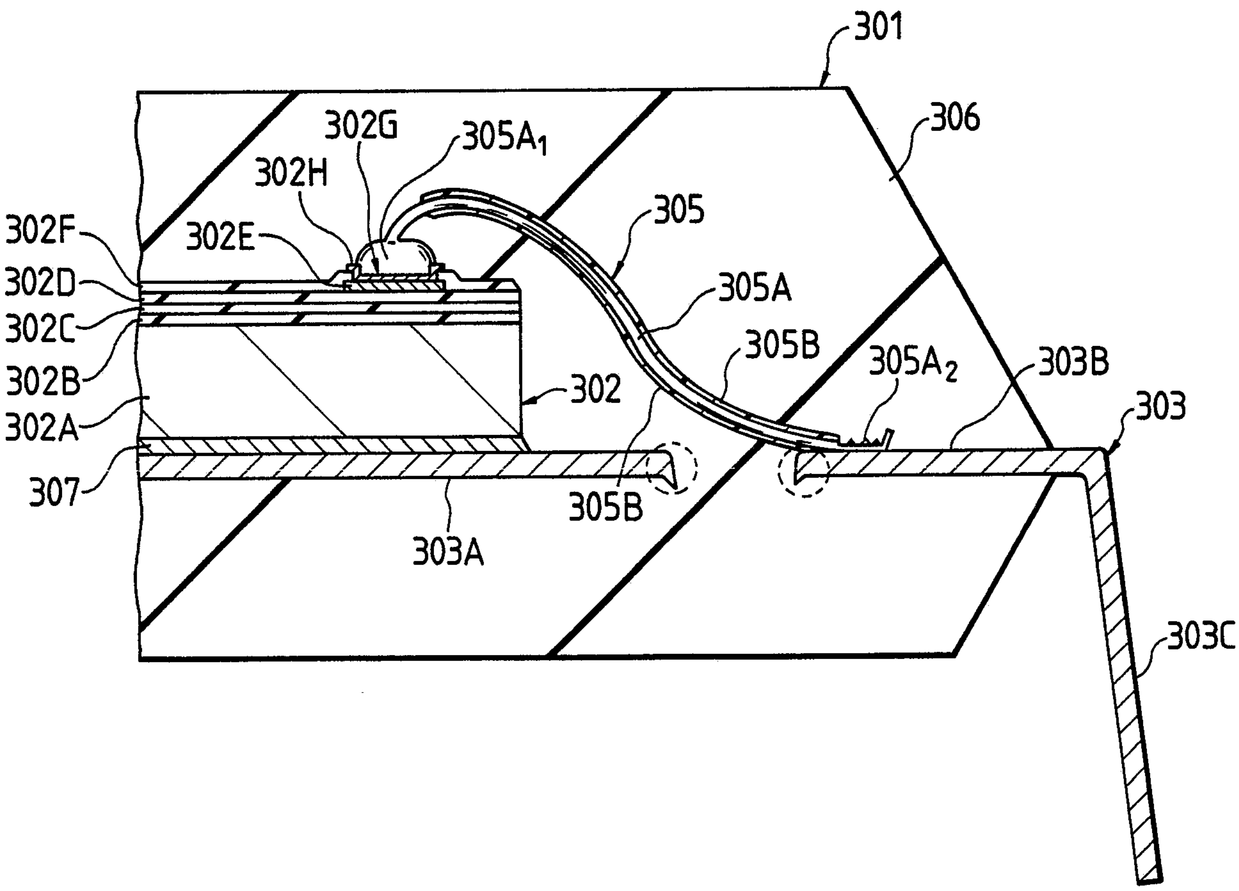
301
306
302G
$305A_1$
302H
305
302F
302E
302D
305A
302C
305B
$305A_2$
303B
302B
302
303
302A
307
305B
303A
303C

FIG. 46

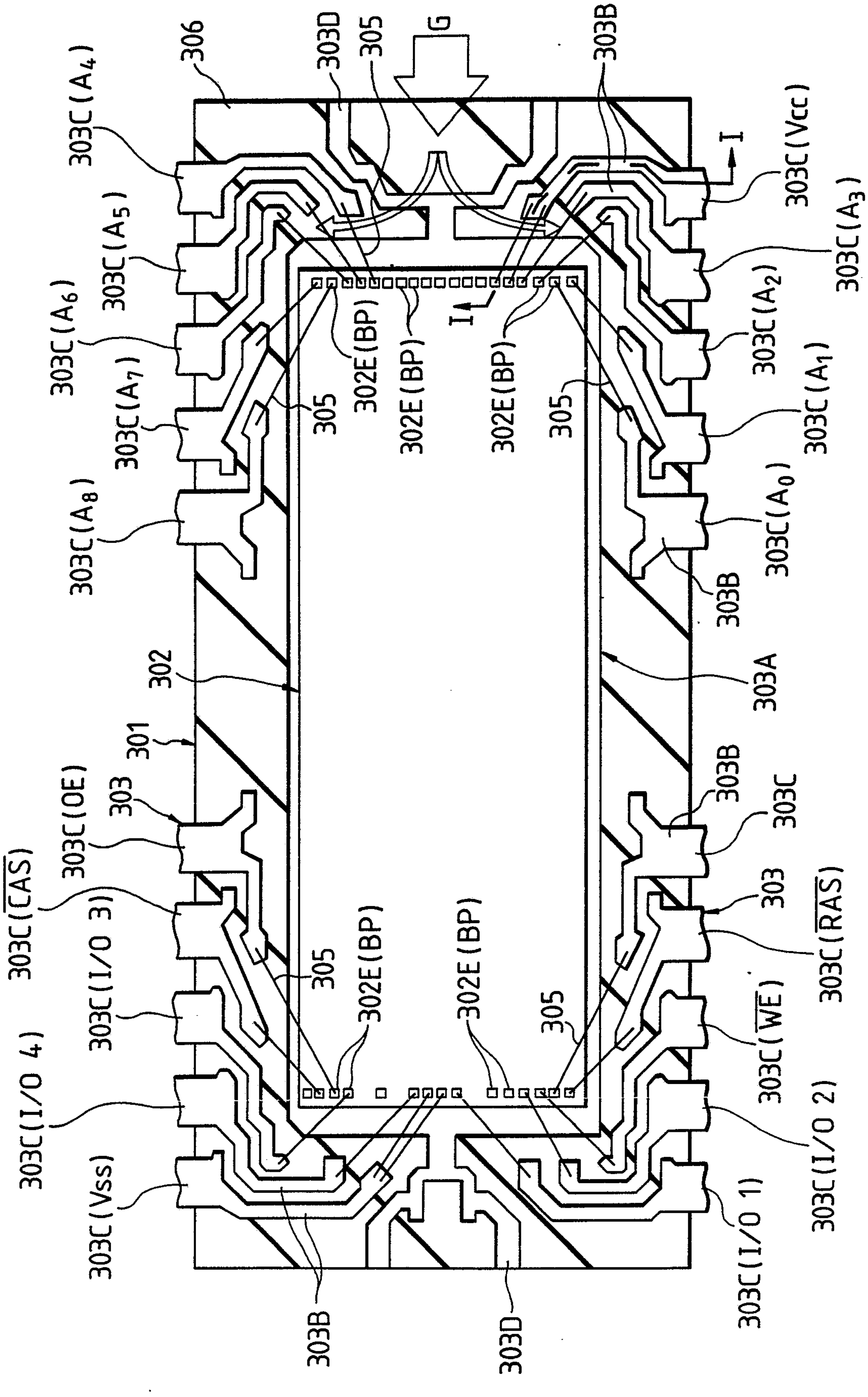
G
306
303D
305
303B
I
303C (A4)
303C (A5)
303C (A6)
303C (A7)
303C (A8)
303C (Vcc)
303C (A3)
303C (A2)
303C (A1)
303C (A0)
302E (BP)
302E (BP)
302E (BP)
305
305
303B
302
301
303A
303
303C (OE)
303C (CAS)
303C (I/O 3)
303C (I/O 4)
303C (Vss)
303B
303C
303
303C (RAS)
303C (WE)
303C (I/O 2)
303C (I/O 1)
305
302E (BP)
302E (BP)
305
303B
303D

FIG. 47

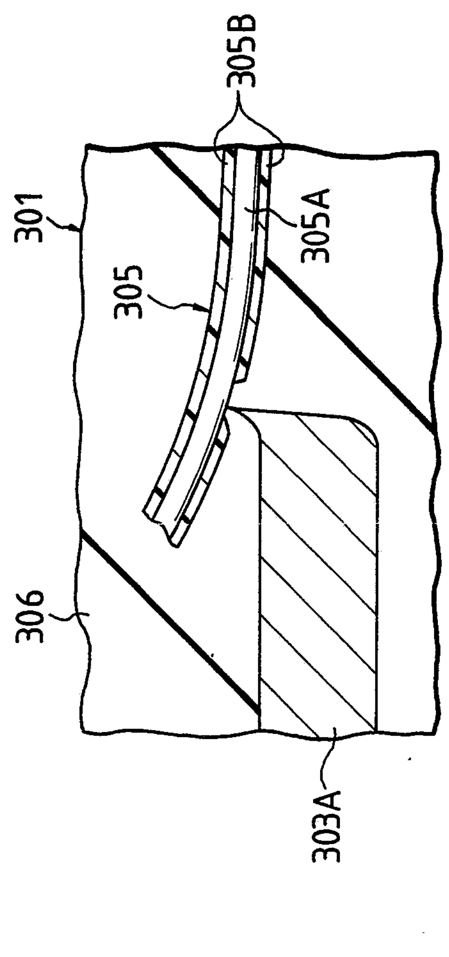


FIG. 48

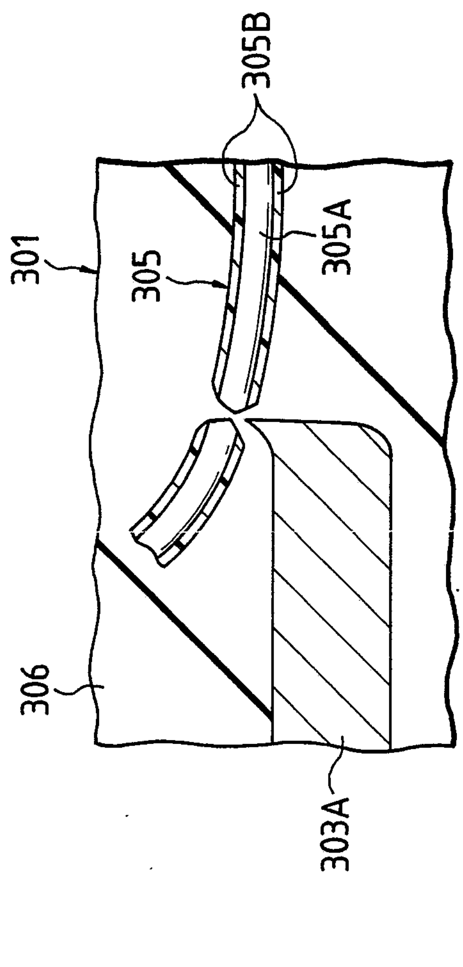


FIG. 49

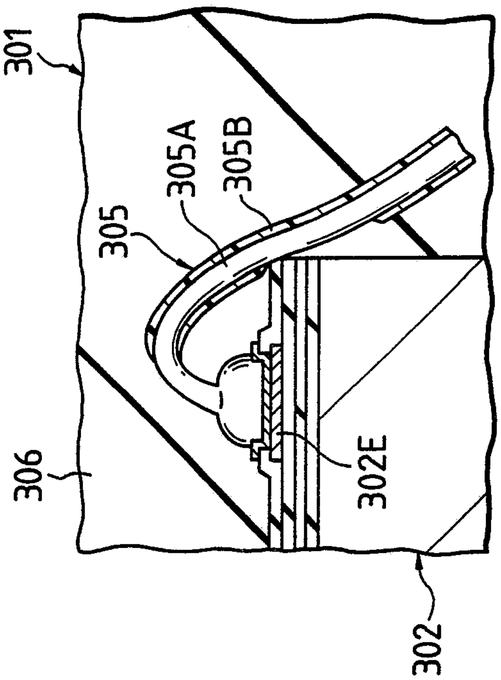


FIG. 50

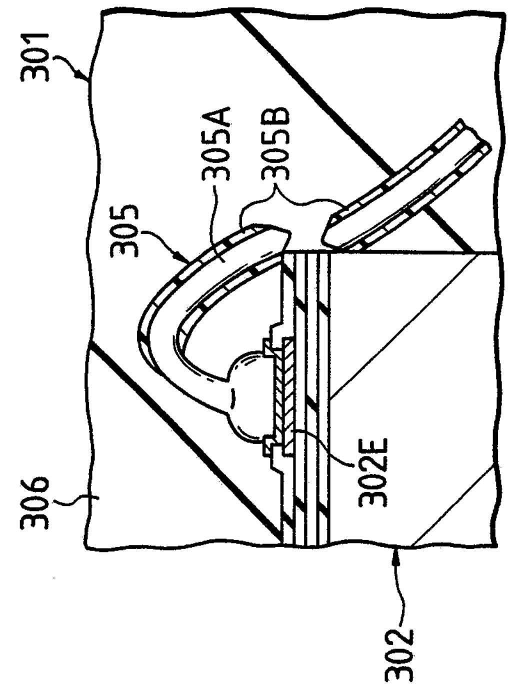

FIG. 51

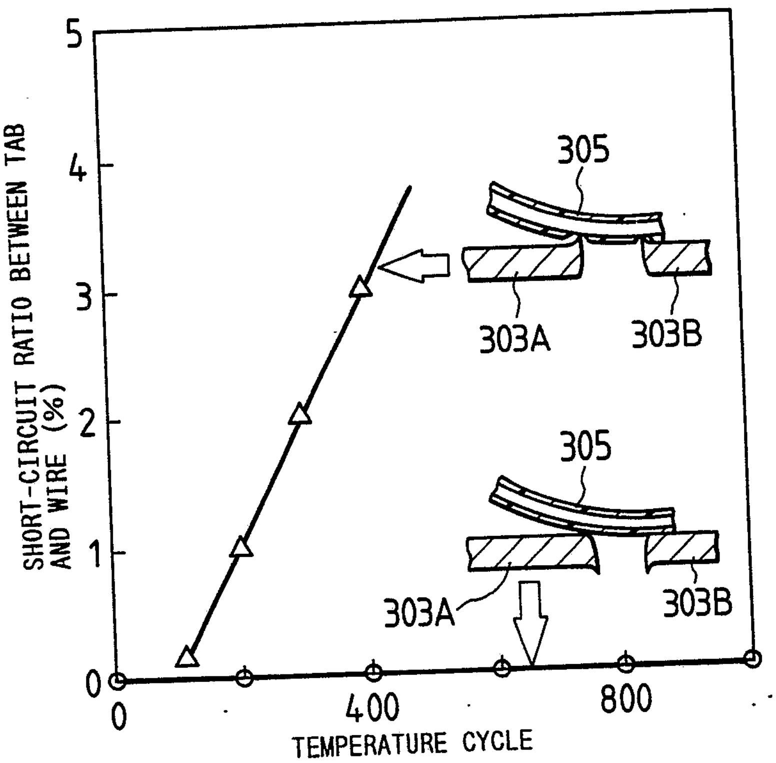
5
4
3
2
1
0
SHORT-CIRCUIT RATIO BETWEEN TAB AND WIRE (%)
305
303A
303B
305
303A
303B
0
400
800
TEMPERATURE CYCLE

FIG. 52

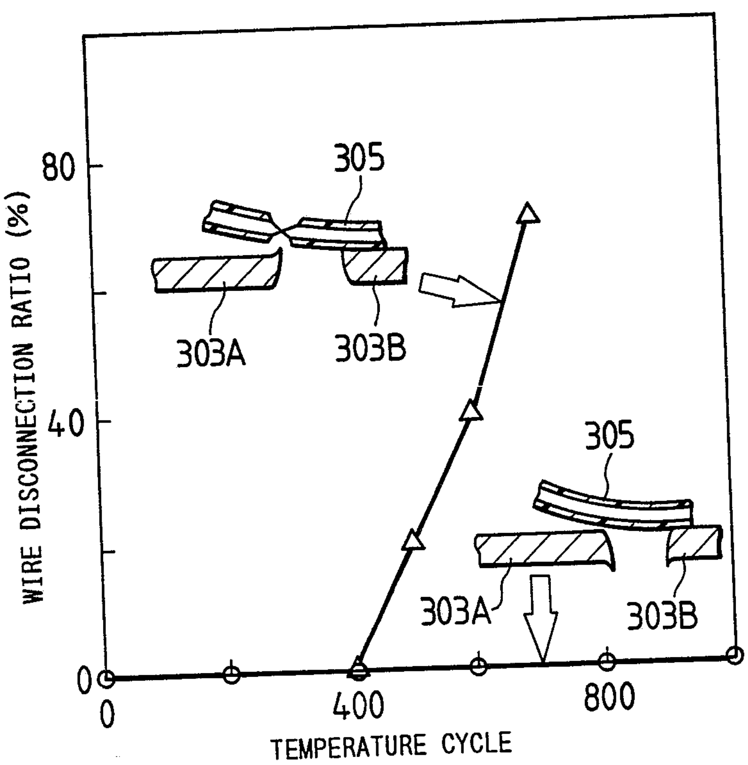
80
40
0
WIRE DISCONNECTION RATIO (%)
305
303A
303B
305
303A
303B
0
400
800
TEMPERATURE CYCLE

FIG. 53

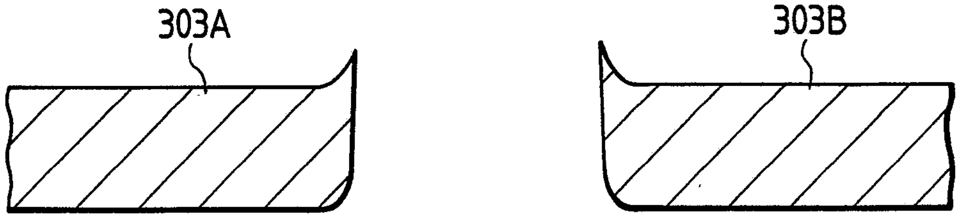


FIG. 54

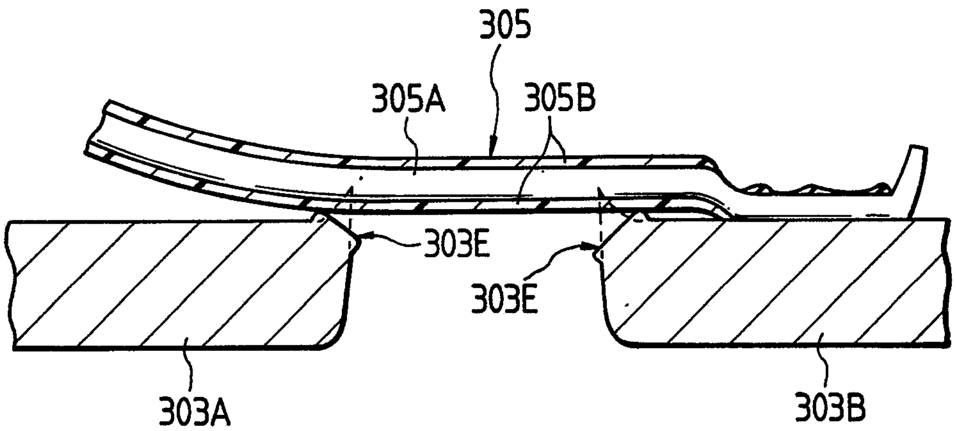


FIG. 55

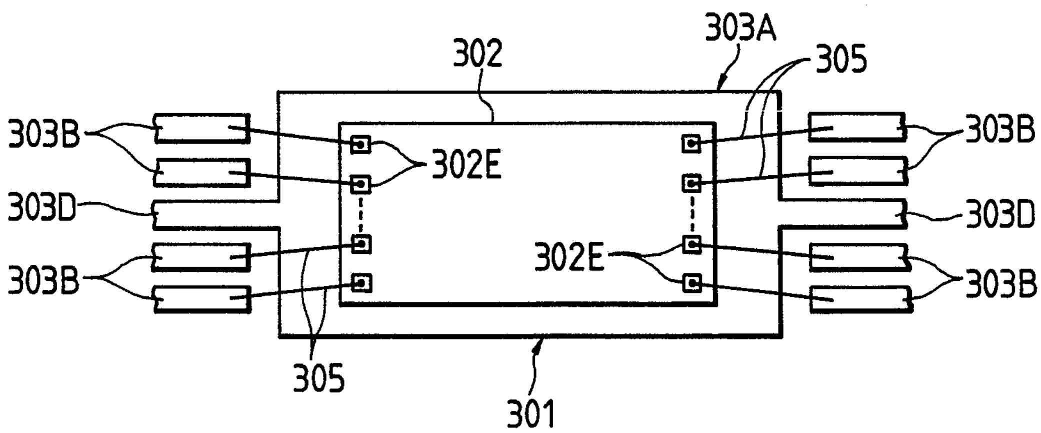

FIG. 56

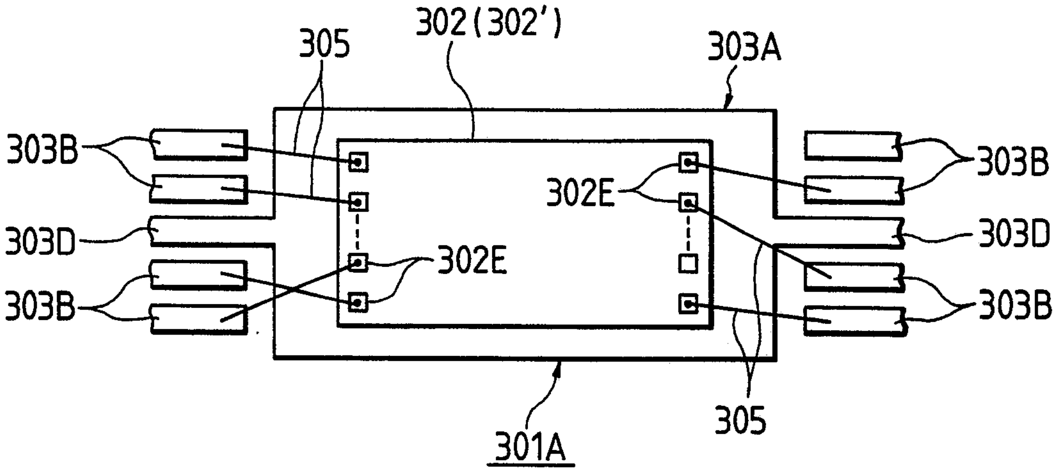
305
302(302')
303A
303B
303D
303B
302E
302E
303B
303D
303B
305
301A

FIG. 57

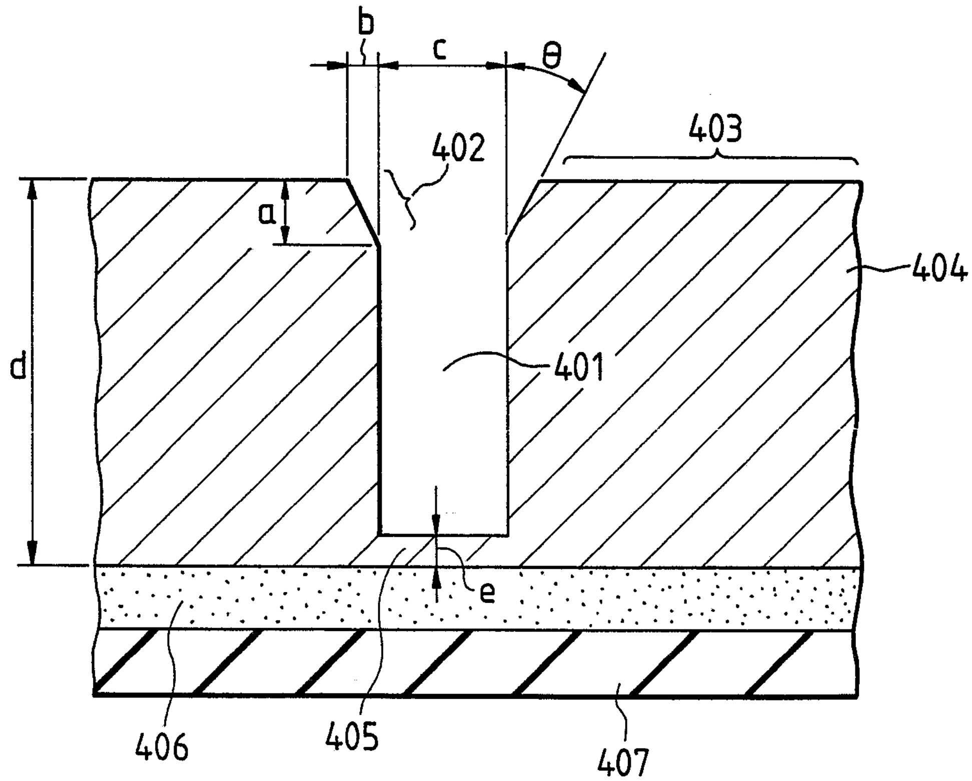
b
c
θ
403
402
a
404
d
401
e
406
405
407

FIG. 58

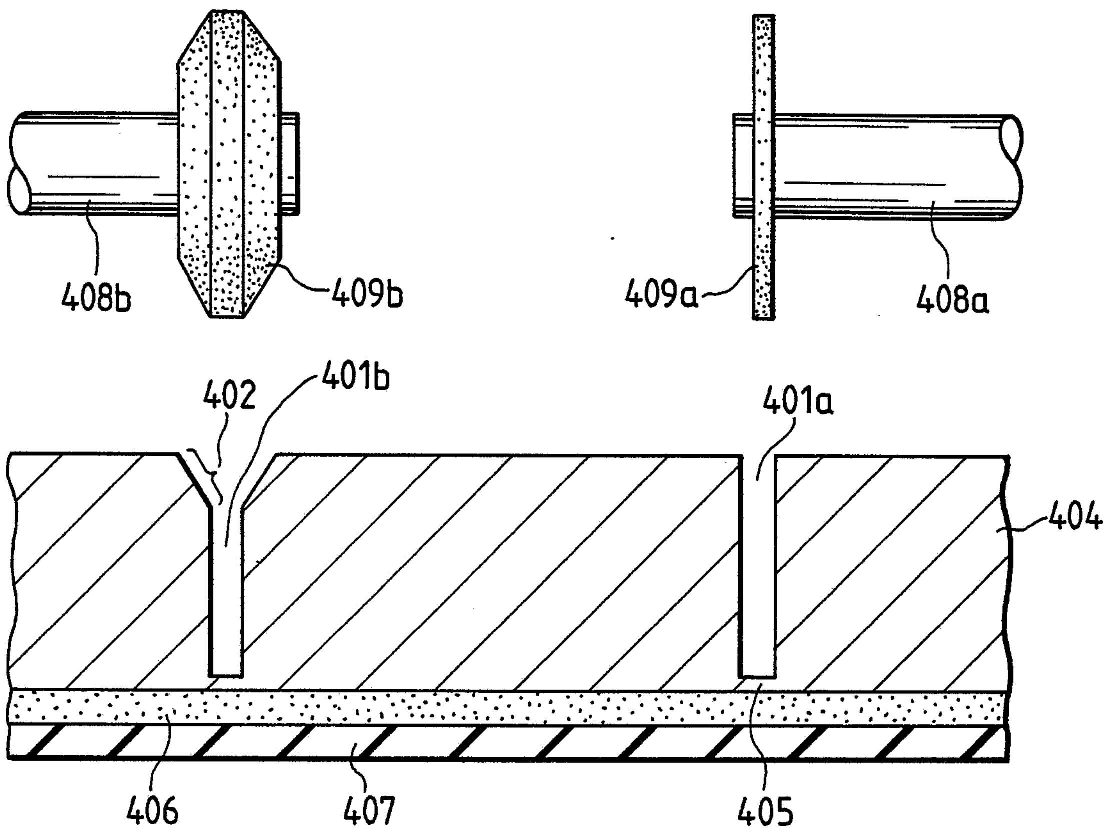


FIG. 59

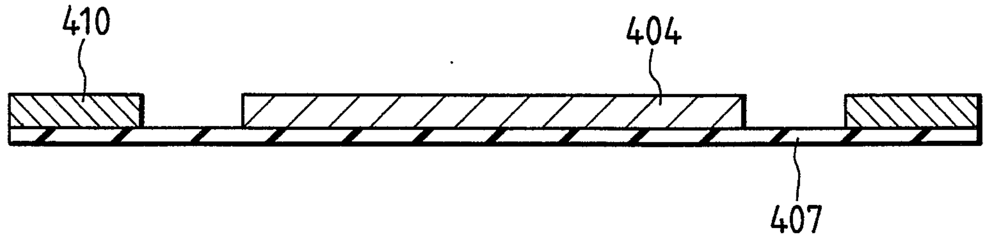

FIG. 60

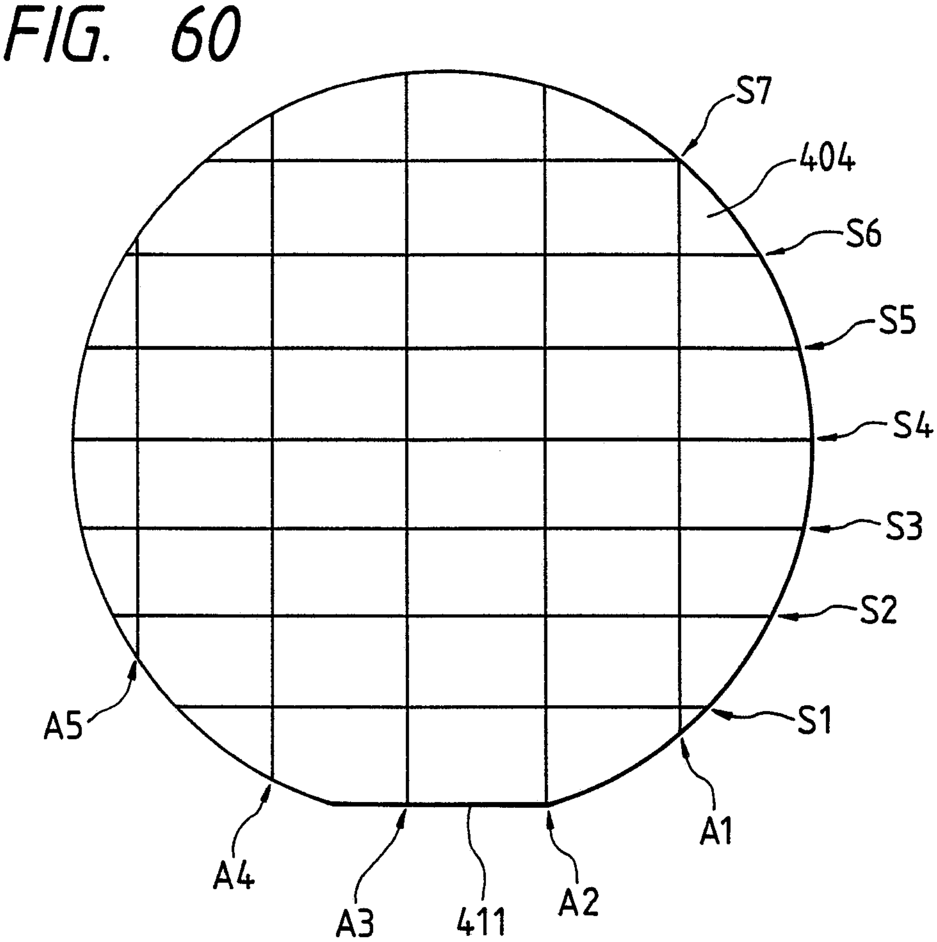
S7
404
S6
S5
S4
S3
S2
S1
A1
A2
411
A3
A4
A5

FIG. 62

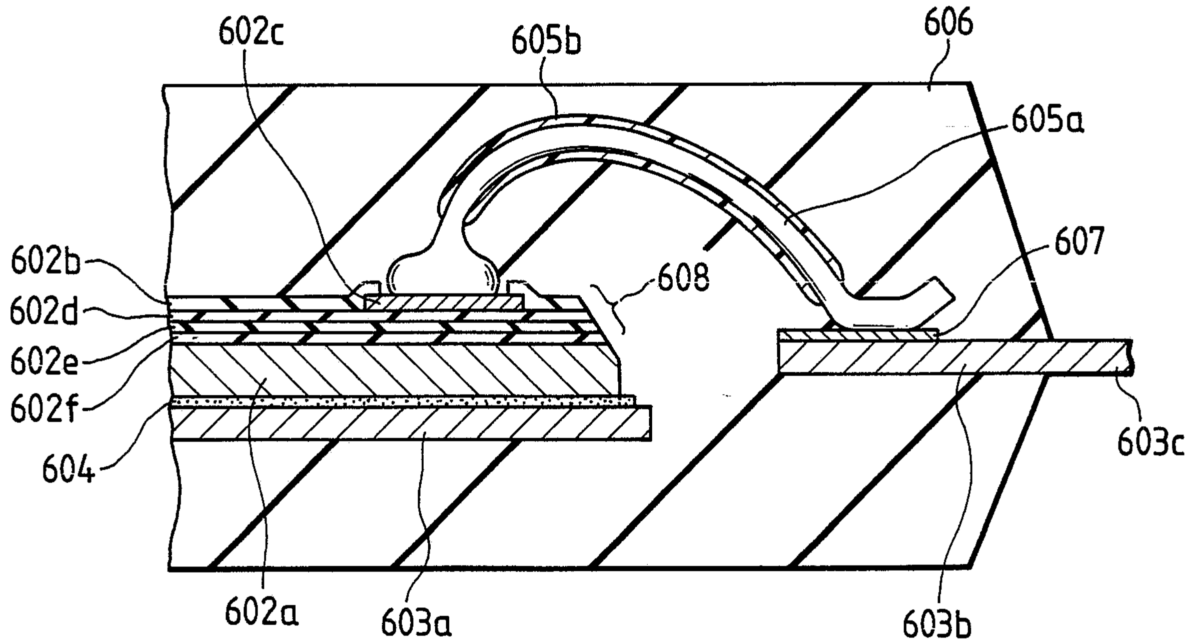
606
605b
602c
605a
607
608
602b
602d
602e
602f
604
602a
603a
603b
603c

FIG. 61

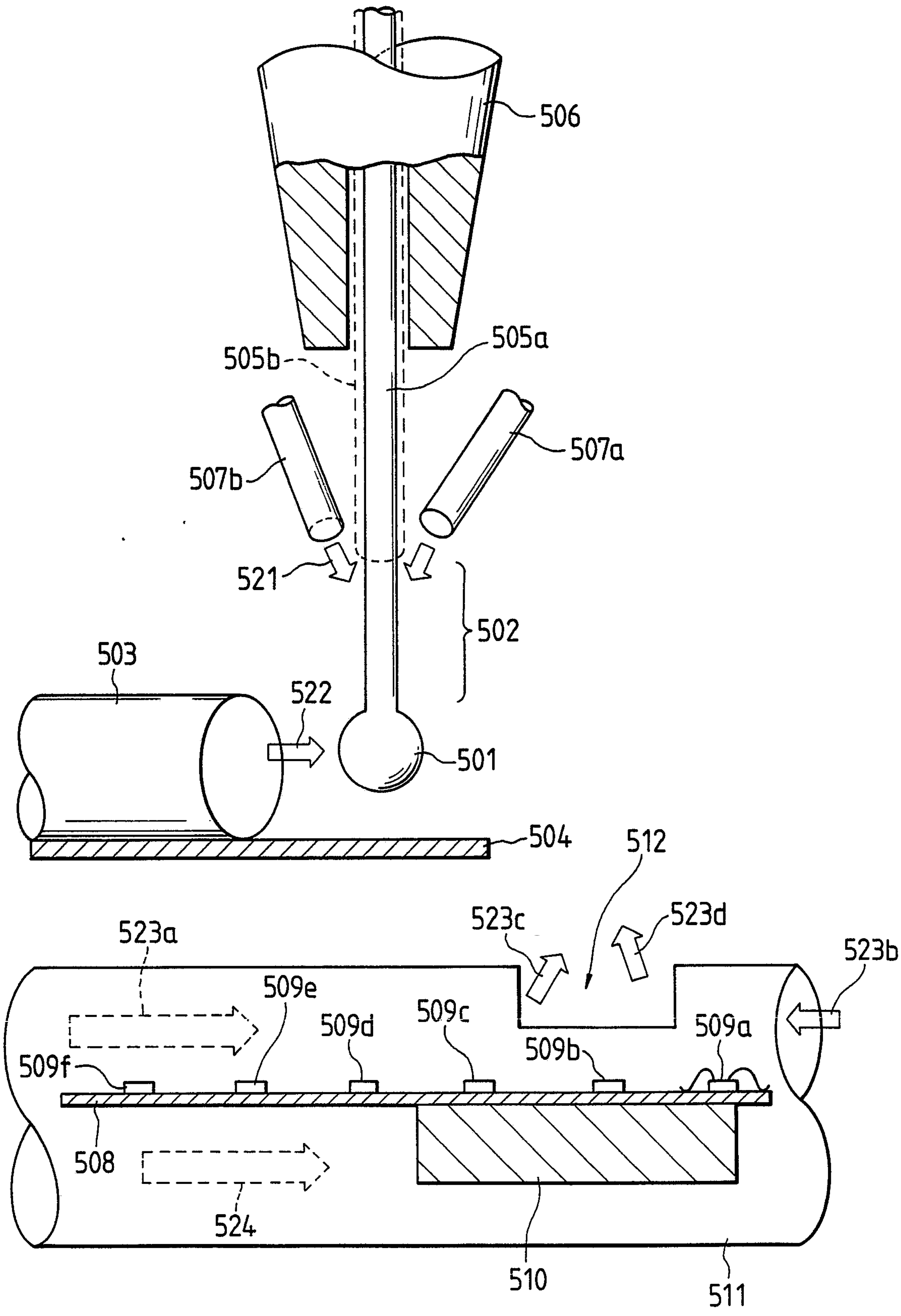
506
505b
505a
507b
507a
521
502
503
522
501
504
512
523c
523d
523a
523b
509e
509d
509c
509a
509f
509b
508
524
510
511